# EUROPEAN PATENT SPECIFICATION

(11) **EP 4 518 635 B1**
(45) Date of publication and mention of the grant of the patent: **25.03.2026**
(21) Application number: 23194021.4
(22) Date of filing: 29.08.2023
(51) Int. Cl.: H10K 85/30, H10K 50/17

(54) **ORGANIC ELECTRONIC DEVICE COMPRISING A HOLE INJECTION LAYER, WHEREIN THE HOLE INJECTION LAYER COMPRISES A COMPOUND OF FORMULA (I) AND A COMPOUND OF FORMULA (III)**
ORGANISCHE ELEKTRONISCHE VORRICHTUNG MIT EINER LOCHINJEKTIONSSCHICHT, WELCHE VERBINDUNGEN DER FORMELN (I) UND (III) ENTHÄLT
DISPOSITIF ÉLECTRONIQUE ORGANIC AVEC UNE COUCHE D'INJECTION DE TROUS COMPRENANT UN COMPOSÉ DE FORMULE (I) ET UN COMPOSÉ DE FORMULE (III)

(43) Date of publication of application: 05.03.2025
(73) Proprietor: Novaled GmbH, 01099 Dresden (DE)
(72) Inventor: UVAROV, Vladimir, 01099 Dresden (DE); PINTER, Piermaria, 01099 Dresden (DE); LUSCHTINETZ, Regina, 01099 Dresden (DE)
(74) Representative: Michalski Hüttermann & Partner Patentanwälte mbB

(56) References cited:
- EP-A1- 3 883 003
- EP-A1- 3 945 125
- EP-A1- 4 106 024

## Description

An organic electronic device comprising a substrate, an anode layer, a cathode layer, at least one first emission layer, and a hole injection layer, wherein the hole injection layer comprises a compound of formula (I) and a compound of formula (III), wherein the hole injection layer is arranged between the anode layer and the at least one first emission layer.

### Technical Field

The present invention relates to an organic electronic device, comprising a substrate, an anode layer, a cathode layer, at least one first emission layer, and a hole injection layer, wherein the hole injection layer comprises a compound of formula (I) and a compound of formula (III), wherein the hole injection layer is arranged between the anode layer and the at least one first emission layer.

### Background Art

Organic electronic devices, such as organic light-emitting diodes OLEDs, which are self-emitting devices, have a wide viewing angle, excellent contrast, quick response, high brightness, excellent operating voltage characteristics, and color reproduction. A typical OLED comprises an anode layer, a hole injection layer HIL, a hole transport layer HTL, an emission layer EML, an electron transport layer ETL, and a cathode layer, which are sequentially stacked on a substrate. In this regard, the HIL, the HTL, the EML, and the ETL are thin films formed from organic compounds.

When a voltage is applied to the anode and the cathode, holes injected from the anode move to the EML, via the HIL and HTL, and electrons injected from the cathode move to the EML, via the ETL. The holes and electrons recombine in the EML to generate excitons. When the excitons drop from an excited state to a ground state, light is emitted. The injection and flow of holes and electrons should be balanced, so that an OLED having the above-described structure has low operating voltage, excellent efficiency and/or a long lifetime.

Performance of an organic light emitting diode may be affected by characteristics of the organic semiconductor layers, such as the hole injection layer, and among them, may be affected by characteristics of the compounds contained in the organic semiconductor layer, such as hole transport compounds and compounds of formula (I). Patent documents EP4106024, EP3883003 and EP3945125 disclose organic electronic devices having an amine compound and a metal complex in the hole injection layer.

There remains a need to improve performance of organic electronic devices by providing organic semiconductor layers with improved performance, in particular to achieve improved operating voltage and/or voltage stability over time.

### DISCLOSURE

An aspect of the present invention provides an organic electronic device comprising a substrate, an anode layer, a cathode layer, at least one first emission layer, and a hole injection layer, wherein
the hole injection layer comprises a compound of formula (I): 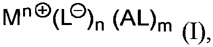
wherein:
   - M: is a metal ion;
   - n: is the valency of M and selected from 1 to 4;
   - L: is a ligand of formula (II) 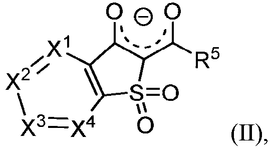
Wherein
   - X¹: is selected from CR¹ or N;
   - X²: is selected from CR² or N;
   - X³: is selected from CR³ or N;
   - X⁴: is selected from CR⁴ or N;
Wherein 0, 1 or 2 of the group consisting of X¹, X², X³, X⁴ are selected from N;
R¹ to R⁴ are independently selected from H, D, substituted or unsubstituted C₁ to C₁₂ alkyl, substituted or unsubstituted C₆ to C₁₉ aryl, substituted or unsubstituted C₂ to C₂₀ heteroaryl, substituted or unsubstituted 6-membered heteroaryl, halogen, F, Cl or CN; and whereby any R^{k} to R^{k+1} may form a ring;
R⁵ is selected from unsubstituted and substituted C₁ to C₁₂ alkyl, substituted or unsubstituted C₆ to C₁₉ aryl, substituted or unsubstituted C₂ to C₂₀ heteroaryl, substituted or unsubstituted 6-membered heteroaryl;
wherein the substituents in the substituted C₁ to C₁₂ alkyl, substituted C₆ to C₁₉ aryl, substituted C₂ to C₂₀ heteroaryl, substituted 6-membered heteroaryl are selected from halogen, F, Cl, CN, partially or perfluorinated C₁ to C₆ alkyl, partially or perfluorinated C₁ to C₆ alkoxy, C₁ to C₆ alkyl, C₁ to C₆ alkoxy;
   - AL: is an ancillary ligand which coordinates to the metal M;
   - m: is an integer selected from 0 to 2;
and the hole injection layer comprises a compound of formula (III) 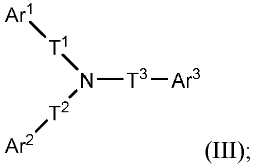
   - T^{I}, T², T³: are independently selected from a single bond, phenylene, biphenylene, terphenylene or naphthenylene, preferably a single bond or phenylene;
   - Ar¹, Ar², Ar³: are independently selected from substituted or unsubstituted C₆ to C₂₀ aryl, or substituted or unsubstituted C₃ to C₂₀ heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted spiro[fluorene-9,9'-xanthene], or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (ii) 5-to 6-member of an aromatic heterocycle, (iii) unsaturated 5- to 7-member ring of a non-heterocycle, (iv) 6-member ring of an aromatic non-heterocycle;
wherein
   the substituents of Ar¹, Ar², Ar³ are selected the same or different from the group comprising H, D, F, CN, Si(R²)₃, substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted aromatic ring systems having 6 to 40 aromatic ring atoms, and substituted or unsubstituted heteroaromatic ring systems having 5 to 40 aromatic ring atoms,
   unsubstituted C₆ to C₁₈ aryl, unsubstituted C₃ to C₁₈ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle,
      wherein R² may be selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, C₆ to C₁₈ aryl or C₃ to C₁₈ heteroaryl;
   wherein the hole injection layer is arranged between the anode layer and the at least one first emission layer.

The term "R¹ to R⁴ and/or R⁵ comprises at least one CF₃ moiety and/or one of R¹, R², R³, R⁴ and R⁵ is CF₃" is understood to encompass a terminal CF₃ group in C₁ to C₁₂ alkyl.

The negative charge in the compounds of formula (I) may be delocalised partially or fully over the β-dicarbonyl group and optionally also over the aryl group(s).

It should be noted that throughout the application and the claims any R^{k} etc. always refer to the same moieties, unless otherwise noted. k is an integer from 1 to 4.

It should be noted that throughout the application and the claims any Aⁿ, Bⁿ, Rⁿ, Arⁿ, Tⁿ, Xⁿ, L, M, Q etc. always refer to the same moieties, unless otherwise noted.

In the present specification, when a definition is not otherwise provided, "partially fluorinated" refers to a C₁ to Cs alkyl group in which only part of the hydrogen atoms are replaced by fluorine atoms.

In the present specification, when a definition is not otherwise provided, "perfluorinated" refers to a C₁ to C₈ alkyl group in which all hydrogen atoms are replaced by fluorine atoms.

In the present specification, when a definition is not otherwise provided, "substituted" refers to one substituted with a deuterium, C₁ to C₁₂ alkyl and C₁ to C₁₂ alkoxy.

In the present specification, when a definition is not otherwise provided, a substituted aryl group with at least 6 C-ring atoms can be substituted with 1, 2, 3, 4 or 5 substituents. For example a substituted C₆ aryl group may have 1, 2, 3, 4 or 5 phenyl substituents.

However, in the present specification "aryl substituted" refers to a substitution with one or more aryl groups, which themselves may be substituted with one or more aryl and/or heteroaryl groups.

Correspondingly, in the present specification "heteroaryl substituted" refers to a substitution with one or more heteroaryl groups, which themselves may be substituted with one or more aryl and/or heteroaryl groups.

In the present specification, when a definition is not otherwise provided, a substituted heteroaryl group with at least 2 C-ring atoms can be substituted with one or more substituents. For example a substituted C₂ heteroaryl group may have 1 or 2 substituents.

In the present specification, when a definition is not otherwise provided, an "alkyl group" refers to a saturated aliphatic hydrocarbyl group. The alkyl group may be a C₁ to C₁₂ alkyl group. More specifically, the alkyl group may be a C₁ to C₁₀ alkyl group or a C₁ to C₆ alkyl group. For example, a C₁ to C₄ alkyl group includes 1 to 4 carbons in alkyl chain, and may be selected from methyl, ethyl, propyl, iso-propyl, n-butyl, iso-butyl, sec-butyl, and tert-butyl.

Specific examples of the alkyl group may be a methyl group, an ethyl group, a propyl group, an isopropyl group, a butyl group, an iso-butyl group, a sec-butyl group, a tert-butyl group, a pentyl group, a hexyl group.

The term "cycloalkyl" refers to saturated hydrocarbyl groups derived from a cycloalkane by formal abstraction of one hydrogen atom from a ring atom comprised in the corresponding cycloalkane. Examples of the cycloalkyl group may be a cyclopropyl group, a cyclobutyl group, a cyclopentyl group, a cyclohexyl group, a methylcyclohexyl group, an adamantly group and the like.

The term "hetero" is understood the way that at least one carbon atom, in a structure which may be formed by covalently bound carbon atoms, is replaced by another polyvalent atom. Preferably, the heteroatoms are selected from B, Si, N, P, O, S; more preferably from N, P, O, S.

The term "charge-neutral" means that the corresponding group is overall electrically neutral.

In the present specification, "aryl group" refers to a hydrocarbyl group which can be created by formal abstraction of one hydrogen atom from an aromatic ring in the corresponding aromatic hydrocarbon. Aromatic hydrocarbon refers to a hydrocarbon which contains at least one aromatic ring or aromatic ring system. Aromatic ring or aromatic ring system refers to a planar ring or ring system of covalently bound carbon atoms, wherein the planar ring or ring system comprises a conjugated system of delocalized electrons fulfilling Hückel's rule. Examples of aryl groups include monocyclic groups like phenyl or tolyl, polycyclic groups which comprise more aromatic rings linked by single bonds, like biphenyl, and polycyclic groups comprising fused rings, like naphtyl or fluoren-2-yl.

Analogously, under heteroaryl, it is especially where suitable understood a group derived by formal abstraction of one ring hydrogen from a heterocyclic aromatic ring in a compound comprising at least one such ring.

Under heterocycloalkyl, it is especially where suitable understood a group derived by formal abstraction of one ring hydrogen from a saturated cycloalkyl ring in a compound comprising at least one such ring.

The term "fused aryl rings" or "condensed aryl rings" is understood the way that two aryl rings are considered fused or condensed when they share at least two common sp²-hybridized carbon atoms.

The term "5-, 6- or 7-member ring" is understood to mean a ring comprising 5, 6 or 7 atoms. The atoms may be selected from C and one or more hetero-atoms.

In the present specification, the single bond refers to a direct bond.

In the present specification, when a definition is not otherwise provided, "substituted" refers to one substituted with a H, deuterium, C₁ to C₁₂ alkyl, unsubstituted C₆ to C₁₈ aryl, and unsubstituted C₃ to C₁₈ heteroaryl.

In the present specification, when a substituent is not named, the substituent can be a H.

In the context of the present invention, "different" means that the compounds do not have an identical chemical structure.

The term "free of", "does not contain", "does not comprise" does not exclude impurities which may be present in the compounds prior to deposition. Impurities have no technical effect with respect to the object achieved by the present invention.

As used herein, "percent by weight", "weight percent", "wt.-%", "% by weight", and variations thereof refer to a composition, component, substance or agent as the weight of that composition, component, substance or agent of the respective layer divided by the total weight of the composition thereof and multiplied by 100. It is understood that the total weight percent amount of all components, substances or agents of the respective are selected such that it does not exceed 100 wt.-%.

The term "contacting sandwiched" refers to an arrangement of three layers whereby the layer in the middle is in direct contact with the two adjacent layers.

The terms "light-absorbing layer" and "light absorption layer" are used synonymously.

The terms "light-emitting layer", "light emission layer" and "emission layer" are used synonymously.

The terms "OLED", "organic light-emitting diode" and "organic light-emitting device" are used synonymously.

The terms "anode", "anode layer" and "anode electrode" are used synonymously.

The term "at least two anode sub-layers" is understood to mean two or more anode sub-layers, for example two or three anode sub-layers.

The terms "cathode", "cathode layer" and "cathode electrode" are used synonymously.

The term "hole injection layer" is understood to mean a layer which improves charge injection from the anode layer into further layers in the organic electronic device or from further layers of the organic electronic device into the anode.

The term "hole transport layer" is understood to mean a layer which transports holes between the hole injection layer and further layers arranged between the hole injection layer and the cathode layer.

The operating voltage U is measured in Volt.

In the context of the present specification the term "essentially non-emissive" or "non-emissive" means that the contribution of the compound of formula (I) or the hole injection layer comprising a compound of formula (I), to the visible emission spectrum from an electronic device, such as OLED or display device, is less than 10 %, preferably less than 5 % relative to the visible emission spectrum. The visible emission spectrum is an emission spectrum with a wavelength of about ≥ 380 nm to about ≤ 780 nm.

In the context of the present invention, the term "sublimation " may refer to a transfer from solid state to gas phase or from liquid state to gas phase.

In the specification, hole characteristics refer to an ability to donate an electron to form a hole when an electric field is applied and that a hole formed in the anode may be easily injected into the emission layer and transported in the emission layer due to conductive characteristics according to a highest occupied molecular orbital (HOMO) level.

In addition, electron characteristics refer to an ability to accept an electron when an electric field is applied and that electrons formed in the cathode may be easily injected into the emission layer and transported in the emission layer due to conductive characteristics according to a lowest unoccupied molecular orbital (LUMO) level.

The term "HOMO level" is understood to mean the highest occupied molecular orbital and is determined in eV (electron volt).

The work function of the first metal is measured in eV (electron volt). Tabulated values of work functions can be found for example in CRC Handbook of Chemistry and Physics version 2008, p. 12-114. Further, tabulated values of work functions can be found for example at https://en.wikipedia.org/wiki/Work_function#cite_note-14.

### Advantageous Effects

Surprisingly, it was found that the organic electronic device of the present invention solves the problem underlying the present invention by enabling devices in various aspects superior over the organic electronic devices known in the art, in particular with respect to improved voltage stability over time.

### Compound of formula (I)

In the following several preferred aspects and embodiments of the compound of formula (I) as well as the layer comprising said compound are described.

### M of the compound of formula (I)

The term "M" represents a metal ion.

According to one embodiment, M of the compound of formula (I) may be selected from a metal ion wherein the corresponding metal has an electronegativity value according to Allen of ≥ 0.65 and ≤ 1.9.

The term "electronegativity value according to Allen" especially refers to Allen, Leland C. (1989). "Electronegativity is the average one-electron energy of the valence-shell electrons in ground-state free atoms", Journal of the American Chemical Society 111 (25): 9003-9014.

According to one embodiment, M may be selected from a transition metal or group III or V metal.

According to one embodiment, the atomic mass of M is selected in the range of ≥ 54 Da and ≤ 200 Da, preferably in the range of ≥ 55 Da and ≤ 200 Da.

According to one embodiment, M is a metal ion selected from Li(I), K(I), Rb(I), Cs(I), Ag(I), Cu(II), Zn(II), Pd(II), Ir(III), Al(III), Ga(III), Mn(II), Mn(III), Ru(III), In(III), Fe(II) or Fe(III); more preferred M is a metal ion selected from Cu(II), Mn(II), Fe(II) and Fe(III); especially preferred M is Cu(II) or Fe(III); wherein the number in brackets denotes the oxidation state.

Thereby, the LUMO and/or thermal properties of the compound of formula (I) may be in the range suitable for use in organic electronic devices.

### n valency of M

The term "n" is the valency of M and selected from 1 to 4, preferably n = 1, 2, 3 or 4, further preferred n = 3 or 4. In addition preferred n = 1 or 2.

According to one embodiment "n" is an integer selected from 2, 3 and 4, which corresponds to the valency of M. According to one embodiment "n" is an integer selected from 2 or 3, which corresponds to the valency of M. According to one embodiment "n" is selected 2. According to another embodiment "n" is selected 4. According to another embodiment "n" is selected 3. According to another embodiment "n" is selected 4.

### The term "m"

The term "m" is an integer selected from 0 to 2, which corresponds to the oxidation number of M. According to one embodiment "m" is an integer selected from 0 or 1. According to another embodiment "m" is an integer selected from 1. According to another embodiment "m" is an integer selected from 2. Preferably "m" is an integer and may be selected from 0.

According to another embodiment of compound of formula (I), wherein n = 2 or 3; and/or m is an integer selected from 0 or 1, preferably 0.

### Ligand L

According to one embodiment, the molecular mass of L is selected in the range of ≤ 600 Da and ≥ 240 Da, preferably ≤ 500 Da and ≥ 280 Da.

According to one embodiment of the present invention, zero or one of R¹ to R⁴ are not H or D.

According to one embodiment of the present invention, the ligand of formula (II) is free of alkoxy groups.

According to an embodiment of compound of formula (I), R¹ to R⁴ are independently selected from H, D, F or CN, preferably H or D; and R⁵ is selected from unsubstituted and substituted C₁ to C₆ alkyl, substituted or unsubstituted C₆ to C₁₂ aryl, substituted or unsubstituted C₂ to C₁₂ heteroaryl, substituted or unsubstituted 6-membered heteroaryl;
wherein the substituents in the substituted C₁ to C₆ alkyl, substituted C₆ to C₁₂ aryl, substituted C₂ to C₁₂ heteroaryl, substituted 6-membered heteroaryl are selected from halogen, F, Cl, CN, partially or perfluorinated C₁ to C₄ alkyl, partially or perfluorinated C₁ to C₄ alkoxy, C₁ to C₄ alkyl, C₁ to C₄ alkoxy.

According to one embodiment of the present invention, the compound of formula (I) comprises at least two fluorine atoms and/or at least one CN group and less than 50 fluorine atoms and/or less than 16 CN groups; preferably compound of formula (I) comprises between 2 and 36 fluorine atoms and/or between one and 8 CN groups.

According to an embodiment, in case the compound of formula (I) comprises at least one CN group then it is especially preferred that the CN group is present on one or more of the groups R¹ to R⁴, preferably R² or R³.

According to an embodiment, in case the compound of formula (I) comprises at least two fluorine atoms then it is especially preferred that R⁵ comprises the at least two fluorine atoms.

According to an embodiment of the present invention, the ligand of formula (II) comprises at least two fluorine atoms and/or at least one CN group.

According to one embodiment of the present invention, the ligand of formula (II) comprises at least two fluorine atoms and/or at least one CN group and less than 25 fluorine atoms and/or less than 4 CN groups; preferably compound of formula (I) comprises between 2 and 13 fluorine atoms and/or between one and 4 CN groups.

According to an embodiment of the present invention, in case the ligand of formula (II) comprises at least one CN group then it is especially preferred that the CN group is present on one or more of the groups R¹ to R⁴, preferably R² or R³.

According to an embodiment of the present invention, in case the ligand of formula (II) comprises at least two fluorine atoms then it is especially preferred that R⁵ comprises the at least two fluorine atoms.

According to an embodiment of the present invention, none of the groups R¹ to R⁴ comprises fluorine atoms.

According to an embodiment of the present invention, R¹ to R⁴ are independently selected from H, D, F or CN, preferably H or D; and R⁵ is selected from unsubstituted and substituted C₁ to C₆ alkyl, substituted or unsubstituted C₆ to C₁₂ aryl, substituted or unsubstituted C₂ to C₁₂ heteroaryl, substituted or unsubstituted 6-membered heteroaryl;
wherein the substituents in the substituted C₁ to C₆ alkyl, substituted C₆ to C₁₂ aryl, substituted C₂ to C₁₂ heteroaryl, substituted 6-membered heteroaryl are selected from halogen, F, Cl, CN, partially or perfluorinated C₁ to C₄ alkyl, partially or perfluorinated C₁ to C₄ alkoxy, C₁ to C₄ alkyl, C₁ to C₄ alkoxy;
wherein at least one of R¹ to R⁴ and/or R⁵ comprises at least two fluorine atoms and/or at least one CN group.

According to an embodiment of the present invention, R¹ to R⁴ are independently selected from H, D or CN, preferably H or D; and R⁵ is selected from substituted C₁ to C₁₂ alkyl, substituted C₆ to C₁₉ aryl, substituted C₂ to C₂₀ heteroaryl, substituted 6-membered heteroaryl;
wherein the substituents in the substituted C₁ to C₁₂ alkyl, substituted C₆ to C₁₉ aryl, substituted C₂ to C₂₀ heteroaryl, substituted 6-membered heteroaryl are selected from halogen, F, Cl, CN, partially or perfluorinated C₁ to C₆ alkyl, C₁ to C₆ alkyl, C₁ to C₆ alkoxy;
wherein at least one of R¹ to R⁴ and/or R⁵ comprises at least two fluorine atoms and/or at least one CN group.

According to an embodiment of the present invention, R¹ to R⁴ are independently selected from H or D; and R⁵ is selected from substituted C₁ to C₁₂ alkyl, substituted C₆ to C₁₉ aryl, substituted C₂ to C₂₀ heteroaryl, substituted 6-membered heteroaryl;
wherein the substitutents in the substituted C₁ to C₁₂ alkyl, substituted C₆ to C₁₉ aryl, substituted C₂ to C₂₀ heteroaryl, substituted 6-membered heteroaryl are selected from halogen, F, Cl, CN, partially or perfluorinated C₁ to C₆ alkyl, C₁ to C₆ alkyl, C₁ to C₆ alkoxy;
wherein R⁵ comprises at least two fluorine atoms and/or at least one CN group.

According to an embodiment of the present invention, R¹ to R⁴ are selected from H or D; and R⁵ is selected from substituted C₁ to C₆ alkyl, substituted C₆ aryl, substituted C₂ to C₅ heteroaryl, substituted 6-membered heteroaryl;
wherein the substitutents in the substituted C₁ to C₆ alkyl, substituted C₆ aryl, substituted C₂ to C₅ heteroaryl, substituted 6-membered heteroaryl are selected from halogen, F, Cl, CN, partially or perfluorinated C₁ to C₆ alkyl, C₁ to C₆ alkyl, C₁ to C₆ alkoxy;
wherein R⁵ comprises at least two fluorine atoms and/or at least one CN group.

According to one embodiment of the present invention, the ligand L of formula (II) is selected from one of the following formulae (A1) to (A9) 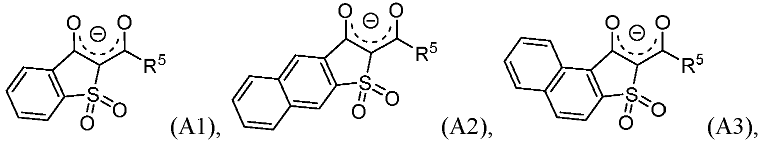 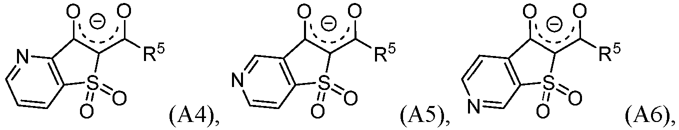 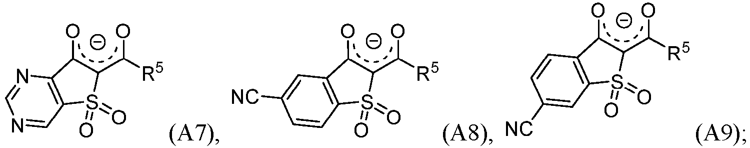 preferably the ligand of formula (II) is selected from formulae (A1) to (A7).

According to one embodiment of the present invention, R⁵ is selected from CH₃, CF₃, C₂F₅, C₃F₇, iso-C₃F₇, C₄F₉, tert-C₄H₉, phenyl, pyrimidyl or formulae (B1) to (B51) 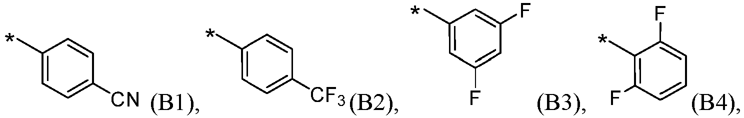 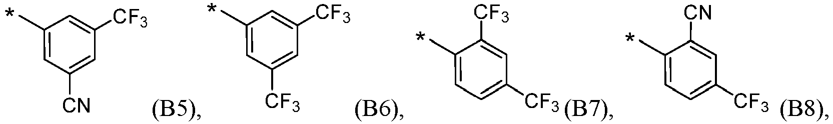 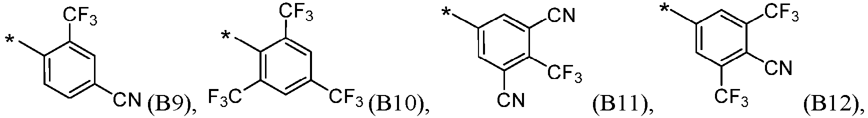 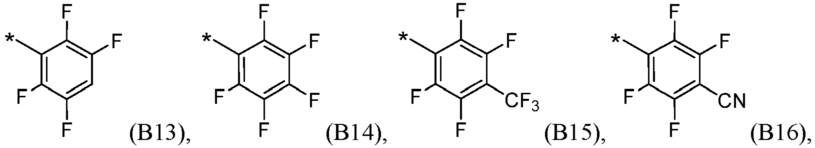 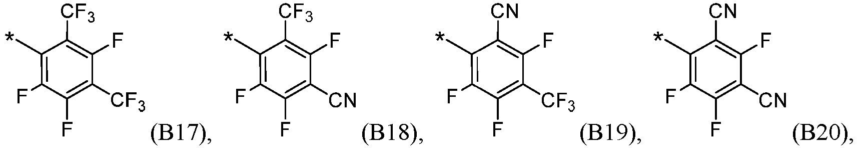 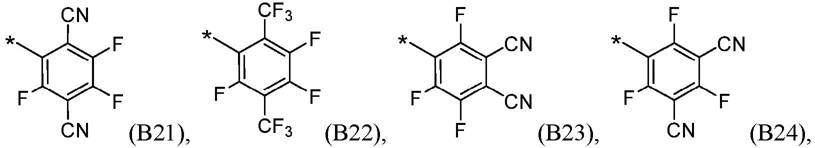 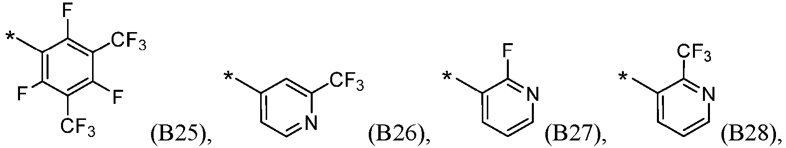 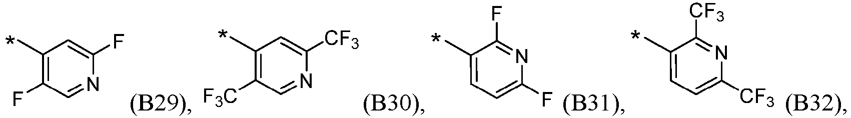 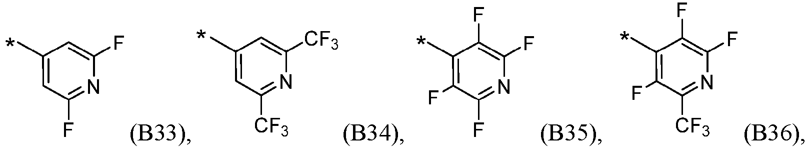 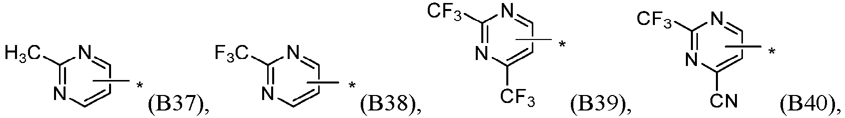 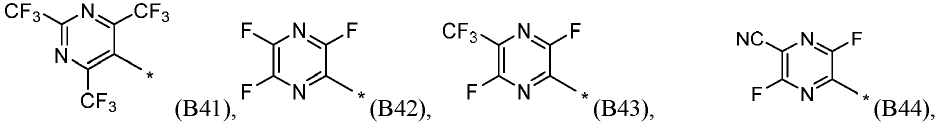 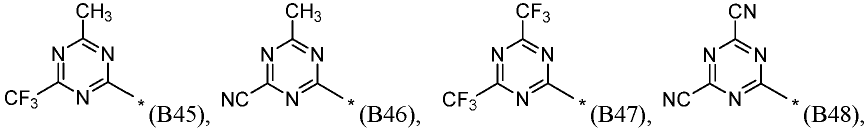 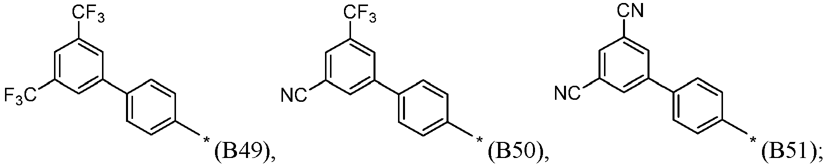 wherein the "*" denotes the binding position;
preferably, R⁵ is selected from CF₃ or formulae (B1) to (B36), more preferably R⁵ is selected from CF₃ or formulae (B2) to (B25).

According to one embodiment of the present invention, at least one R¹ to R⁴ is selected from CN and R⁵ is selected from phenyl or unsubstituted and mono or polysubstituted C₁ to C₁₂ alkyl, preferably R⁵ is selected from phenyl or mono or polysubstituted C₁ to C₆ alkyl, wherein the substituent is selected from F or CF₃.

According to one embodiment of the present invention, the ligand L of formula (II) is selected from (A1) to (A9) wherein R⁵ is selected from CF₃, C₂F₅, C₃F₇, iso-C₃F₇, C₄F₉, tert-C₄H₉, phenyl, pyrimidyl or formulae (B1) to (B51) preferably, R⁵ is selected from CF₃ or formulae (B1) to (B36), more preferably R⁵ is selected from CF₃ or formulae (B2) to (B25).

According to one embodiment of the present invention, the ligand L of formula (II) is selected from one of the following formulae (C1) to (C30) 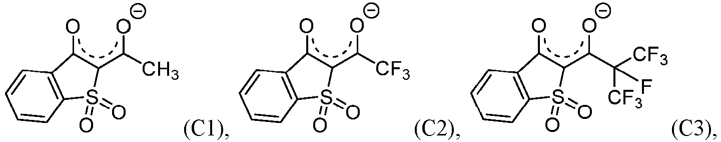 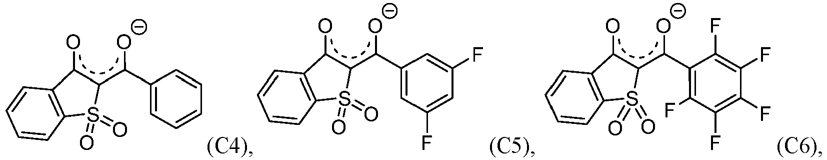 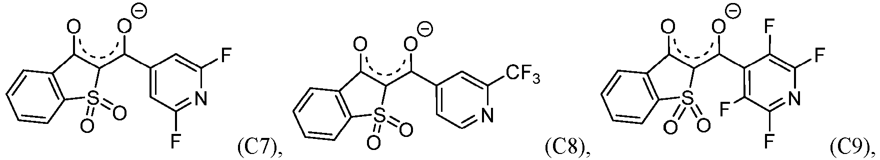 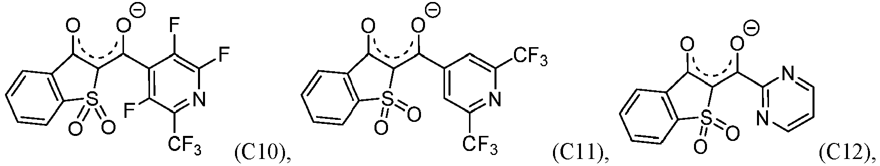 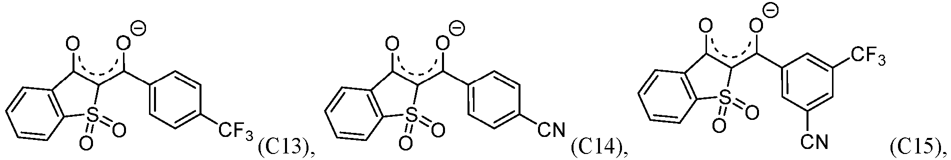 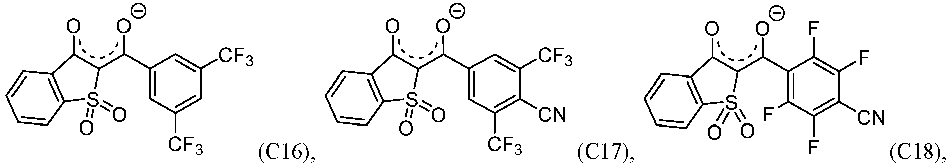 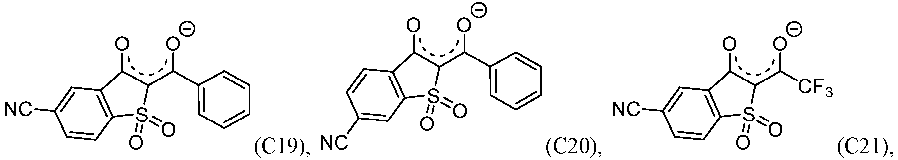 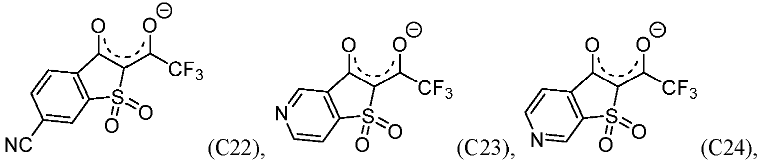 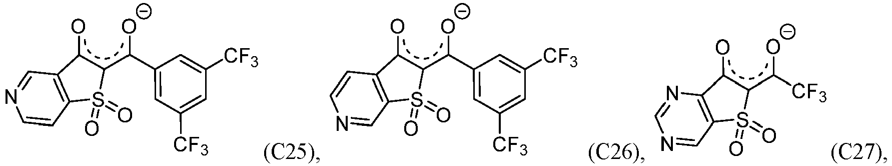 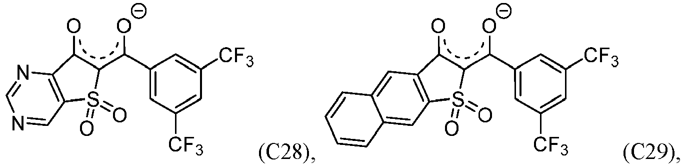 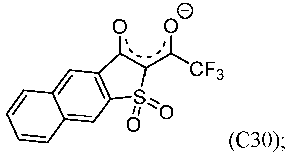 preferably, ligand L of formula (II) is selected from (C2) to (C26), especially preferred are (C2) and (C16).

According to one embodiment of the application AL (the ancillary ligand) is selected from the group comprising H₂O, C₂ to C₄₀ mono- or multi-dentate ethers and C₂ to C₄₀ thioethers, C₂ to C₄₀ amines, C₂ to C₄₀ phosphine, C₂ to C₂₀ alkyl nitrile or C₂ to C₄₀ aryl nitrile, or a compound according to Formula (AL-I); 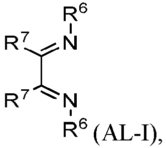 wherein
- R⁶ and R⁷: are independently selected from C₁ to C₂₀ alkyl, C₁ to C₂₀ heteroalkyl, C₆ to C₂₀ aryl, heteroaryl with 5 to 20 ring-forming atoms, halogenated or perhalogenated C₁ to C₂₀ alkyl, halogenated or perhalogenated C₁ to C₂₀ heteroalkyl, halogenated or perhalogenated C₆ to C₂₀ aryl, halogenated or perhalogenated heteroaryl with 5 to 20 ring-forming atoms, or at least one R⁶ and R⁷ are bridged and form a 5 to 20 member ring, or the two R⁶ and/or the two R⁷ are bridged and form a 5 to 40 member ring or form a 5 to 40 member ring comprising an unsubstituted or C₁ to C₁₂ substituted phenanthroline.

According to one embodiment of the present invention, in the compound of formula (I) the ligand L of formula (II) is selected from one of (A1) to (A9) wherein R⁵ is selected from CF₃, C₂F₅, C₃F₇, iso-C₃F₇, C₄F₉, tert-C₄H₉, phenyl, pyrimidyl or formulae (B1) to (B51); and
M is a metal ion selected from Li(I), K(I), Rb(I), Cs(I), Ag(I), Cu(II), Zn(II), Pd(II), Ir(III), Al(III), Ga(III), Mn(II), Mn(III), Ru(III), In(III), Fe(II) or Fe(III); more preferred M is a metal ion selected from Cu(II), Mn(II), Fe(II) and Fe(III); especially preferred M is Cu(II) or Fe(III); wherein the number in brackets denotes the oxidation state.

Preferably, the compound of formula (I) is selected from formulae (D1) to (D75): 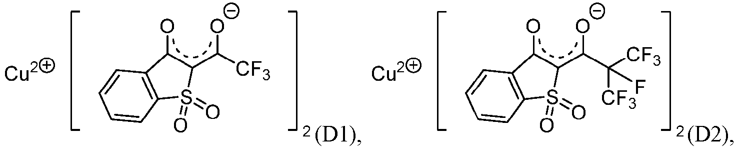 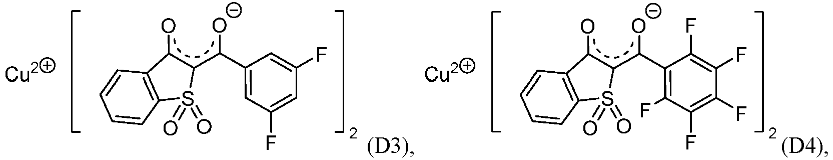 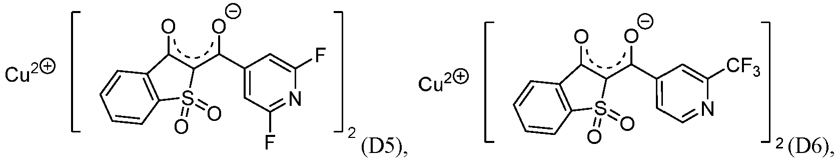 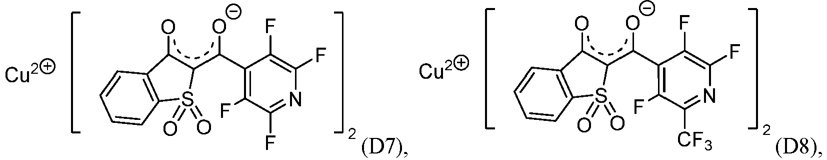 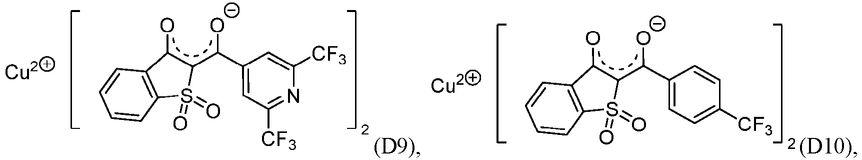 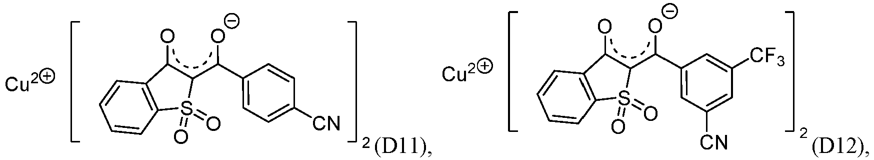 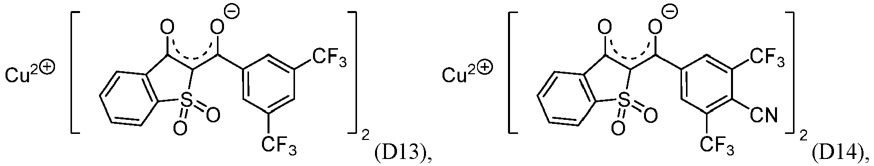 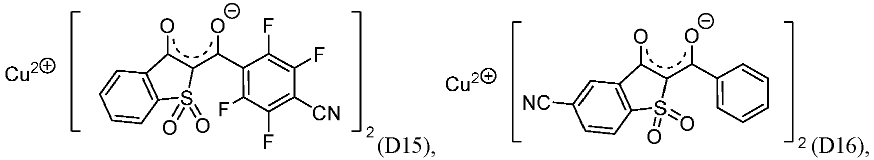 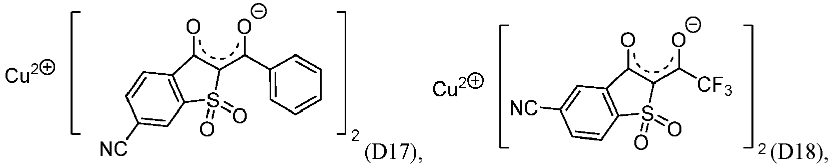 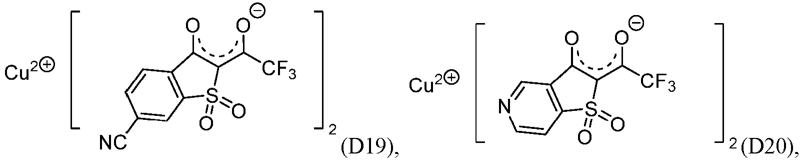 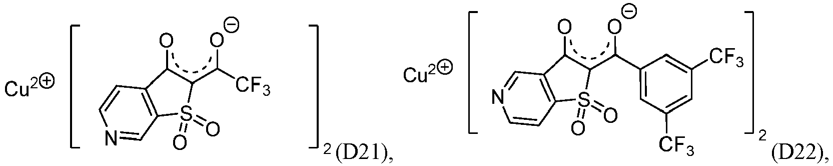 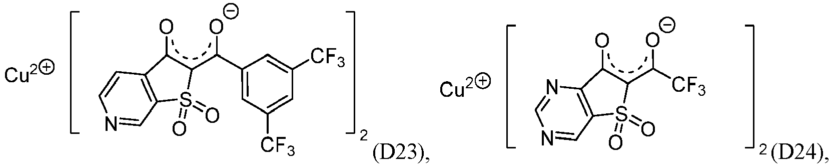 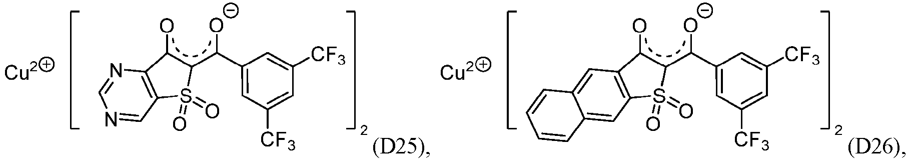 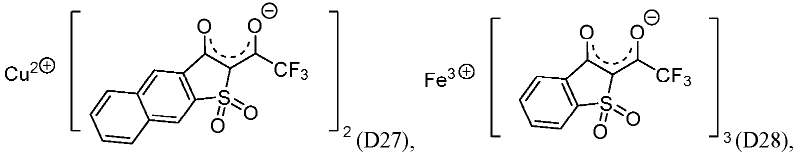 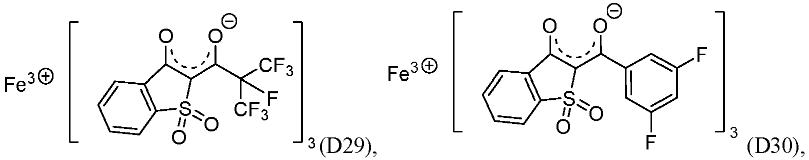 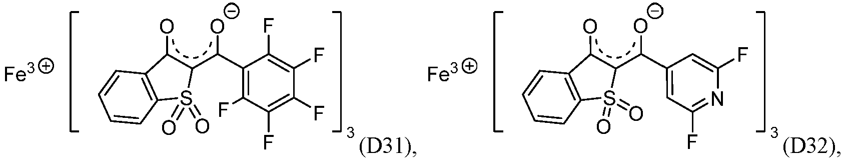 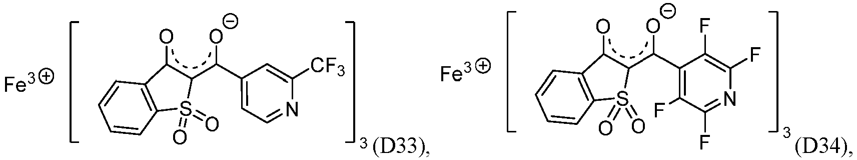 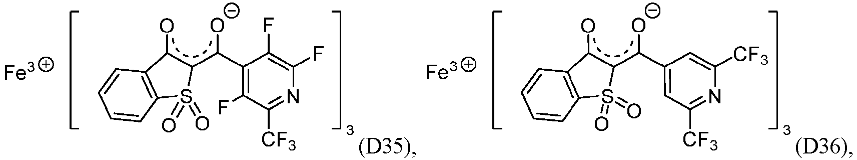 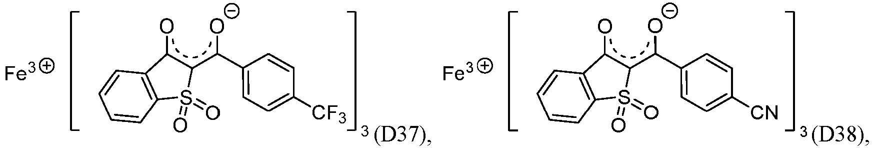 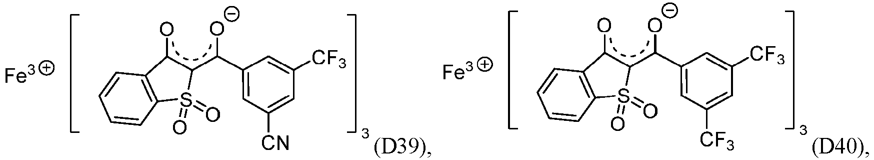 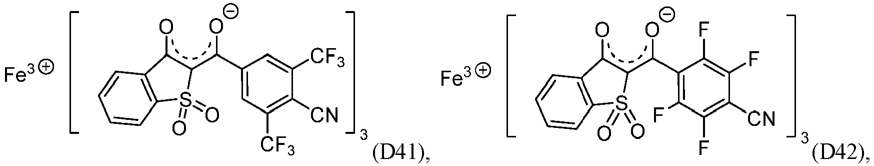 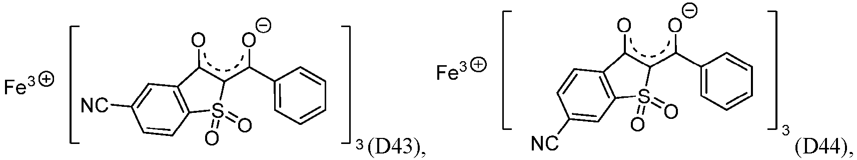 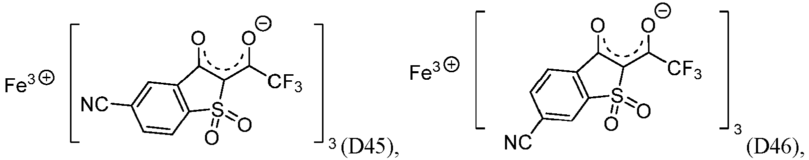 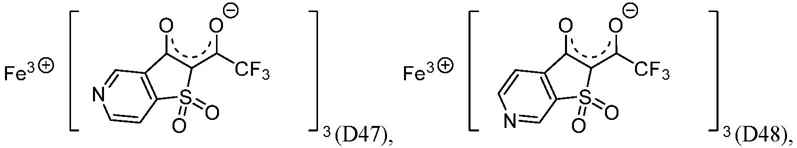 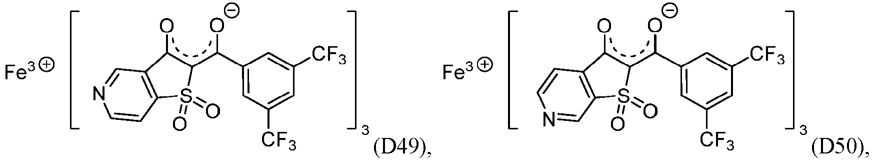 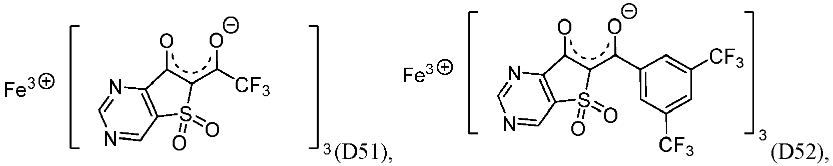 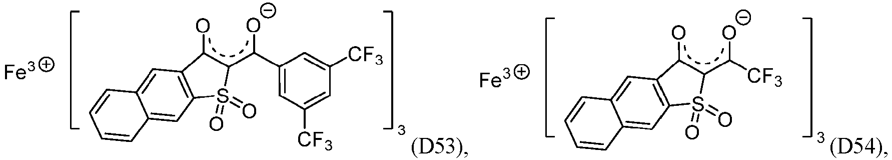 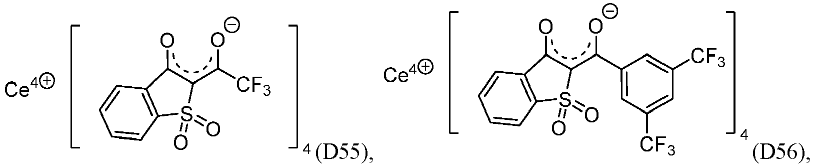 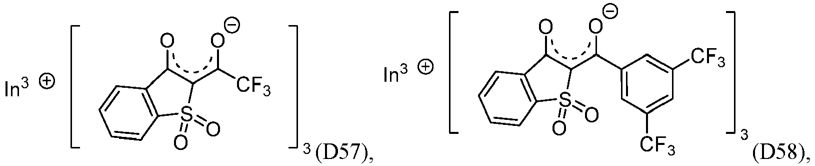 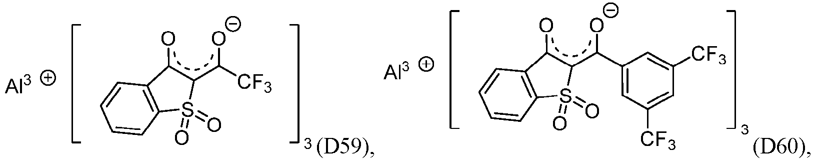 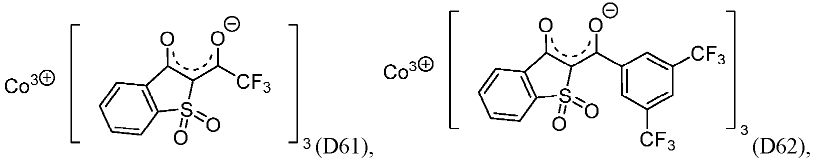 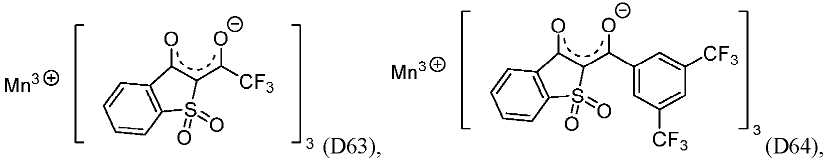 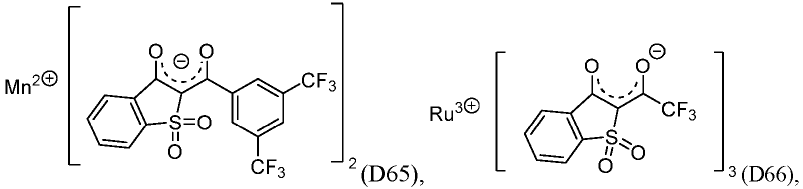 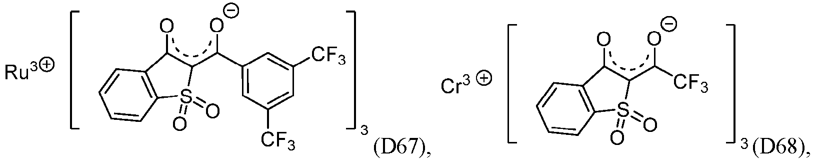 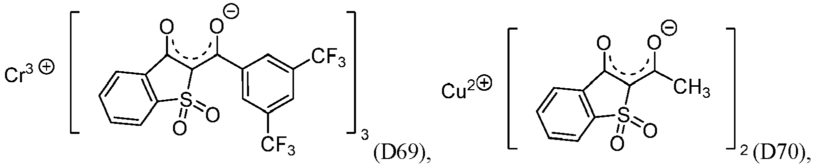 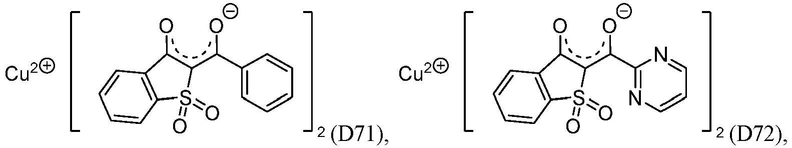 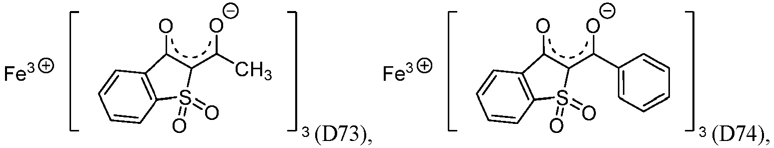 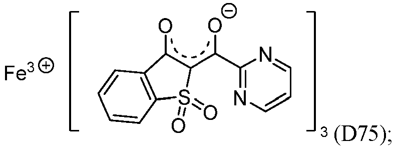 preferably compound of formula (I) is selected from formulae (D1) to (D69).

The compound of formula (I) and the hole injection layer comprising a compound of formula (I) may be essentially non-emissive or non-emissive.

The concentration of the compound of formula (I) may be selected from 1 to 30 wt.-%, preferably from 2 wt.-% to 25 wt.-%, more preferred from 3 wt.-% to 15 wt.-%, based on the weight of the hole injection layer.

The concentration of the compound of formula (I) may be selected from 1 to 30 vol.-%, preferably from 2 vol.-% to 25 vol.-%, more preferred from 3 vol.-% to 15 vol.-% based on the volume of the hole injection layer.

According to one embodiment of the present invention, the hole injection layer is free of of metal phthalocyanine (Pc) or CuPc, and/or the layers of the organic electronic device are free of metal phthalocyanine or CuPc. Preferably, the semiconductor layer is free of ionic liquids, metal phthalocyanine, CuPc, HAT-CN, Pyrazino[2,3-f] [1,l0]phenanthroline-2,3-dicarbonitrile, F₄TCNQ, metal fluoride and/or metal oxides, wherein the metal in the metal oxide is selected from Re and/or Mo.

### Compound of formula (III)

According to one embodiment of the present invention, the compound of formula (III) is a matrix compound, preferably a substantially covalent matrix compound.

According to one embodiment, the substantially covalent matrix compound may have a molecular weight Mw of ≥ 400 and ≤ 2000 g/mol, preferably a molecular weight Mw of ≥ 450 and ≤ 1500 g/mol, further preferred a molecular weight Mw of ≥ 500 and ≤ 1000 g/mol, in addition preferred a molecular weight Mw of ≥ 550 and ≤ 900 g/mol, also preferred a molecular weight Mw of ≥ 600 and ≤ 800 g/mol.

According to an embodiment wherein T¹, T², and T³ may be independently selected from a single bond, phenylene, biphenylene or terphenylene. According to an embodiment wherein T¹, T², and T³ may be independently selected from phenylene, biphenylene or terphenylene and one of T¹, T², and T³ are a single bond. According to an embodiment wherein T¹, T², and T³ may be independently selected from phenylene or biphenylene and one of T¹, T², and T³ are a single bond. According to an embodiment wherein T¹, T², and T³ may be independently selected from phenylene or biphenylene and two of T¹, T², and T³ are a single bond.

According to an embodiment wherein T¹, T² and T³ may be independently selected from phenylene and one of T¹, T² and T³ are a single bond. According to an embodiment wherein T¹, T² and T³ may be independently selected from phenylene and two of T¹, T² and T³ are a single bond.

According to one embodiment of the present invention Ar¹, Ar², and Ar³ are independently selected from formulae (E1) to (E16): 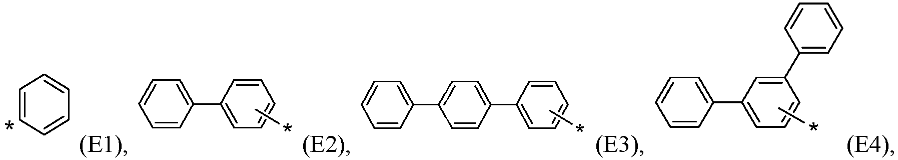 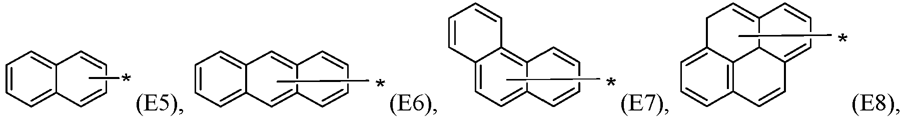 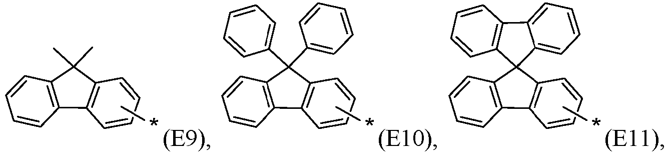 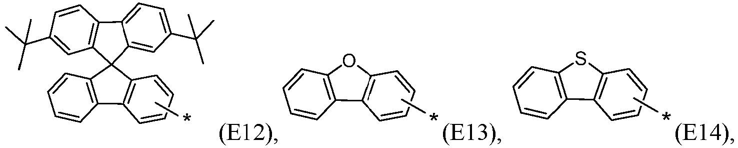 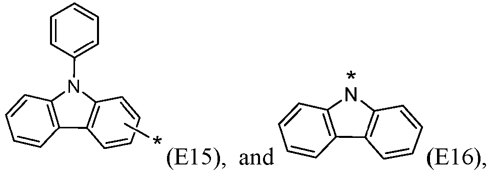 wherein the asterisk "*" denotes the binding position.

According to an embodiment, Ar¹, Ar², and Ar³ may be independently selected from E1 to E15; alternatively selected from E1 to E10 and E13 to E15.

According to an embodiment, wherein Ar¹, Ar², Ar³, Ar⁴ and Ar⁵ may be independently selected from the group consisting of E1, E2, E5, E7, E9, E10, E13 to E16.

The rate onset temperature may be in a range particularly suited to mass production, when Ar¹, Ar², and Ar³ are selected in this range.

The compound according to formula (III) may be also referred to as "hole transport compound".

According to one embodiment, the compound according to formula (III) comprises at least one naphthyl group, carbazole group, dibenzofuran group, dibenzothiophene group and/or substituted fluorenyl group, wherein the substituents are independently selected from methyl, phenyl or fluorenyl.

According to one embodiment of the invention, the compound of formula (III) has a HOMO level smaller than the HOMO level of N2,N2,N2',N2',N7,N7,N7',N7'-octakis(4-methoxyphenyl)-9,9'-spirobi[fluorene]-2,2',7,7'-tetraamine, preferably smaller than N4,N4,N4',N4'-tetrakis(4-methoxyphenyl)biphenyl-4,4'-diamine, more preferred smaller than N4,N4'-bis(9,9-dimethyl-9H-fluoren-2-yl)-N4,N4'-diphenyl-[1,1'-biphenyl]-4,4'-diamine, when determined by the same method. The HOMO level of N2,N2,N2',N2',N7,N7,N7',N7'-octakis(4-methoxyphenyl)-9,9'-spirobi[fluorene]-2,2',7,7'-tetraamine is -4.39 eV, the HOMO level of N4,N4,N4',N4'-tetrakis(4-methoxyphenyl)biphenyl-4,4'-diamine is -4.53 eV, and the HOMO level of N4,N4'-bis(9,9-dimethyl-9H-fluoren-2-yl)-N4,N4'-diphenyl-[1,1'-biphenyl]-4,4'-diamine is -4.84 eV, when calculated using the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) by applying the hybrid functional B3LYP with a Def2-TZVP basis set in the gas phase.

According to one embodiment of the invention, the compound of formula (III) has a HOMO level smaller than -4.39 eV, preferably smaller than -4.53 eV, even more preferred smaller than -4.84 eV when calculated using the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) by applying the hybrid functional B3LYP with a Def2-TZVP basis set in the gas phase.

The term "having a HOMO level smaller than" in the context of the present invention means that the absolute value of the HOMO level is greater than the absolute value of the HOMO level to which it is compared to. Particularly, the term "having a HOMO level smaller than" in the context of the present invention means that the HOMO level is further away from vacuum level than the value of the HOMO level to which it is compared to.

According to an embodiment of the electronic device, the molecular mass of the compound of formula (III) is selected in the range of ≥ 600 Da and ≤ 900 Da, preferably ≥ 620 Da and ≤ 850 Da. When the molecular mass of compound of formula (III) is selected within this range, the compound of formula (III) may be particularly suited to vacuum thermal deposition.

According to an embodiment of the electronic device, the compound of formula (III) is selected from one of the following formulae (K1) to (K19):

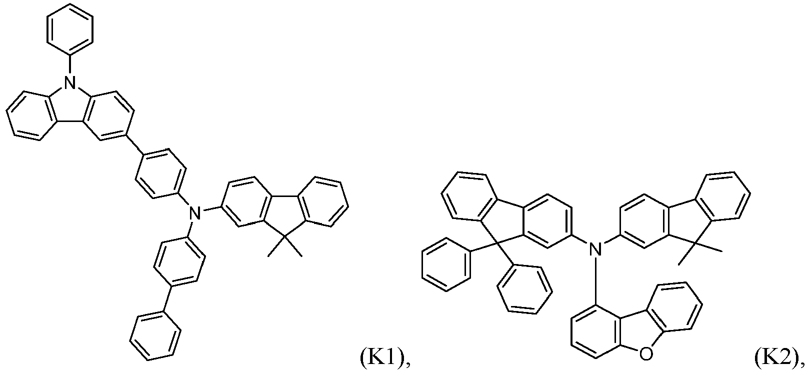

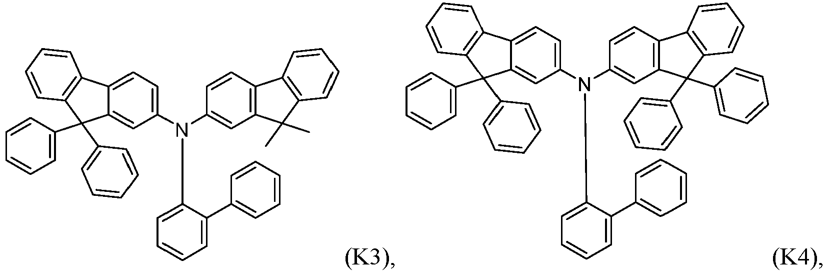

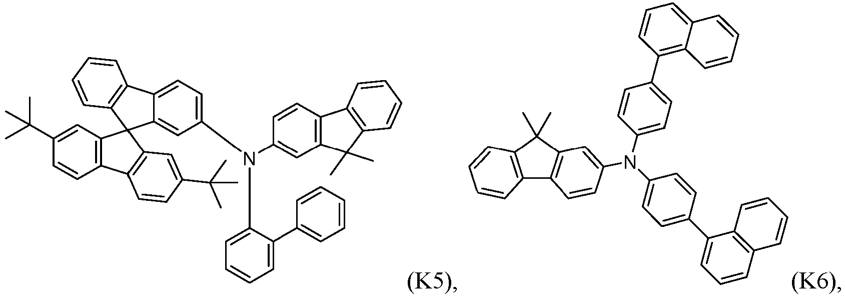

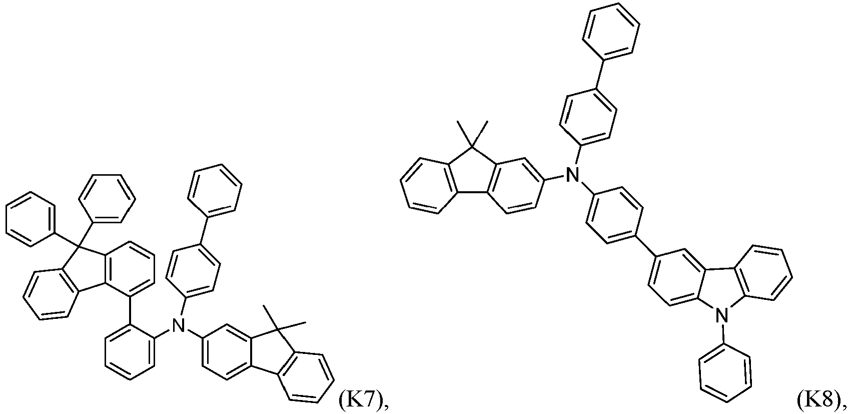

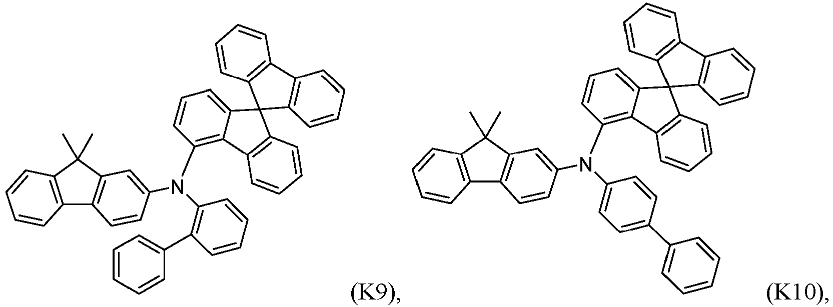

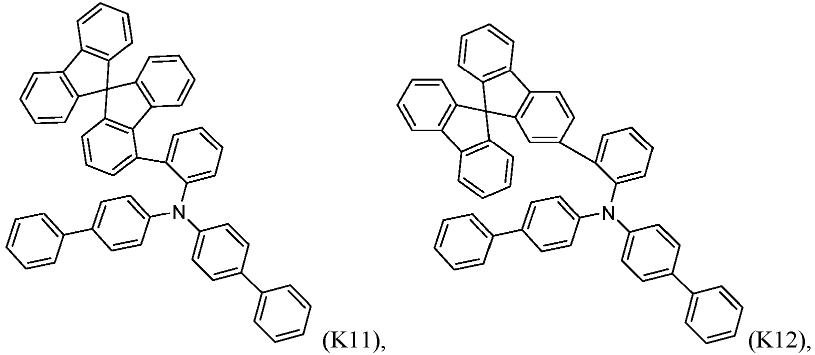

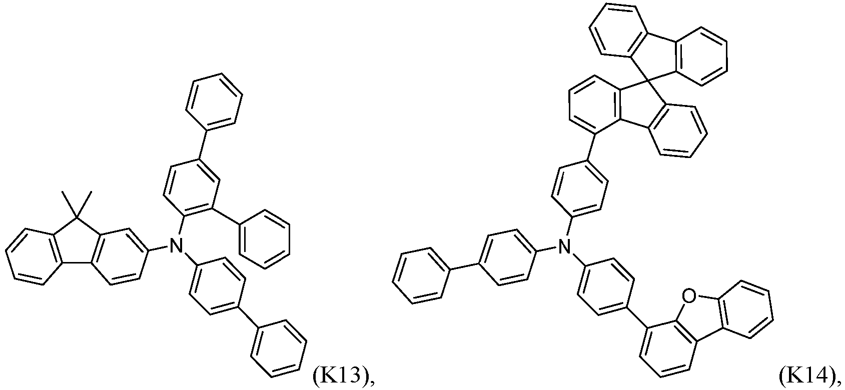

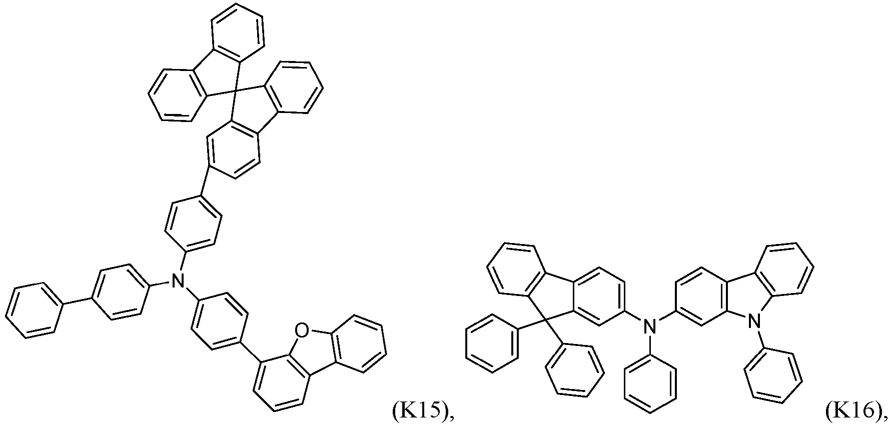

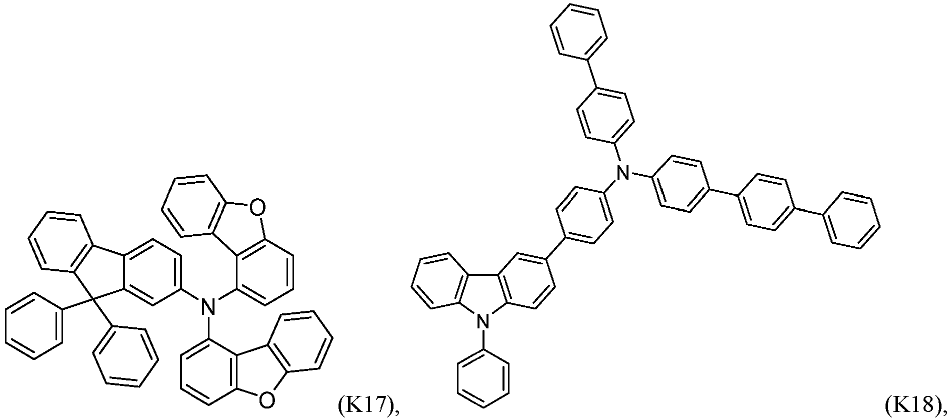

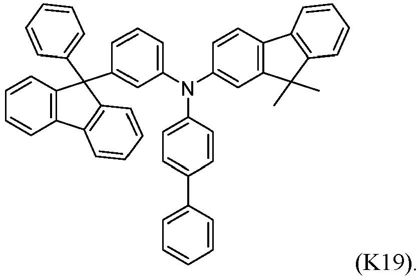

According to one embodiment of the invention, the thickness of the hole injection layer is in the range of 1 nm to 20 nm, preferably in the range of 1 nm to 15 nm, more preferably in the range of 3 nm to 15 nm.

According to one embodiment of the present invention, the hole injection layer is in direct contact to the anode layer.

### Further layers

In accordance with the invention, the organic electronic device may comprise, besides the layers already mentioned above, further layers. Exemplary embodiments of respective layers are described in the following:

### Substrate

The substrate may be any substrate that is commonly used in manufacturing of, electronic devices, such as organic light-emitting diodes. If light is to be emitted through the substrate, the substrate shall be a transparent or semitransparent material, for example a glass substrate or a transparent plastic substrate. If light is to be emitted through the top surface, the substrate may be both a transparent as well as a non-transparent material, for example a glass substrate, a plastic substrate, a metal substrate, a silicon substrate or a backplane.

### Anode layer

The anode layer may be formed by depositing or sputtering a material that is used to form the anode layer. The material used to form the anode layer may be a high work-function material, so as to facilitate hole injection. The anode material may also be selected from a low work function material (i.e. aluminum). The anode layer may be a transparent or reflective electrode. Transparent conductive oxides, such as indium tin oxide (ITO), indium zinc oxide (IZO), tin-dioxide (SnO2), aluminum zinc oxide (AlZO) and zinc oxide (ZnO), may be used to form the anode layer. The anode layer may also be formed using metals, typically silver (Ag), gold (Au), or metal alloys.

According to one embodiment of the present invention, the anode layer comprises a first anode sub-layer and a second anode sub-layer, wherein
- the first anode sub-layer comprises a first metal having a work function in the range of ≥ 4 and ≤ 6 eV, and
- the second anode sub-layer comprises a transparent conductive oxide; and
- the second anode sub-layer is arranged closer to the hole injection layer.

According to one embodiment of the present invention, the first metal of the first anode sub-layer may be selected from the group comprising Ag, Mg, Al, Cr, Pt, Au, Pd, Ni, Nd, Ir, preferably Ag, Au or Al, and more preferred Ag.

According to one embodiment of the present invention, the first anode sub-layer has have a thickness in the range of 5 to 200 nm, alternatively 8 to 180 nm, alternatively 8 to 150 nm, alternatively 100 to 150 nm.

According to one embodiment of the present invention, the first anode sub-layer is formed by depositing the first metal via vacuum thermal evaporation.

It is to be understood that the first anode layer is not part of the substrate.

According to one embodiment of the present invention, the transparent conductive oxide of the second anode sub layer is selected from the group selected from the group comprising indium tin oxide or indium zinc oxide, more preferred indium tin oxide.

According to one embodiment of the present invention, the second anode sub-layer may has a thickness in the range of 3 to 200 nm, alternatively 3 to 180 nm, alternatively 3 to 150 nm, alternatively 3 to 20 nm.

According to one embodiment of the present invention, the second anode sub-layer may be formed by sputtering of the transparent conductive oxide.

According to one embodiment of the present invention, anode layer of the organic electronic device comprises in addition a third anode sub-layer comprising a transparent conductive oxide, wherein the third anode sub-layer is arranged between the substrate and the first anode sub-layer.

According to one embodiment of the present invention, the third anode sub-layer comprises a transparent oxide, preferably from the group selected from the group comprising indium tin oxide or indium zinc oxide, more preferred indium tin oxide.

According to one embodiment of the present invention, the third anode sub-layer may has a thickness in the range of 3 to 200 nm, alternatively 3 to 180 nm, alternatively 3 to 150 nm, alternatively 3 to 20 nm.

According to one embodiment of the present invention, the third anode sub-layer may be formed by sputtering of the transparent conductive oxide.

It is to be understood that the third anode layer is not part of the substrate.

According to one embodiment of the present invention, the anode layer comprises a first anode sub-layer comprising of Ag, a second anode sub-layer comprising of transparent conductive oxide, preferably ITO, and a third anode sub-layer comprising of transparent conductive oxide, preferably ITO; wherein the first anode sub-layer is arranged between the second and the third anode sub-layer.

### Hole transport layer

According to one embodiment of the present invention, the organic electronic device comprises a hole transport layer, wherein the hole transport layer is arranged between the hole injection layer and the at least one first emission layer.

The hole transport layer (HTL) may be formed on the HIL by vacuum deposition, spin coating, slot-die coating, printing, casting, Langmuir-Blodgett (LB) deposition, or the like. When the HTL is formed by vacuum deposition or spin coating, the conditions for deposition and coating may be similar to those for the formation of the HIL. However, the conditions for the vacuum or solution deposition may vary, according to the compound that is used to form the HTL.

The HTL may be formed of any compound that is commonly used to form a HTL. Compounds that can be suitably used are disclosed for example in Yasuhiko Shirota and Hiroshi Kageyama, Chem. Rev. 2007, 107, 953-1010 and incorporated by reference.

According to one embodiment of the present invention, the hole transport layer may comprise a substantially covalent matrix compound as described above.

According to one embodiment of the present invention, the hole transport layer may comprise a compound of formula (III) as described above.

According to one embodiment of the present invention, the hole injection layer and the hole transport layer comprises the same substantially covalent matrix compound as described above.

According to one embodiment of the present invention, the hole injection layer and the hole transport layer comprise the same compound of formula (III) as described above.

The thickness of the HTL may be in the range of about 5 nm to about 250 nm, preferably, about 10 nm to about 200 nm, further about 20 nm to about 190 nm, further about 40 nm to about 180 nm, further about 60 nm to about 170 nm, further about 80 nm to about 160 nm, further about 100 nm to about 160 nm, further about 120 nm to about 140 nm. A preferred thickness of the HTL may be 170 nm to 200 nm.

When the thickness of the HTL is within this range, the HTL may have excellent hole transporting characteristics, without a substantial penalty in driving voltage.

According to one embodiment of the present invention, the organic electronic device further comprises a hole transport layer, wherein the hole transport layer is arranged between the hole injection layer and the at least one emission layer.

According to one embodiment of the present invention, the hole transport layer comprises a compound of formula (III), wherein more preferably the compound of formula (III) in the hole injection layer and hole transport layer is selected the same.

### Electron blocking layer

The function of an electron blocking layer (EBL) is to prevent electrons from being transferred from an emission layer to the hole transport layer and thereby confine electrons to the emission layer. Thereby, efficiency, operating voltage and/or lifetime are improved. Typically, the electron blocking layer comprises a triarylamine compound. The triarylamine compound may have a LUMO level closer to vacuum level than the LUMO level of the hole transport layer. The electron blocking layer may have a HOMO level that is further away from vacuum level compared to the HOMO level of the hole transport layer. The thickness of the electron blocking layer may be selected between 2 and 20 nm.

If the electron blocking layer has a high triplet level, it may also be described as triplet control layer.

The function of the triplet control layer is to reduce quenching of triplets if a phosphorescent green or blue emission layer is used. Thereby, higher efficiency of light emission from a phosphorescent emission layer can be achieved. The triplet control layer is selected from triarylamine compounds with a triplet level above the triplet level of the phosphorescent emitter in the adjacent emission layer. Suitable compounds for the triplet control layer, in particular the triarylamine compounds, are described in EP 2 722 908 A1.

### Emission layer (EML)

The EML may be formed on the HTL by vacuum deposition, spin coating, slot-die coating, printing, casting, LB deposition, or the like. When the EML is formed using vacuum deposition or spin coating, the conditions for deposition and coating may be similar to those for the formation of the HIL. However, the conditions for deposition and coating may vary, according to the compound that is used to form the EML.

According to one embodiment of the present invention, the emission layer does not comprise the compound of formula (I).

The emission layer (EML) may be formed of a combination of a host and an emitter dopant. Example of the host are Alq3, 4,4'-N,N'-dicarbazole-biphenyl (CBP), poly(n-vinylcarbazole) (PVK), 9,10-di(naphthalene-2-yl)anthracene (ADN), 4,4',4"-tris(carbazol-9-yl)-triphenylamine(TCTA), 1,3,5-tris(N-phenylbenzimidazole-2-yl)benzene (TPBI), 3-tert-butyl-9,10-di-2-naphthylanthracenee (TBADN), distyrylarylene (DSA) and bis(2-(2-hydroxyphenyl)benzo-thiazolate)zinc (Zn(BTZ)2).

The emitter dopant may be a phosphorescent or fluorescent emitter. Phosphorescent emitters and emitters which emit light via a thermally activated delayed fluorescence (TADF) mechanism may be preferred due to their higher efficiency. The emitter may be a small molecule or a polymer.

Examples of red emitter dopants are PtOEP, Ir(piq)3, and Btp2lr(acac), but are not limited thereto. These compounds are phosphorescent emitters, however, fluorescent red emitter dopants could also be used.

Examples of phosphorescent green emitter dopants are Ir(ppy)3 (ppy = phenylpyridine), Ir(ppy)2(acac), Ir(mpyp)3.

Examples of phosphorescent blue emitter dopants are F2Irpic, (F2ppy)2Ir(tmd) and Ir(dfppz)3 and ter-fluorene. 4.4'-bis(4-diphenyl amiostyryl)biphenyl (DPAVBi), 2,5,8,11-tetra-tert-butyl perylene (TBPe) are examples of fluorescent blue emitter dopants.

The amount of the emitter dopant may be in the range from about 0.01 to about 50 parts by weight, based on 100 parts by weight of the host. Alternatively, the emission layer may consist of a light-emitting polymer. The EML may have a thickness of about 10 nm to about 100 nm, for example, from about 20 nm to about 60 nm. When the thickness of the EML is within this range, the EML may have excellent light emission, without a substantial penalty in driving voltage.

According to a preferred embodiment of the present invention, the emission layer comprises a light-emitting compound of formula (IV): 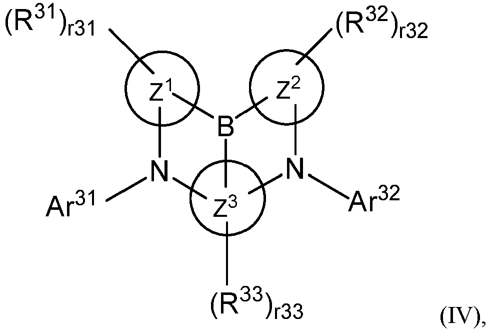 wherein
Z¹, Z² and Z³ are the same as or different from each other, and are each independently selected from the group comprising a monocyclic to polycyclic aromatic hydrocarbon ring or monocyclic to polycyclic aromatic hetero ring;
Ar³¹ and Ar³² are the same as or selected different from each other, and are each independently a substituted or unsubstituted alkyl group, a substituted or unsubstituted aryl group, or a substituted or unsubstituted heteroaryl group, or are bonded to an adjacent substituent to form a substituted or unsubstituted aromatic ring or a substituted or unsubstituted aliphatic ring;
R³¹, R³² and R³³ are the same as or different from each other, and are each independently selected from the group comprising hydrogen, deuterium, a substituted or unsubstituted alkyl group, a substituted or unsubstituted silyl group, a substituted or unsubstituted amine group, a substituted or unsubstituted aryl group, or a substituted or unsubstituted heteroaryl group, or adjacent substituents are bonded to each other to form a substituted or unsubstituted aromatic ring or a substituted or unsubstituted aliphatic ring,
wherein one or more substituents selected from the group consisting of deuterium, an alkyl group having 1 to 6 carbon atoms, an alkyl silyl group having 1 to 30 carbon atoms, an aryl silyl group having 6 to 50 carbon atoms, an alkylamine group having 1 to 30 carbon atoms, an alkylarylamine group having 1 to 50 carbon atoms, an arylamine group having 6 to 50 carbon atoms, an aryl group having 6 to 30 carbon atoms, and a heteroaryl group having 2 to 30 carbon atoms, or a substituent to which two or more substituents selected from the group are linked, or adjacent substituents are bonded to each other to form an aliphatic hydrocarbon ring having 3 to 60 carbon atoms, which is unsubstituted or substituted with the substituent;
r³¹, r³² and r³³ are each an integer from 0, 1, 2, 3 or 4, and when r³¹ to r³³ are 2 or higher, substituents in the parenthesis are the same as or different from each other.

According to one embodiment, for formula (III):
- Z¹, Z² and Z³: are the same as or selected different from each other, and are each independently selected from the group comprising a monocyclic to bicyclic aromatic hydrocarbon ring, or a monocyclic to bicyclic aromatic hetero ring containing O, N or S;
- Ar³¹ and Ar³²: are the same as or selected different from, and are each independently selected from the group comprising an alkyl group having 1 to 10 carbon atoms, which is unsubstituted or substituted with an aryl group, an aryl group having 6 to 30 carbon atoms, which is unsubstituted or substituted with an aryl group, or a heteroaryl group having 2 to 30 carbon atoms;
- R³¹, R³² and R³³: are the same as or selected different from each other, and are each independently selected from the group comprising hydrogen, deuterium, a substituted or unsubstituted alkyl group, a substituted or unsubstituted cycloalkyl group, a substituted or unsubstituted silyl group, a substituted or unsubstituted aryl group,
or a substituted or unsubstituted heteroaryl group.

According to one embodiment, wherein for formula (III):
- Z¹, Z² and Z³: are the same as or selected different from each other, and are each independently selected from the group comprising a benzene ring or a thiophene ring;
- Ar³¹ and Ar³²: are the same as or selected different from each other, and are each independently selected from the group comprising phenyl group, a biphenyl group, a naphthyl group, a dimethyl fluorenyl group, a diphenyl fluorenyl group, a dibenzofuran group, or a dibenzothiophene group;
- R³¹, R³² and R³³: are the same as or selected different from each other, and are each independently selected from the group comprising hydrogen, deuterium, a substituted or unsubstituted alkyl group having 1 to 10 carbon atoms, a substituted or unsubstituted cycloalkyl group having 5 to 30 carbon atoms, a substituted or unsubstituted silyl group having 1 to 10 carbon atoms, a substituted or unsubstituted aryl group having 6 to 30 carbon atoms, or a substituted or unsubstituted heteroaryl group having 2 to 30 carbon atoms.

According to a preferred embodiment of the present invention, the emission layer comprises a light-emitting compound of formula (IV) is selected from formulae (BD1) to (BD9):

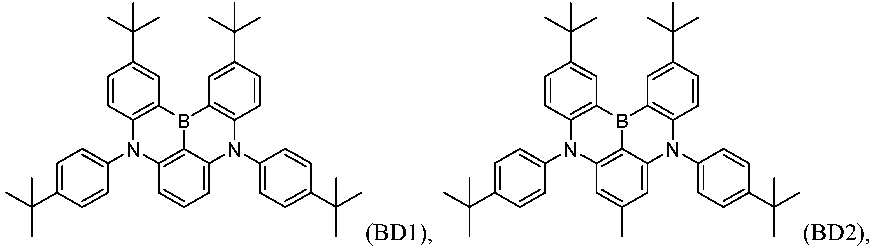

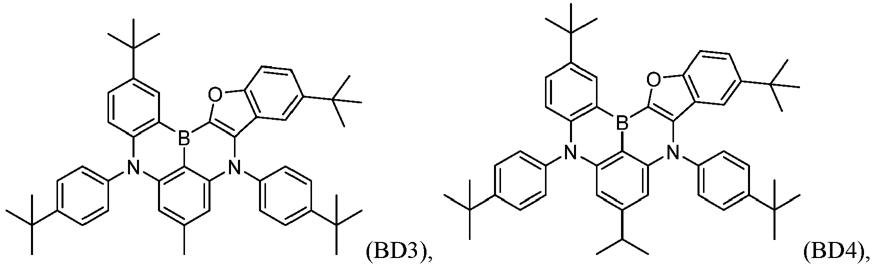

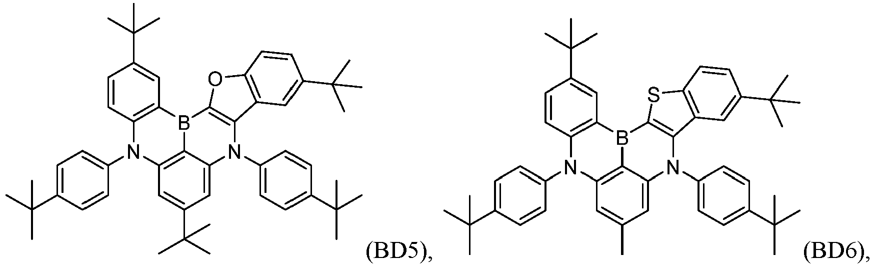

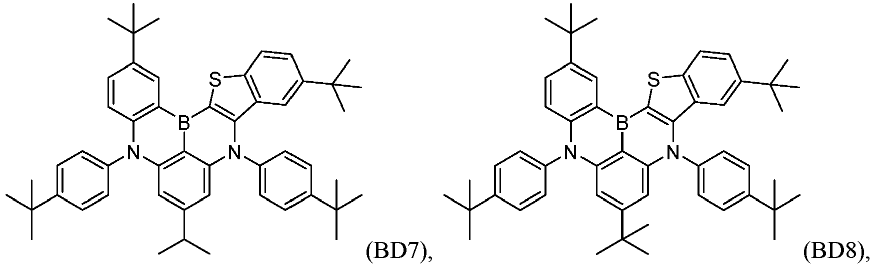

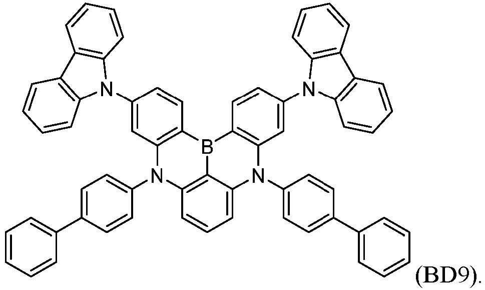

According to a preferred embodiment of the present invention, the emission layer comprises an organic emitter host compound, wherein the organic emitter host compound comprises
- at least one condensed aromatic ring system consisting of 3 to 5 rings, and
- 3 to 7 aromatic or heteroaromatic rings, wherein one or more sub-groups of the aromatic and/or heteroaromatic rings may be condensed to form fused aromatic or heteroaromatic ring systems;
wherein the molecular weight Mw of the organic emitter host compound is in the range of ≥ 400 and ≤ 2000 g/mol.

According to a preferred embodiment of the present invention, the organic emitter host compound has the formula (V) 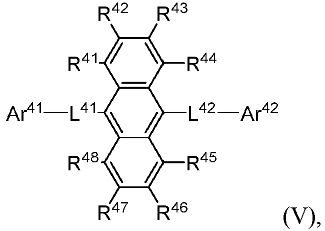 wherein
Ar⁴¹ and Ar⁴² are independently selected from substituted or unsubstituted C₆ to C₂₄ aryl, substituted or unsubstituted C₃ to C₂₄ heteroaryl;
L⁴¹ and L⁴² are independently selected from a direct bond or substituted or unsubstituted C₆ to C₂₄ arylene, substituted or unsubstituted C₃ to C₂₄ heteroarylene;
R⁴¹ to R⁴⁸ are independently selected from H, D, substituted or unsubstituted C₁ to C₁₂ alkyl, substituted or unsubstituted C₆ to C₁₉ aryl, substituted or unsubstituted C₃ to C₁₂ heteroaryl;
wherein
the substituents on Ar⁴¹, Ar⁴², L⁴¹, L⁴², R⁴¹ to R⁴⁸ are independently selected from D, C₆ to C₁₀ aryl, C₃ to C₉ heteroaryl, C₁ to C₆ alkyl, C₁ to C₆ alkoxy, C₃ to C₆ branched alkyl, C₃ to C₆ cyclic alkyl, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkyl, partially or perdeuterated C₁ to C₆ alkoxy, halogen, F or CN.

According to a preferred embodiment of the present invention, the organic emitter host and/or compound of formula (V) is selected from formulae (BH1) to (BH13):

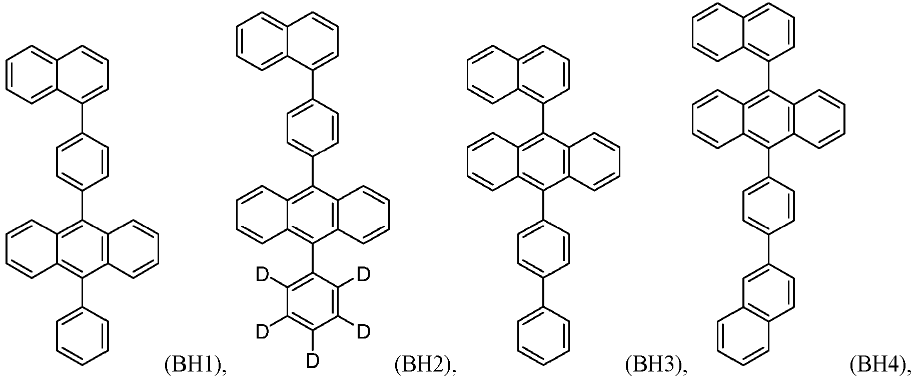

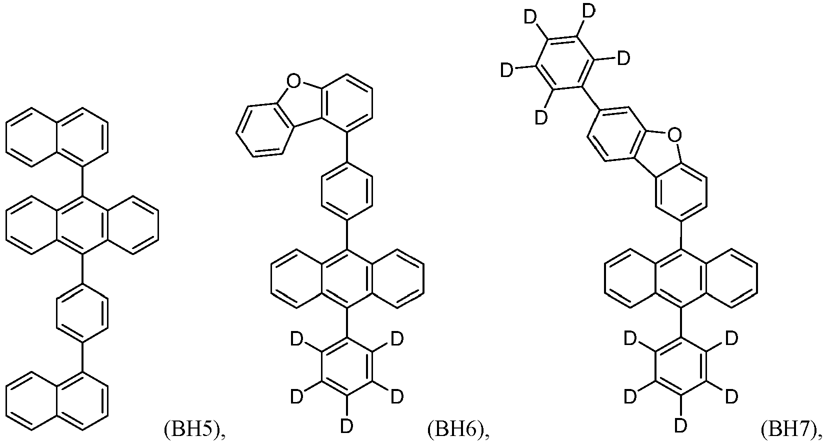

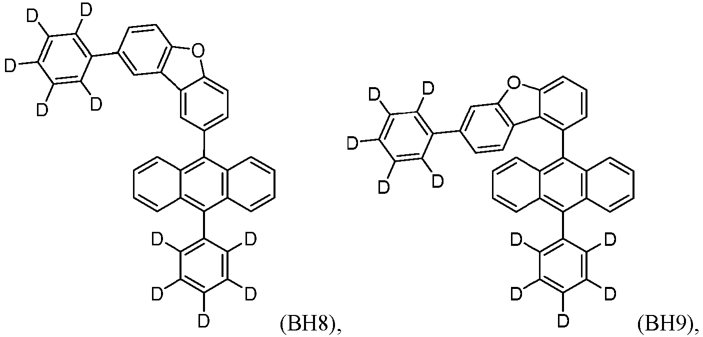

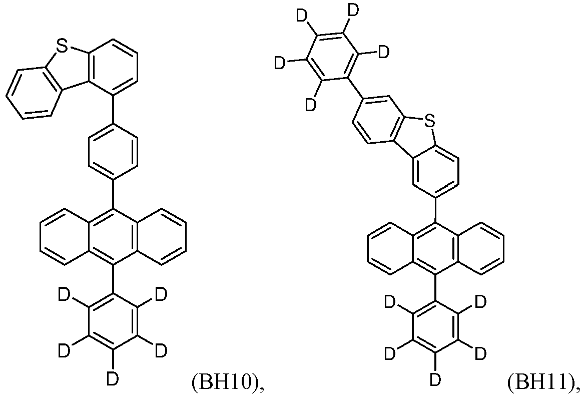

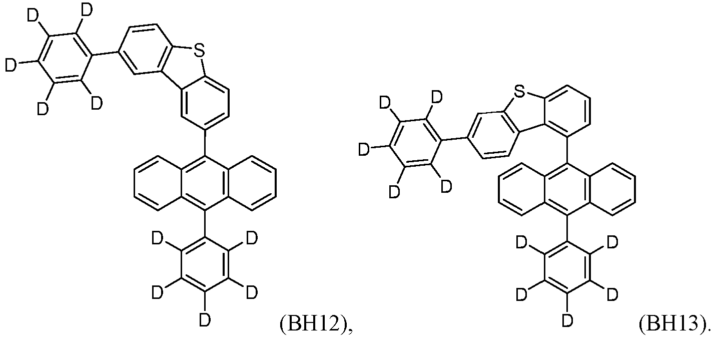

According to a preferred embodiment of the present invention, the emission layer comprises a light-emitting dopant of formula (IV) and an organic emitter host of formula (V).

According to a preferred embodiment of the organic electronic device, the hole injection layer comprises a compound of formula (I) and a compound of formula (III), the hole transport layer comprises a compound of formula (III), preferably the hole injection layer and the hole transport layer comprise the same compound of formula (III) and the emission layer comprises a light-emitting dopant of formula (IV) and an organic emitter host of formula (V);
wherein the hole transport layer is arranged between the hole injection layer and the emission layer, and the emission layer is arranged between the hole transport layer and the cathode layer.

According to a preferred embodiment of the organic electronic device, the hole injection layer comprises a compound of formula (I) and a compound of formula (III), the hole transport layer comprises a compound of formula (III), preferably the hole injection layer and the hole transport layer comprise the same compound of formula (III) and the emission layer comprises a light-emitting dopant of formula (IV) and an organic emitter host of formula (V);
wherein the hole transport layer is arranged between the hole injection layer and the emission layer, and the emission layer is arranged between the hole transport layer and the cathode layer;
wherein the anode layer may comprise a first anode sub-layer comprising Ag or Au having a thickness of 100 to 150 nm, a second anode sub-layer comprising or consisting of a transparent conductive oxide having a thickness of 3 to 20 nm and a third anode sub-layer comprising or consisting of a transparent conductive oxide having a thickness of 3 to 20 nm, preferably the transparent conductive oxide is selected from ITO or IZO.

### Hole blocking layer (HBL)

A hole blocking layer (HBL) may be formed on the EML, by using vacuum deposition, spin coating, slot-die coating, printing, casting, LB deposition, or the like, in order to prevent the diffusion of holes into the ETL. When the EML comprises a phosphorescent dopant, the HBL may have also a triplet exciton blocking function.

The HBL may also be named auxiliary ETL or a-ETL.

When the HBL is formed using vacuum deposition or spin coating, the conditions for deposition and coating may be similar to those for the formation of the HIL. However, the conditions for deposition and coating may vary, according to the compound that is used to form the HBL. Any compound that is commonly used to form a HBL may be used. Examples of compounds for forming the HBL include oxadiazole derivatives, triazole derivatives, phenanthroline derivatives and azine derivatives, preferably triazine or pyrimidine derivatives.

The HBL may have a thickness in the range from about 5 nm to about 100 nm, for example, from about 10 nm to about 30 nm. When the thickness of the HBL is within this range, the HBL may have excellent hole-blocking properties, without a substantial penalty in driving voltage.

### Electron transport layer (ETL)

The organic electronic device according to the present invention may further comprise an electron transport layer (ETL).

According to another embodiment of the present invention, the electron transport layer may further comprise an azine compound, preferably a triazine compound.

In one embodiment, the electron transport layer may further comprise a dopant selected from an alkali organic complex, preferably LiQ.

The thickness of the ETL may be in the range from about 15 nm to about 50 nm, for example, in the range from about 20 nm to about 40 nm. When the thickness of the EIL is within this range, the ETL may have satisfactory electron-injecting properties, without a substantial penalty in driving voltage.

According to another embodiment of the present invention, the organic electronic device may further comprise a hole blocking layer and an electron transport layer, wherein the hole blocking layer and the electron transport layer comprise an azine compound. Preferably, the azine compound is a triazine compound.

### Electron injection layer (EIL)

An optional EIL, which may facilitates injection of electrons from the cathode, may be formed on the ETL, preferably directly on the electron transport layer. Examples of materials for forming the EIL include lithium 8-hydroxyquinolinolate (LiQ), LiF, NaCl, CsF, Li2O, BaO, Ca, Ba, Yb, Mg which are known in the art. Deposition and coating conditions for forming the EIL are similar to those for formation of the HIL, although the deposition and coating conditions may vary, according to the material that is used to form the EIL.

The thickness of the EIL may be in the range from about 0.1 nm to about 10 nm, for example, in the range from about 0.5 nm to about 9 nm. When the thickness of the EIL is within this range, the EIL may have satisfactory electron-injecting properties, without a substantial penalty in driving voltage.

### Cathode layer

The cathode layer is formed on the ETL or optional EIL. The cathode layer may be formed of a metal, an alloy, an electrically conductive compound, or a mixture thereof. The cathode layer may have a low work function. For example, the cathode layer may be formed of lithium (Li), magnesium (Mg), aluminum (Al), aluminum (Al)-lithium (Li), calcium (Ca), barium (Ba), ytterbium (Yb), magnesium (Mg)-indium (In), magnesium (Mg)-silver (Ag), or the like. Alternatively, the cathode layer may be formed of a transparent conductive oxide, such as ITO or IZO.

The thickness of the cathode layer may be in the range from about 5 nm to about 1000 nm, for example, in the range from about 10 nm to about 100 nm. When the thickness of the cathode layer is in the range from about 5 nm to about 50 nm, the cathode layer may be transparent or semitransparent even if formed from a metal or metal alloy.

According to a preferred embodiment of the present invention, the cathode is transparent.

It is to be understood that the cathode layer is not part of an electron injection layer or the electron transport layer.

### Organic light-emitting diode (OLED)

The organic electronic device according to the invention may be an organic light-emitting device.

According to one aspect of the present invention, there is provided an organic light-emitting diode (OLED) comprising: a substrate; an anode layer formed on the substrate; a hole injection layer comprising a compound of formula (I), a hole transport layer, an emission layer, an electron transport layer and a cathode layer.

According to another aspect of the present invention, there is provided an OLED comprising: a substrate; an anode layer formed on the substrate; a hole injection layer comprising a compound of formula (I), a hole transport layer, an electron blocking layer, an emission layer, a hole blocking layer, an electron transport layer and a cathode layer.

According to another aspect of the present invention, there is provided an OLED comprising: a substrate; an anode layer formed on the substrate; a hole injection layer comprising a compound of formula (I), a hole transport layer, an electron blocking layer, an emission layer, a hole blocking layer, an electron transport layer, an electron injection layer, and a cathode layer.

According to various embodiments of the present invention, there may be provided OLEDs layers arranged between the above mentioned layers, on the substrate or on the top electrode.

### Organic electronic device

According to one embodiment of the present invention, the organic electronic device is a light emitting device or a display device, an organic light emitting diode (OLED), a light emitting device, thin film transistor, a battery or an organic photovoltaic cell (OPV).. More preferably, the electronic device is a light emitting device or display device.

The present invention furthermore relates to a display device comprising an organic electronic device according to the present invention.

According to another aspect of the present invention, there is provided a method of manufacturing an organic electronic device, the method using:
- at least one deposition source, preferably two deposition sources and more preferred at least three deposition sources.

The methods for deposition that can be suitable comprise:
- deposition via vacuum thermal evaporation;
- deposition via solution processing, preferably the processing is selected from spin-coating, printing, casting; and/or
- slot-die coating.

According to various embodiments of the present invention, the method may further include forming on the anode layer, at least one layer selected from the group consisting of forming a hole transport layer or forming a hole blocking layer, and an emission layer between the anode layer and the first electron transport layer.

According to various embodiments of the present invention, the method may further include the steps for forming an organic light-emitting diode (OLED), wherein
- on a substrate an anode layer is formed,
- on the anode layer a hole injection layer comprising a compound of formula (I) and a compound of formula (III) is formed,
- on the hole injection layer comprising a compound of formula (I) a hole transport layer is formed,
- on the hole transport layer an emission layer is formed,
- on the emission layer an electron transport layer is formed, optionally a hole blocking layer is formed on the emission layer,
- and finally a cathode layer is formed,
- optional a hole blocking layer is formed in that order between the first anode layer and the emission layer,
- optional an electron injection layer is formed between the electron transport layer and the cathode layer.

According to various embodiments, the OLED may have the following layer structure, wherein the layers having the following order:
anode, hole injection layer comprising a compound of formula (I) according to the invention, first hole transport layer, second hole transport layer, emission layer, optional hole blocking layer, electron transport layer, optional electron injection layer, and cathode.

According to another aspect of the invention, it is provided an electronic device comprising at least one organic light emitting device according to any embodiment described throughout this application, preferably, the electronic device comprises the organic light emitting diode in one of embodiments described throughout this application.

Hereinafter, the embodiments are illustrated in more detail with reference to examples. However, the present disclosure is not limited to the following examples. Reference will now be made in detail to the exemplary aspects.

### Description of the Drawings

The aforementioned components, as well as the claimed components and the components to be used in accordance with the invention in the described embodiments, are not subject to any special exceptions with respect to their size, shape, material selection and technical concept such that the selection criteria known in the pertinent field can be applied without limitations.

Additional details, characteristics and advantages of the object are disclosed in the dependent claims and the following description of the respective figures which in an exemplary fashion show preferred embodiments according to the invention. Any embodiment does not necessarily represent the full scope, however, and reference is made therefore to the claims and herein for interpreting the scope. It is to be understood that both the foregoing general description and the following detailed description are exemplary and explanatory only and are intended to provide further explanation of the present invention as claimed.

### Figures 1 to 8

- FIG. 1: is a schematic sectional view of an organic electronic device, according to an exemplary embodiment of the present invention;
- FIG. 2: is a schematic sectional view of an organic electronic device, according to an exemplary embodiment of the present invention;
- FIG. 3: is a schematic sectional view of an organic electronic device, according to an exemplary embodiment of the present invention.
- FIG. 4: is a schematic sectional view of an organic electronic device, according to an exemplary embodiment of the present invention;
- FIG. 5: is a schematic sectional view of an organic electronic device, according to an exemplary embodiment of the present invention;
- FIG. 6: is a schematic sectional view of an organic electronic device, according to an exemplary embodiment of the present invention;
- FIG. 7: is a schematic sectional view of an organic electronic device, according to an exemplary embodiment of the present invention;
- FIG. 8: is a schematic sectional view of an organic electronic device, according to an exemplary embodiment of the present invention;

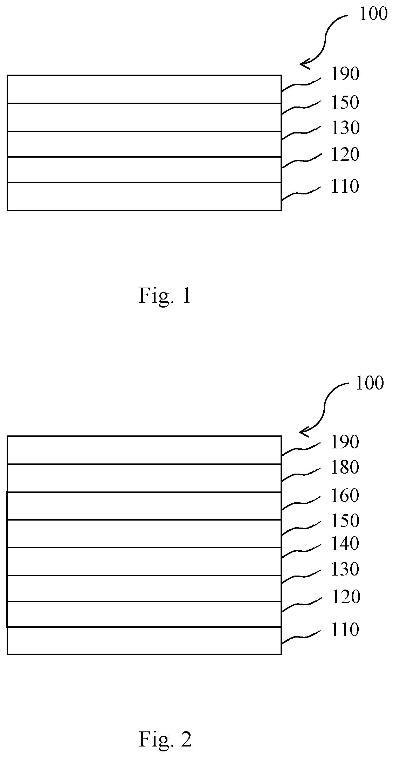

Hereinafter, the figures 1 to 9 are illustrated in more detail with reference to examples. However, the present disclosure is not limited to the following figures.

Herein, when a first element is referred to as being formed or disposed "on" or "onto" a second element, the first element can be disposed directly on the second element, or one or more other elements may be disposed there between. When a first element is referred to as being formed or disposed "directly on" or "directly onto" a second element, no other elements are disposed there between.

FIG. 1 is a schematic sectional view of an organic electronic device 100, according to an exemplary embodiment of the present invention. The organic electronic device 100 includes a substrate 110, an anode layer 120 and a hole injection layer (HIL) 130 which may comprise a compound of formula (I) and a compound of formula (III). The HIL 130 is disposed on the anode layer 120. Onto the HIL 130, an emission layer (EML) 150, and a cathode layer 190 are disposed.

FIG. 2 is a schematic sectional view of an organic electronic device 100, according to an exemplary embodiment of the present invention. The organic electronic device 100 includes a substrate 110, an anode layer 120 and a hole injection layer (HIL) 130 which may comprise a compound of formula (I) and a compound of formula (III). The HIL 130 is disposed on the anode layer 120. Onto the HIL 130, a hole transport layer (HTL) 140, an emission layer (EML) 150, an electron transport layer (ETL) 160, an electron injection layer (EIL) 180 and a cathode layer 190 are disposed. Instead of a single electron transport layer 160, optionally an electron transport layer stack (ETL) can be used.

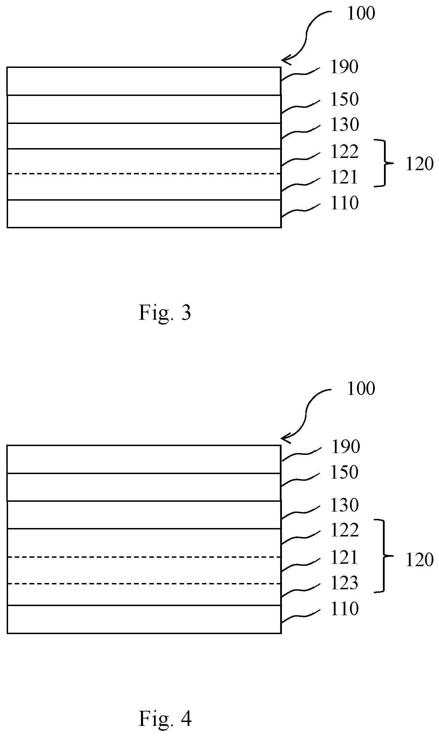

FIG. 3 is a schematic sectional view of an organic electronic device (100), according to an exemplary embodiment of the present invention. The organic electronic device (100) includes a substrate (110), an anode layer (120) that comprises a first anode sub-layer (121) and a second anode sub-layer (122) and a hole injection layer (HIL) (130). The HIL (130) is disposed on the anode layer (120). Onto the HIL (130), a first emission layer (EML) (150), and a cathode layer (190) are disposed.

FIG. 4 is a schematic sectional view of an organic electronic device (100), according to an exemplary embodiment of the present invention. The organic electronic device (100) includes a substrate (110), an anode layer (120) that comprises a first anode sub-layer (121), a second anode sub-layer (122) and a third anode sub-layer (123), and a hole injection layer (HIL) (130). The HIL (130) is disposed on the anode layer (120) comprising a first anode sub-layer (121), a second anode sub-layer (122) and a third anode sub-layer (123). Onto the HIL (130), a first emission layer (EML) (150), and a cathode layer (190) are disposed.

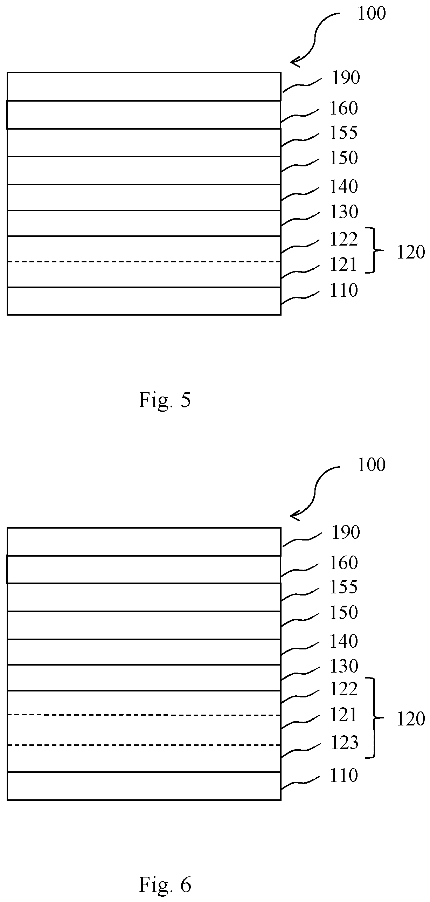

FIG. 5 is a schematic sectional view of an organic electronic device (100), according to an exemplary embodiment of the present invention. The organic electronic device (100) includes a substrate (110), an anode layer (120) that comprises a first anode sub-layer (121) and a second anode sub-layer (122), and a hole injection layer (HIL) (130). The HIL (130) is disposed on the anode layer (120). Onto the HIL (130), an hole transport layer (HTL) (140), a first emission layer (EML) (150), a hole blocking layer (BL) (155), an electron transport layer (ETL) (160), and a cathode layer (190) are disposed.

FIG. 6 is a schematic sectional view of an organic electronic device (100), according to an exemplary embodiment of the present invention. The organic electronic device (100) includes a substrate (110), an anode layer (120) that comprises a first anode sub-layer (121), a second anode sub-layer (122) and a third anode sub-layer (123), and a hole injection layer (HIL) (130). The HIL (130) is disposed on the anode layer (120). Onto the HIL (130), an hole transport layer (HTL) (140), a first emission layer (EML) (150), a hole blocking layer (HBL) (155), an electron transport layer (ETL) (160), and a cathode layer (190) are disposed.

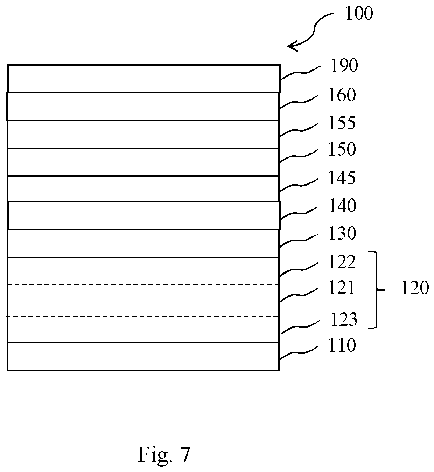

FIG. 7 is a schematic sectional view of an organic electronic device (100), according to an exemplary embodiment of the present invention. The organic electronic device (100) includes a substrate (110), an anode layer (120) that comprises a first anode sub-layer (121) and a second anode sub-layer (122) and a hole injection layer (HIL) (130). The HIL (130) is disposed on the anode layer (120). Onto the HIL (130), a hole transport layer (HTL) (140), an electron blocking layer (EBL) (145), a first emission layer (EML) (150), a hole blocking layer (HBL) (155), an electron transport layer (ETL) (160), and a cathode layer (190) are disposed.

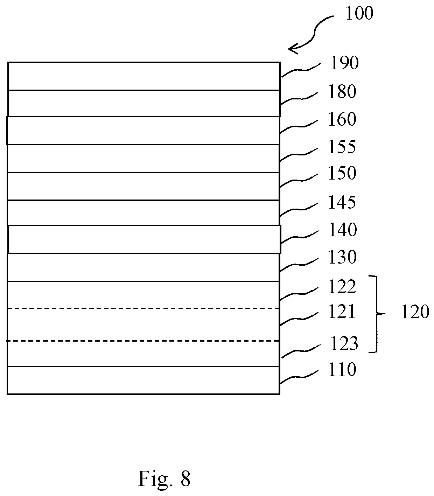

FIG. 8 is a schematic sectional view of an organic electronic device (100), according to an exemplary embodiment of the present invention. The organic electronic device (100) includes a substrate (110), an anode layer (120) that comprises a first anode sub-layer (121), a second anode sub-layer (122) and a third anode sub-layer (123), and a hole injection layer (HIL) (130). The HIL (130) is disposed on the anode layer (120). Onto the HIL (130), a hole transport layer (HTL) (140), an electron blocking layer (EBL) (145), a first emission layer (EML) (150), a hole blocking layer (HBL) (155), an electron transport layer (ETL) (160), an electron injection layer (EIL) (180) and a cathode layer (190) are disposed.

While not shown in Fig. 1 to Fig. 8, a capping and/or a sealing layer may further be formed on the cathode layer 190, in order to seal the organic electronic device 100. In addition, various other modifications may be applied thereto.

Hereinafter, the embodiments are illustrated in more detail with reference to examples. However, the present disclosure is not limited to the following examples.

### Detailed description

The invention is furthermore illustrated by the following examples which are illustrative only and non-binding.
The protonated form of the ligand of formula (II) L-H may be prepared by methods known in the art, for example as described in J. G. Lombardino, J. Org. Chem. 1968, 33, 10, 3938-3941.

Compounds of formula (I) may be prepared by methods known in the art and as described below.

### Synthesis of bis(1-(1,3-dioxo-1,3-dihydro-2H-inden-2-ylidene)-2,2,2-trifluoroethoxy)copper (MC-1)

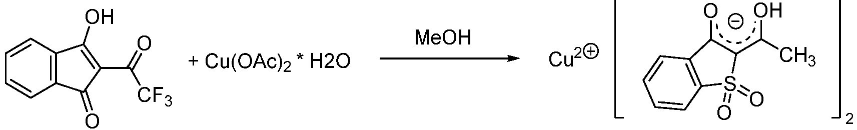

2.42g (10mmol) of 3-hydroxy-2-(2,2,2-trifluoroacetyl)-1H-inden-1-one and 1g (5mmol) of copper acetate monohydrate were added to 50ml methanol and stirred vigorously for 3 days. The suspension was filtered and the solid washed with methanol. After drying in high vacuum at 60°C, 2.39g (95%) product was obtained as a pale green powder, which was further purified by sublimation in vacuo.

### Synthesis of tris((2-(3,5-bis(trifluoromethyl)benzoyl)-1,1-dioxidobenzo[b]thiophen-3-yl)oxy)iron (MC-40)

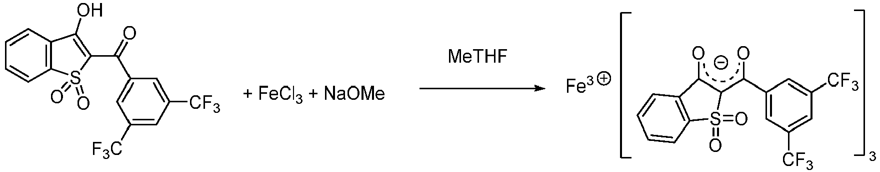

3g (7.1mmol) of (3,5-bis(trifluoromethyl)phenyl)(3-hydroxy-1,1-dioxidobenzo[b]thiophen-2-yl)methanone was dissolved in 30mL 2-methyltetrahydrofurane and 0.38g (7.1mmol) sodium methoxide and 0.41g (2.49mmol) iron trichloride were added. The mixture was stirred at room temperature for 2 hours. The precipitate was filtered off and the solvent was removed under reduced pressure. The residue was dissolved in dichloromethane and the product was precipitated by adding hexane. After filtration the product was dried in high vacuum to obtain 2.82g (90%) dark red solid, which was further purified by sublimation in vacuo.

### Synthesis of bis((2-(3,5-bis(trifluoromethyl)benzoyl)-1,1-dioxidobenzo[b]thiophen-3-yl)oxy)manganese (MC-65)

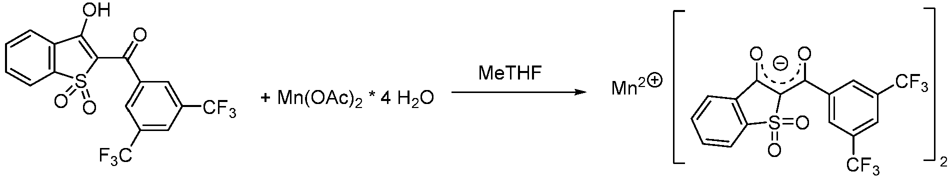

4,0g (9.47mmol) of (3,5-bis(trifluoromethyl)phenyl)(3-hydroxy-1,1-dioxidobenzo[b]thiophen-2-yl)methanone was dissolved in 40mL ethanol and a solution of 1.16g (4,74mmol) of manganese acetate tetrahydrate in 35ml ethanol was added. The mixture was stirred under reflux for 2 hours. After cooling the precipitate was filtered off and washed with ethanol and the solvent was removed under reduced pressure. The residue was dissolved in tetrahydrofurane and precipitated with hexane. The solid was filtered off, washed with hexane and dried in high vacuum to obtain 2,41g (57%) pale orange solid, which was further purified by sublimation in vacuo.

Compounds of formula (III), (IV) and (V) may be prepared by methods known in the art

### Calculated LUMO of compounds of formula (I) and comparative compounds

The energy of the lowest unoccupied molecular orbital (LUMO) of compounds of formula (I) and comparative compounds was calculated with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany). The LUMO energy levels of the molecular structures are determined by applying the hybrid functional B3LYP with a Def2-TZVP basis set and the Stuttgart/Dresden (SDD) effective core potential (ECP) for the metals from the optimized geometries obtained by applying the functional BP86 with a Def2-SVP basis set the Stuttgart/Dresden (SDD) effective core potential (ECP) for the metals. For materials containing a Ce(IV) cation, the LUMO energy levels of the molecular structures are determined by applying the hybrid functional B3LYP with a SARC-ZORA-TZVP basis set for the metals and a ZORA-Def2-TZVP basis set for all other atoms from the optimized geometries obtained by applying the functional BP86 with a SARC-ZORA-TZVP basis set for the metals and a ZORA-Def2-SVP basis set for all other atoms. All the calculations were performed in the gas phase. All relativistic calculations were performed by applying the zero order regular approximation (ZORA). If more than one conformation is viable, the conformation with the lowest total energy is selected. Depending on the metal cation different multiplicities may be applied. For the following metal cations the multiplicity is shown in brackets: Cu²⁺ (dublet), Cr³⁺ (quartet), Mn²⁺ (sextet), Mn³⁺ (quintet), Fe³⁺ (sextet), Co³⁺ (quintet), Al³⁺ (singlet), In³⁺ (singlet), Ru³⁺ (sextet), Ce⁴⁺ (singlet).

The LUMO values in Tables 1 and 2 were calculated by this method unless noted otherwise.

According to an embodiment of compound of formula (I), the LUMO of compound of formula (I) is selected in the range of ≤ -3.4 eV and ≥ -6.5 eV, preferably ≤ -3.45 eV and ≥ -6 eV, more preferred ≤ -3.5 eV and ≥ -5.8 eV; wherein the LUMO is calculated by the method described above.

Thereby, particularly improved performance may be obtained in an organic electronic device comprising an organic semiconductor layer comprising compound of formula (I).

### HOMO and LUMO of compounds of formula (III), (IV) and (V)

The HOMO and LUMO of compounds of formula (III), (IV) and (V) may calculated with the program package TURBOMOLE V6.5 (TURBOMOLE GmbH, Litzenhardtstrasse 19, 76135 Karlsruhe, Germany). The optimized geometries and the HOMO and LUMO energy levels of the molecular structures are determined by applying the hybrid functional B3LYP with a 6-31G* basis set in the gas phase. If more than one conformation is viable, the conformation with the lowest total energy is selected. Under these conditions, the HOMO level of N2,N2,N2',N2',N7,N7,N7',N7'-octakis(4-methoxyphenyl)-9,9'-spirobi[fluorene]-2,2',7,7'-tetraamine is -4.27 eV.

Alternatively, the HOMO and LUMO of compounds of formula (III), (IV) and (V) may be calculated as described above for compounds of formula (I).

The HOMO values in Table 3 were calculated by this method unless noted otherwise.

### Melting point

The melting point (mp) is determined as peak temperatures from the DSC curves of the above TGA-DSC measurement or from separate DSC measurements (Mettler Toledo DSC822e, heating of samples from room temperature to completeness of melting with heating rate 10 K/min under a stream of pure nitrogen. Sample amounts of 4 to 6 mg are placed in a 40 µL Mettler Toledo aluminum pan with lid, a <1 mm hole is pierced into the lid).

### Glass transition temperature

The glass transition temperature (Tg) is measured under nitrogen and using a heating rate of 10 K per min in a Mettler Toledo DSC 822e differential scanning calorimeter as described in DIN EN ISO 11357, published in March 2010.

### Decomposition temperature T_{dec}

The decomposition temperature T_{dec} is measured by loading a sample of 9 to 11 mg into a Mettler Toledo 100 µL aluminum pan without lid under nitrogen in a Mettler Toledo TGA-DSC 1 machine. The following heating program was used: 25°C isothermal for 3 min; 25°C to 600°C with 10 K/min.
The decomposition temperature was determined based on the onset of the decomposition in TGA.

The decomposition temperature indicates the temperature at which the compound decomposes. The higher the decomposition temperature the higher the thermal stability of a compound.

### Rate onset temperature

The rate onset temperature (T_{RO}) is determined by loading 100 mg compound into a VTE source. As VTE source a point source for organic materials may be used as supplied by Kurt J. Lesker Company (www.lesker.com) or CreaPhys GmbH (http://www.creaphys.com). The VTE source is heated at a constant rate of 15 K/min at a pressure of less than 10⁻⁵ mbar and the temperature inside the source measured with a thermocouple. Evaporation of the compound is detected with a QCM detector which detects deposition of the compound on the quartz crystal of the detector. The deposition rate on the quartz crystal is measured in Ångstrom per second. To determine the rate onset temperature, the deposition rate is plotted against the VTE source temperature. The rate onset is the temperature at which noticeable deposition on the QCM detector occurs. For accurate results, the VTE source is heated and cooled three time and only results from the second and third run are used to determine the rate onset temperature.

To achieve good control over the evaporation rate of a compound, the rate onset temperature may be in the range of 200 to 300 °C. If the rate onset temperature is substantially below 200 °C the evaporation may be too rapid and therefore difficult to control. If the rate onset temperature is above 300 °C the evaporation rate may be too low which may result in low tact time and decomposition of the compound of formula (I) in VTE source may occur due to prolonged exposure to elevated temperatures.

The rate onset temperature is an indirect measure of the volatility of a compound. The higher the rate onset temperature the lower is the volatility of a compound.

### General procedure for fabrication of OLEDs

For inventive examples 1-1 to 1-11 and comparative example 1-1 in Table 4, a glass substrate with an anode layer comprising a first anode sub-layer of 120 nm Ag, a second anode sub-layer of 8 nm ITO and a third anode sub-layer of 10 nm ITO was cut to a size of 50 mm x 50 mm x 0.7 mm, ultrasonically washed with water for 60 minutes and then with isopropanol for 20 minutes. The liquid film was removed in a nitrogen stream, followed by plasma treatment to prepare the anode layer. The plasma treatment was performed in an atmosphere comprising 97.6 vol.-% nitrogen and 2.4 vol.-% oxygen.

Then, the compound of formula (I) and the matrix compound of formula (III) were codeposited in vacuum on the anode layer, to form a hole injection layer (HIL) having a thickness of 10 nm. The composition of the hole injection layer can be seen in Table 4. The formulae of the compounds of formula (I) are described above or can be seen in Tables 1 and 2. The matrix compound can be seen in Table 3.

Then, the matrix compound was vacuum deposited on the HIL, to form a HTL having a thickness of 123 nm. The compound of formula (III) in the HTL is selected the same as the matrix compound in the HIL.

Then N,N-di([1,1'-biphenyl]-4-yl)-3'-(9H-carbazol-9-yl)-[1,1'-biphenyl]-4-amine was vacuum deposited on the HTL, to form an electron blocking layer (EBL) having a thickness of 5 nm.

Then the emission layer (EML) was formed on the EBL having a thickness of 20 nm by co-depositing 99 vol.-% EML host compound BH9 and 1 vol.-% EML dopant BD8.

Then a hole blocking layer was formed with a thickness of 5 nm by depositing 4-([1,1'-biphenyl]-4-yl)-6-(3'-(9,9-dimethyl-9H-fluoren-4-yl)-[1,1'-biphenyl]-4-yl)-2-phenylpyrimidine on the emission layer EML.

Then the electron transport layer having a thickness of 31 nm was formed on the hole blocking layer by depositing 50 wt.-% 6,6'-(naphthalene-1,2-diylbis(4,1-phenylene))bis(2,4-diphenyl-1,3,5-triazine) and 50 wt.-% of LiQ.

Then an electron injection layer was formed on the electron transport layer by depositing a layer of 1.3 nm Yb.

Then Ag:Mg (90:10 vol.-%) was evaporated at a rate of 0.01 to 1 Å/s at 10⁻⁷ mbar to form a cathode layer with a thickness of 13 nm on the electron transporting layer.

Then, N-([1,1'-biphenyl]-4-yl)-9,9-dimethyl-N-(4-(9-phenyl-9H-carbazol-3-yl)phenyl)-9H-fluoren-2-amine was deposited on the cathode layer to form a capping layer with a thickness of 75 nm.

The OLED stack is protected from ambient conditions by encapsulation of the device with a glass slide. Thereby, a cavity is formed, which includes a getter material for further protection.

To assess the performance of the inventive examples compared to the prior art, the current efficiency is measured at 20°C. The current-voltage characteristic is determined using a Keithley 2635 source measure unit, by sourcing a voltage in V and measuring the current in mA flowing through the device under test. The voltage applied to the device is varied in steps of 0.1V in the range between 0V and 10V. Likewise, the luminance-voltage characteristics and CIE coordinates are determined by measuring the luminance in cd/m² using an Instrument Systems CAS-140CT array spectrometer (calibrated by Deutsche Akkreditierungsstelle (DAkkS)) for each of the voltage values.

To determine the voltage stability over time U(100h)-(1h), a current density of at 20 mA/cm² was applied to the device. The operating voltage was measured after 1 hour and after 100 hours, followed by calculation of the voltage stability for the time period of 1 hour to 100 hours. A low value for U(100h)-(1h) denotes a low increase in operating voltage over time and thereby improved voltage stability.

### Technical Effect of the invention

In Table 1 are shown the calculated LUMO in electron volt of compounds of formula (I). The following multiplicities were applied dependent on metal cation: Cu²⁺ (dublet), Cr³⁺ (quartet), Mn²⁺ (sextet), Mn³⁺ (quintet), Fe³⁺ (sextet), Co³⁺ (quintet), Al³⁺ (singlet), In³⁺ (singlet), Ru³⁺ (sextet), Ce⁴⁺ (singlet).

**Table 1: LUMO values of compounds of formula (I)**

| Referred to as: | Structure | **LUMO** (eV) |
|---|---|---|
| MC-1 | 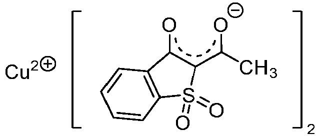 | -4.04 |
| MC-2 | 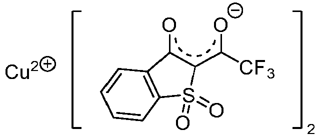 | -4.62 |
| MC-3 | 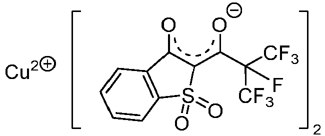 | -4.63 |
| MC-4 | 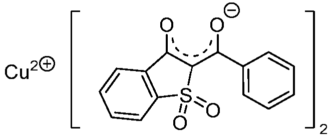 | -3.87 |
| MC-5 | 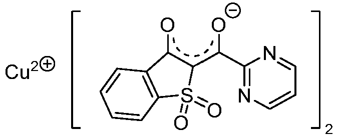 | -3.77 |
| MC-6 | 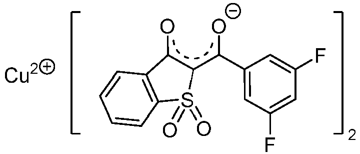 | -4.17 |
| MC-7 | 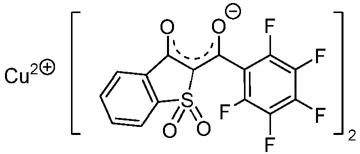 | -4.51 |
| MC-8 | 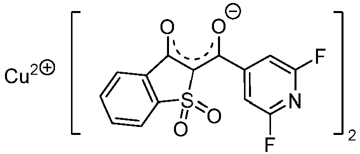 | -4.49 |
| MC-9 | 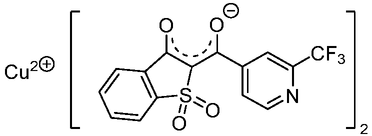 | -4.45 |
| MC-10 | 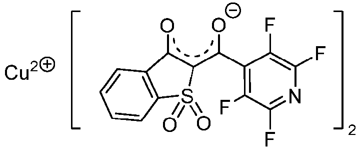 | -4.69 |
| MC-11 | 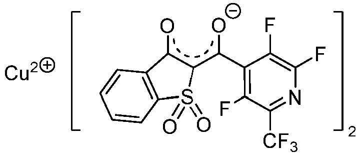 | -4.78 |
| MC-12 | 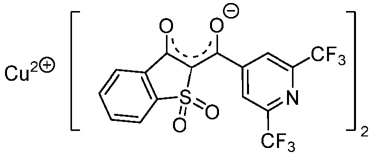 | -4.67 |
| MC-13 | 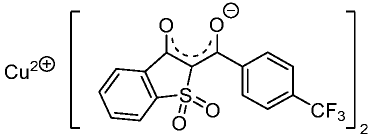 | -4.19 |
| MC-14 | 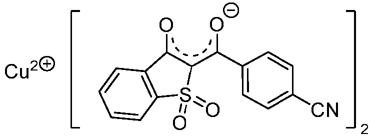 | -4.33 |
| MC-15 | 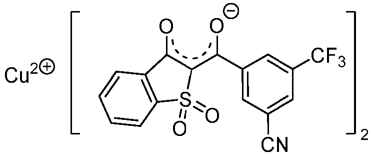 | -4.51 |
| MC-16 | 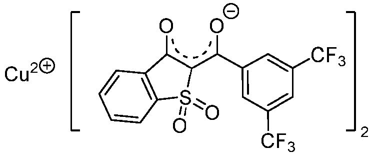 | -4.38 |
| MC-17 | 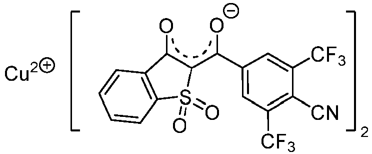 | -4.71 |
| MC-18 | 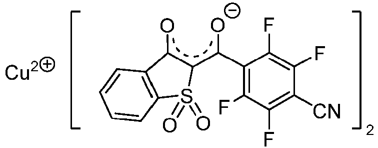 | -4.79 |
| MC-19 | 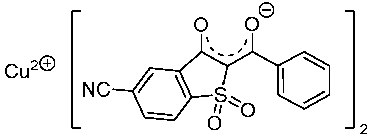 | -4.27 |
| MC-20 | 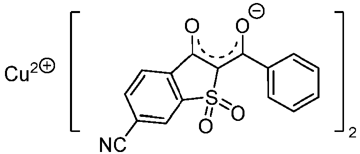 | -4.32 |
| MC-21 | 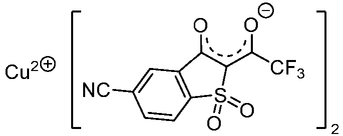 | -5.08 |
| MC-22 | 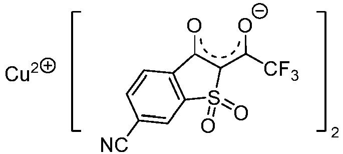 | -5.10 |
| MC-23 | 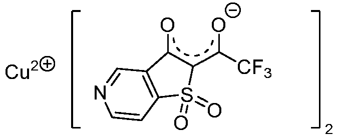 | -4.90 |
| MC-24 | 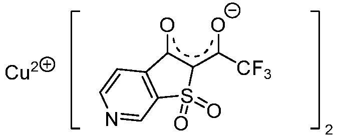 | -5.02 |
| MC-25 | 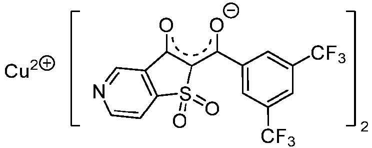 | -4.61 |
| MC-26 | 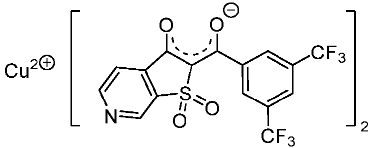 | -4.71 |
| MC-27 | 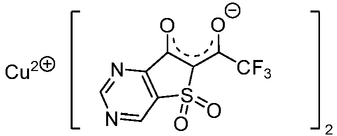 | -5.08 |
| MC-28 | 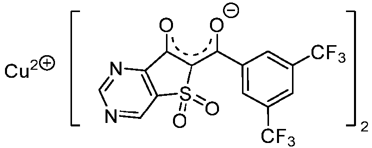 | -4.73 |
| MC-29 | 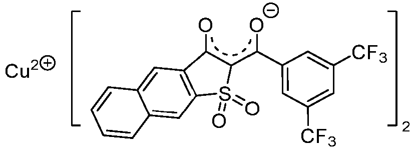 | -4.25 |
| MC-30 | 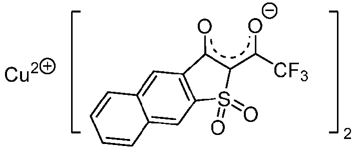 | -4.48 |
| MC-31 | 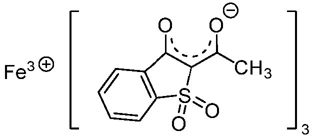 | -4.39 |
| MC-32 | 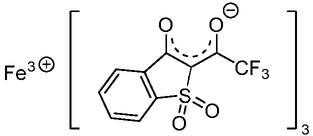 | -5.06 |
| MC-33 | 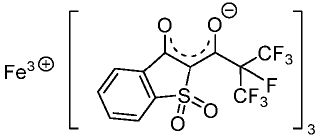 | -5.08 |
| MC-34 | 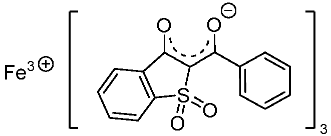 | -4.19 |
| MC-35 | 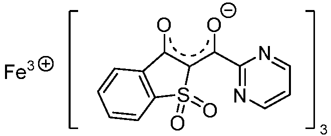 | -4.10 |
| MC-36 | 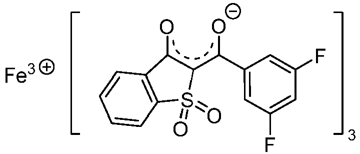 | -4.53 |
| MC-37 | 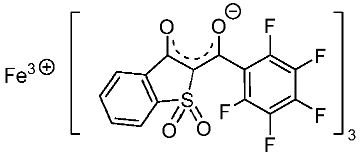 | -4.89 |
| MC-38 | 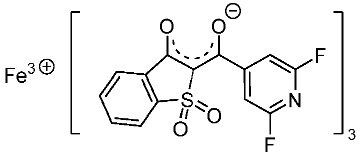 | -4.93 |
| MC-39 | 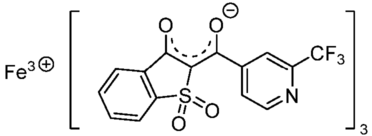 | -4.90 |
| MC-40 | 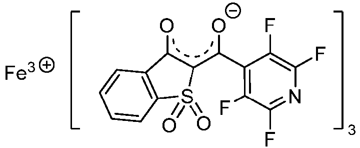 | -5.09 |
| MC-41 | 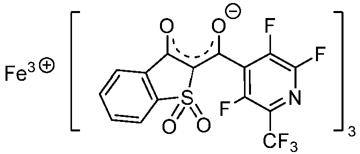 | -5.19 |
| MC-42 | 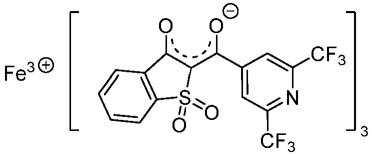 | -5.15 |
| MC-43 | 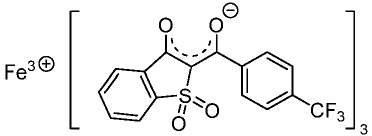 | -4.59 |
| MC-44 | 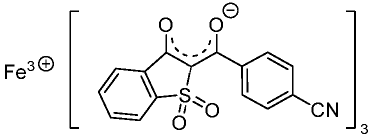 | -4.76 |
| MC-45 | 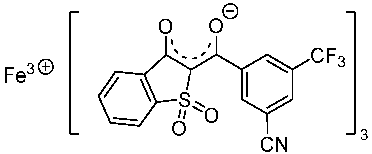 | -4.95 |
| MC-46 | 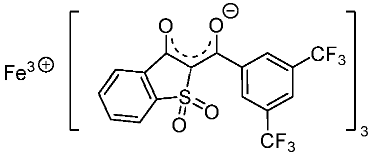 | -4.80 |
| MC-47 | 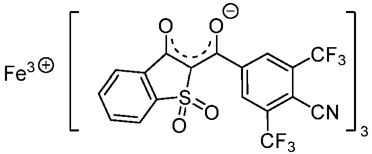 | -5.20 |
| MC-48 | 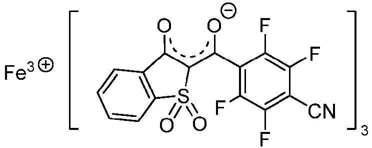 | -5.22 |
| MC-49 | 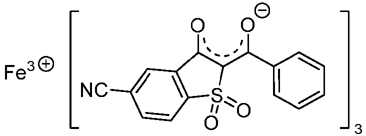 | -4.66 |
| MC-50 | 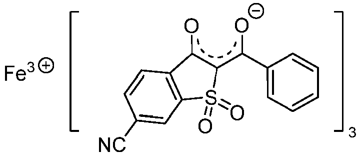 | -4.76 |
| MC-51 | 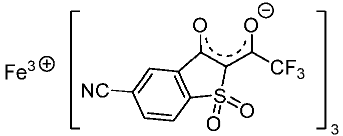 | -5.58 |
| MC-52 | 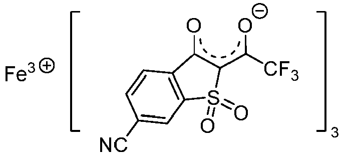 | -5.67 |
| MC-53 | 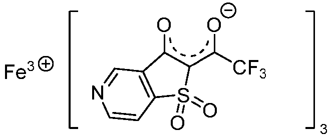 | -5.36 |
| MC-54 | 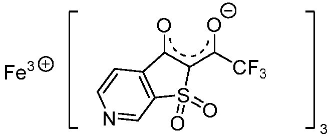 | -5.54 |
| MC-55 | 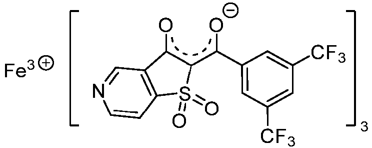 | -5.06 |
| MC-56 | 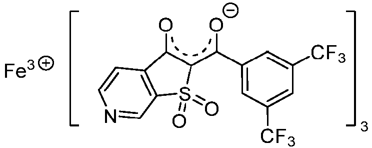 | -5.20 |
| MC-57 | 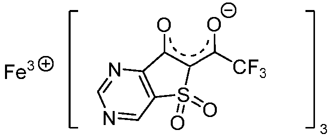 | -5.57 |
| MC-58 | 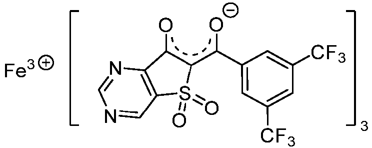 | -5.20 |
| MC-59 | 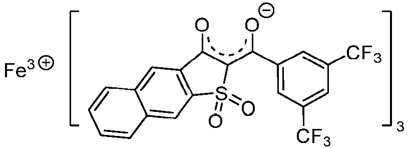 | -4.57 |
| MC-60 | 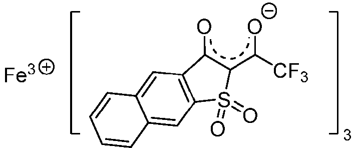 | -4.92 |
| MC-61 | 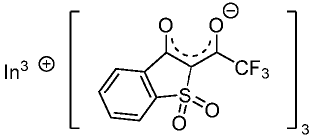 | -3.63 |
| MC-62 | 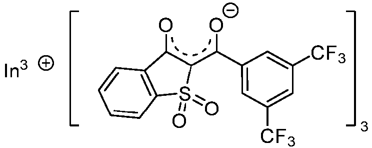 | -3.50 |
| MC-63 | 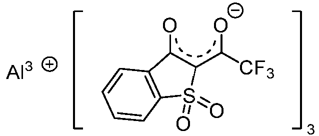 | -3.71 |
| MC-64 | 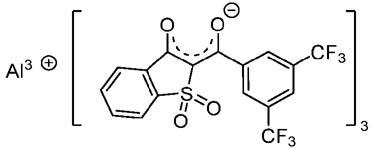 | -3.57 |
| MC-65 | 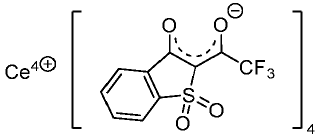 | -4.94 |
| MC-66 | 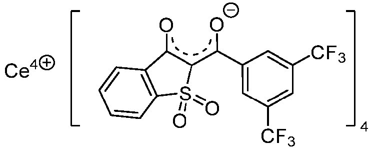 | -4.68 |
| MC-67 | 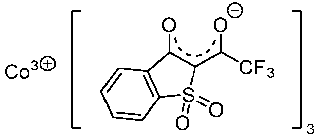 | -5.70 |
| MC-68 | 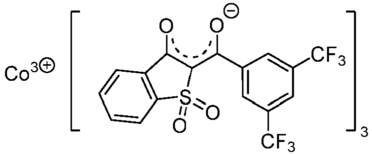 | -5.45 |
| MC-69 | 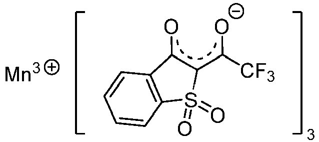 | -4.19 |
| MC-70 | 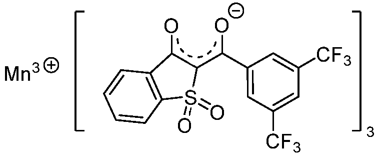 | -3.95 |
| MC-71 | 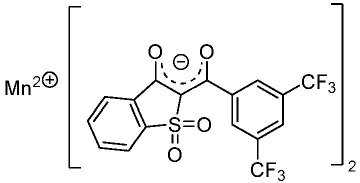 | -3.76 |
| MC-72 | 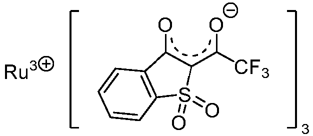 | -4.99 |
| MC-73 | 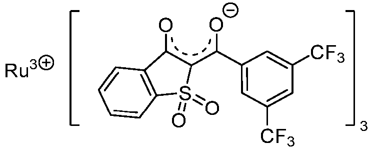 | -4.70 |
| MC-74 | 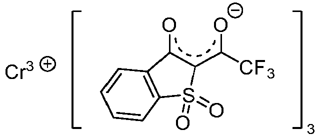 | -4.01 |
| MC-75 | 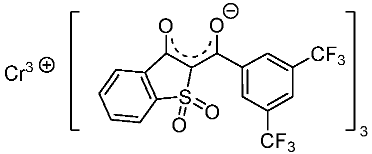 | -3.82 |

As can be seen in Table 1 above, the LUMO of compounds of formula (I) is in the range suitable for organic electronic devices.

In Table 2 are shown rate onset temperatures T_{RO} for compounds of formula (I) and comparative compounds. It is clearly deriveably from Table 2, that the T_{RO} for compounds of formula (I) are significantly higher than those for the comparative compounds.

In Comparative Compound 1 (CC-1), the LUMO is -4.76 eV, the melting point is 158 °C, the glass transition temperature is 44 °C and the rate onset temperature is 97 °C.

In Comparative Compound 2 (CC-2), the LUMO is -4.14 eV, the melting point is improved to 302 °C, the decomposition temperature is 308 °C and the rate onset temperature is improved to 196 °C compared to Comparative Compound 1.

In Comparative Compound 3 (CC-3), the LUMO is -3.76 eV and the rate onset temperature is 187 °C.

In compound of formula (I) MC-46, the LUMO is -4.80 eV, the decomposition temperature is improved to > 460 °C, and the rate onset temperature is improved to 314 °C compared to comparative compounds 6 to 8.

In compound of formula (I) MC-2, the LUMO is -4.62 eV, the decomposition temperature is improved to > 430 °C, and the rate onset temperature is improved to 314 °C compared to comparative compounds 6 to 8.

In summary, in compounds of formula (I), the LUMO and/or thermal properties are improved compared to comparative compounds. In particular, the decomposition temperature and/or rate onset temperature are improved.

A high decomposition temperature and/or rate onset temperature may be beneficial for the preparation of organic electronic devices in vacuum via a thermal evaporation process.

In Table 3 the properties of compounds of formula (III), in particular molecular mass, HOMO energy, glass transition temperature T_{g}, and rate onset temperature T_{RO} are shown.

In Table 4 are shown characteristics of organic electronic devices comprising a semiconductor layer comprising compounds of formula (I) and comparative compounds are shown.

In comparative example 1-1, the organic semiconductor layer comprises 1 wt.-% Comparative Compound 2 (CC-2) and 99 wt.-% compound K16. The operating voltage is 3.77 V and the voltage rise over time U(100h)-(1h) is 0.679 V.

In Example 1-1, the organic semiconductor layer comprises 1 wt.-% compound of formula (I) MC-46 and 99 wt.-% compound K16. Compound MC-46 differs from CC-2 in the ligand of formula (II). The operating voltage is reduced to 3.51 V and the voltage rise over time U(100h)-(1h) is improved to 0.051 V compared to comparative example 1-1.

In Examples 1-2, the organic semiconductor layer comprises 2 wt.-% compound of formula (I) MC-46 and 98 wt.-% compound K16. The operating voltage is reduced to 3.36 V and the voltage rise over time U(100h)-(1h) is improved to 0.034 V compared to comparative example 1-1.

In Examples 1-3, the organic semiconductor layer comprises 4 wt.-% compound of formula (I) MC-46 and 96 wt.-% compound K16. The operating voltage is reduced to 3.31 V and the voltage rise over time U(100h)-(1h) is improved to 0.035 V compared to comparative example 1-1.

In Example 1-4, the organic semiconductor layer comprises 10 wt.-% compound of formula (I) MC-46 and 90 wt.-% compound K7. The operating voltage is reduced to 3.32 V and the voltage rise over time U(100h)-(1h) is improved to 0.068 V compared to comparative example 1-1.

In Example 1-5, the organic semiconductor layer comprises 14 wt.-% compound of formula (I) MC-46 and 86 wt.-% compound K7. The operating voltage is reduced to 3.31 V and the voltage rise over time U(100h)-(1h) is improved to 0.034 V compared to comparative example 1-1.

In Example 1-6, the organic semiconductor layer comprises 18 wt.-% compound of formula (I) MC-46 and 82 wt.-% compound K7. The operating voltage is reduced to 3.31 Vand the voltage rise over time U(100h)-(1h) is improved to 0.030 V compared to comparative example 1-1.

In Example 1-7, the organic semiconductor layer comprises 4 wt.-% compound of formula (I) MC-46 and 96 wt.-% compound K2. The operating voltage is reduced to 3.29 V and the voltage rise over time U(100h)-(1h) is improved to 0.066 V compared to comparative example 1-1.

In Example 1-8, the organic semiconductor layer comprises 8 wt.-% compound of formula (I) MC-46 and 92 wt.-% compound K2. The operating voltage is reduced to 3.27 V and the voltage rise over time U(100h)-(1h) is improved to 0.025 V compared to comparative example 1-1.

In Example 1-9, the organic semiconductor layer comprises 12 wt.-% compound of formula (I) MC-46 and 88 wt.-% compound K2. The operating voltage is reduced to 3.27 V and the voltage rise over time U(100h)-(1h) is improved to 0.024 V compared to comparative example 1-1.

In Example 1-10, the organic semiconductor layer comprises 4 wt.-% compound of formula (I) MC-2 and 96 wt.-% compound K16. The operating voltage is reduced to 3.33 V and the voltage rise over time U(100h)-(1h) is improved to 0.047 V compared to comparative example 1-1.

In Example 1-11, the organic semiconductor layer comprises 7 wt.-% compound of formula (I) MC-2 and 93 wt.-% compound K16. The operating voltage is reduced to 3.32 V and the voltage rise over time U(100h)-(1h) is improved to 0.035 V compared to comparative example 1-1.

A low operating voltage may be important for low power consumption of organic electronic devices, in particular mobile devices.

In summary, the operating voltage and/or voltage rise over time U(100h)-(1h) of an organic electronic device comprising a compound of formula (I) are improved over the close art.

A low voltage rise over time U(100h)-(1h) is an indirect measure of the longterm voltage stability of an organic electronic device. The lower the voltage rise over time, the higher the longterm voltage stability of the organic electronic device.

**Table 2: Properties of compounds of formula (I) and comparative compounds**

| Referred to as: | Structure | LUMO (eV) | mp (°C) | Tg (°C) | T_{dec} (°C) | T_{RO} (°C) |
|---|---|---|---|---|---|---|
| Comparative Compound 1 (CC-1) | 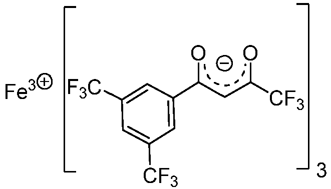 | -4.76 | 158 | 44 | n.d. | 97 |
| Comparative Compound 2 (CC-2) | 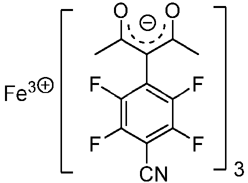 | -4.14 | 302 | n.o. ¹⁾ | 308 | 196 |
| Comparative Compound 3 (CC-3) | 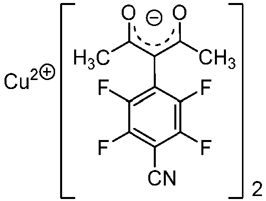 | -3.76 | n.o. | n.d. ²⁾ | n.d. | 187 |
| MC-46 | 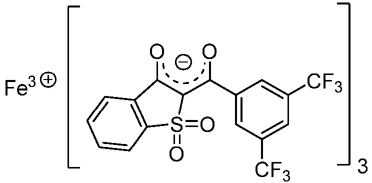 | -4.80 | n.o. | n.o. | > 460 | 314 |
| MC-2 | 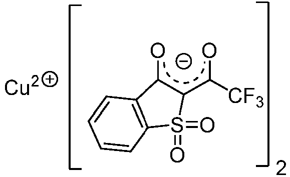 | -4.62 | n.o. | n.o. | > 430 | 292 |
| MC-71 | 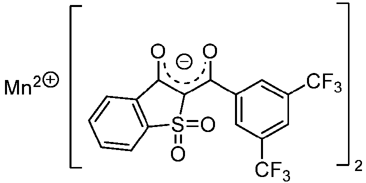 | -3.76 | n.o. | n.o. | > 472 | 340 |

| | | | | | | |
|---|---|---|---|---|---|---|
| ¹⁾ "n.o." = not observed. ²⁾ "n.d." = not determined | | | | | | |

**Table 3: Properties of compounds of formula (III) and comparative hole transport material (HTM)**

| Referred to as: | Structure | Molecular mass (Da) | **HOMO** (eV) | Tg (°C) | T_{RO} (°C) |
|---|---|---|---|---|---|
| HTM-1 (comparative) | 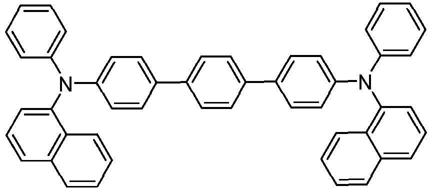 | 665 | -4.99 | 107 | 249 |
| K1 | 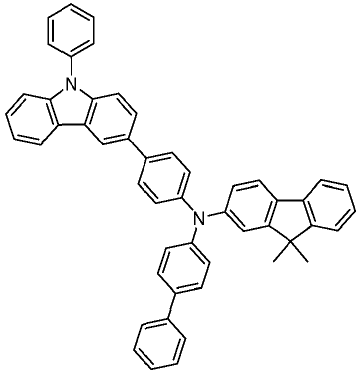 | 679 | -4.88 | 126 | 265 |
| K2 | 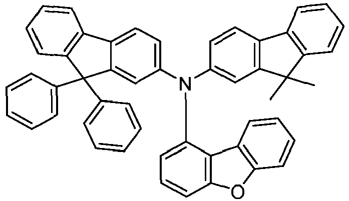 | 692 | -5.03 | 137 | 219 |
| K7 | 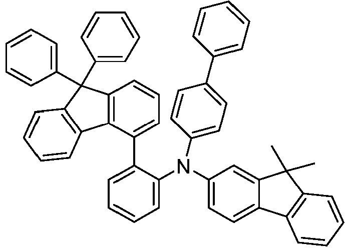 | 754 | -5.04 | 138 | 220 |
| K16 | 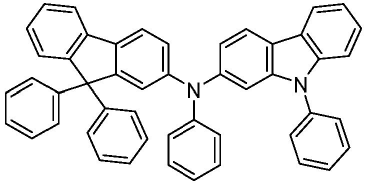 | 651 | -4.96 | 120 | 216 |
| K18 | 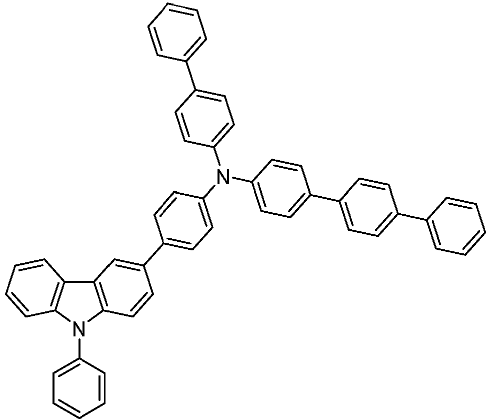 | 715 | -4.95 | 126 | 299 |
| K19 | 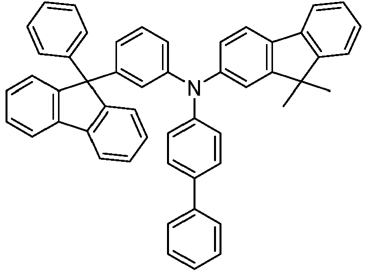 | 678 | -4.99 | 109 | 208 |

**Table 4: Performance of an organic electronic device comprising a hole injection layer**

| | Compound of formula (I) | Percentage compound of formula (I) in semiconductor layer [wt.-%] | Matrix compound | Percentage matrix compound in semiconductor layer [wt.-%] | Thickness organic semiconductor layer [nm] | Voltage at 10mA/cm² [V] | U(100h)-(1h) at 20mA/cm² [V] |
|---|---|---|---|---|---|---|---|
| Comparative example 1-1 | CC-2 | 1 | K16 | 99 | 10 | 3.77 | 0.679 |
| Example 1-1 | MC-46 | 1 | K16 | 99 | 10 | 3.51 | 0.051 |
| Example 1-2 | MC-46 | 2 | K16 | 98 | 10 | 3.36 | 0.034 |
| Example 1-3 | MC-46 | 4 | K16 | 96 | 10 | 3.31 | 0.035 |
| Example 1-4 | MC-46 | 10 | K7 | 90 | 10 | 3.32 | 0.068 |
| Example 1-5 | MC-46 | 14 | K7 | 86 | 10 | 3.31 | 0.034 |
| Example 1-6 | MC-46 | 18 | K7 | 82 | 10 | 3.31 | 0.030 |
| Example 1-7 | MC-46 | 4 | K2 | 96 | 10 | 3.29 | 0.066 |
| Example 1-8 | MC-46 | 8 | K2 | 92 | 10 | 3.27 | 0.025 |
| Example 1-9 | MC-46 | 12 | K2 | 88 | 10 | 3.27 | 0.024 |
| Example 1-10 | MC-2 | 4 | K16 | 96 | 10 | 3.33 | 0.047 |
| Example 1-11 | MC-2 | 7 | K16 | 93 | 10 | 3.32 | 0.035 |

The particular combinations of elements and features in the above detailed embodiments are exemplary only; the interchanging and substitution of these teachings with other teachings in this and the patents/applications incorporated by reference are also expressly contemplated. As those skilled in the art will recognize, variations, modifications, and other implementations of what is described herein can occur to those of ordinary skill in the art without departing from the scope of the invention as claimed. Accordingly, the foregoing description is by way of example only and is not intended as limiting. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. The invention's scope is defined in the following claims. Furthermore, reference signs used in the description and claims do not limit the scope of the invention as claimed.

## Claims

1. An organic electronic device comprising a substrate (110), an anode layer (120), a cathode layer (190), at least one first emission layer (150), and a hole injection layer (130), wherein
the hole injection layer comprises a compound of formula (I): 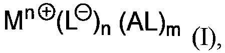
wherein:
M is a metal ion;
n is the valency of M and selected from 1 to 4;
L is a ligand of formula (II) 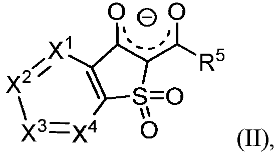
Wherein
X¹ is selected from CR¹ or N;
X² is selected from CR² or N;
X³ is selected from CR³ or N;
X⁴ is selected from CR⁴ or N;
Wherein 0, 1 or 2 of the group consisting of X¹, X², X³, X⁴ are selected from N;
R¹ to R⁴ are independently selected from H, D, substituted or unsubstituted C₁ to C₁₂ alkyl, substituted or unsubstituted C₆ to C₁₉ aryl, substituted or unsubstituted C₂ to C₂₀ heteroaryl, substituted or unsubstituted 6-membered heteroaryl, halogen, F, Cl or CN; and whereby any R^{k} to R^{k+1} may form a ring;
R⁵ is selected from unsubstituted and substituted C₁ to C₁₂ alkyl, substituted or unsubstituted C₆ to C₁₉ aryl, substituted or unsubstituted C₂ to C₂₀ heteroaryl, substituted or unsubstituted 6-membered heteroaryl;
wherein the substituents in the substituted C₁ to C₁₂ alkyl, substituted C₆ to C₁₉ aryl, substituted C₂ to C₂₀ heteroaryl, substituted 6-membered heteroaryl are selected from halogen, F, Cl, CN, partially or perfluorinated C₁ to C₆ alkyl, partially or perfluorinated C₁ to C₆ alkoxy, C₁ to C₆ alkyl, C₁ to C₆ alkoxy;
wherein
AL is an ancillary ligand which coordinates to the metal M;
m is an integer selected from 0 to 2;
and the hole injection layer comprises a compound of formula (III) 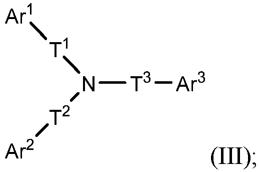
whereby
T¹, T², T³ are independently selected from a single bond, phenylene, biphenylene, terphenylene or naphthenylene, preferably a single bond or phenylene;
Ar¹, Ar², Ar³ are independently selected from substituted or unsubstituted C₆ to C₂₀ aryl, or substituted or unsubstituted C₃ to C₂₀ heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted spiro[fluorene-9,9'-xanthene], or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;
wherein
the substituents of Ar¹, Ar², Ar³ are selected the same or different from the group comprising H, D, F, CN, Si(R²)₃, substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or
unsubstituted alkenyl or alkynyl groups having 2 to 20 carbon atoms, substituted or unsubstituted aromatic ring systems having 6 to 40 aromatic ring atoms, and substituted or unsubstituted heteroaromatic ring systems having 5 to 40 aromatic ring atoms, unsubstituted C₆ to C₁₈ aryl, unsubstituted C₃ to C₁₈ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle,
wherein R² may be selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, C₆ to C₁₈ aryl or C₃ to C₁₈ heteroaryl;
wherein the hole injection layer is arranged between the anode layer and the at least one first emission layer.

2. The organic electronic device according to claim 1, wherein in the compound of formula (I) the atomic mass of M of the compound of formula (I) is selected in the range of ≥ 54 Da and ≤ 200 Da.

3. The organic electronic device according to claims 1 or 2, wherein in the compound of formula (I) ligand L has a molecular mass of ≤ 600 Da.

4. The organic electronic device according to any of claims 1 to 3, wherein in the compound of formula (I) R¹ to R⁴ are independently selected from H, D, F or CN, preferably H or D; and R⁵ is selected from unsubstituted and substituted C₁ to C₆ alkyl, substituted or unsubstituted C₆ to C₁₂ aryl, substituted or unsubstituted C₂ to C₁₂ heteroaryl, substituted or unsubstituted 6-membered heteroaryl;
wherein the substituents in the substituted C₁ to C₆ alkyl, substituted C₆ to C₁₂ aryl, substituted C₂ to C₁₂ heteroaryl, substituted 6-membered heteroaryl are selected from halogen, F, Cl, CN, partially or perfluorinated C₁ to C₄ alkyl, partially or perfluorinated C₁ to C₄ alkoxy, C₁ to C₄ alkyl, C₁ to C₄ alkoxy.

5. The organic electronic device according to any of the preceding claims 1 to 4, wherein in the compound of formula (I) ligand L comprises at least two fluorine atoms and/or at least one CN group.

6. The organic electronic device according to any of the preceding claims 1 to 5, wherein in the compound of formula (I) ligand L is selected from one of the following formulae (A1) to (A9)

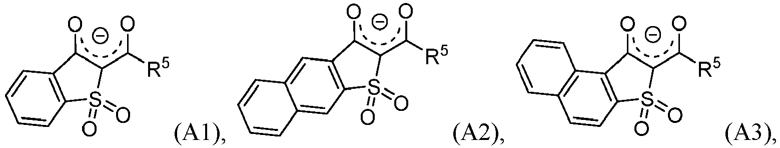

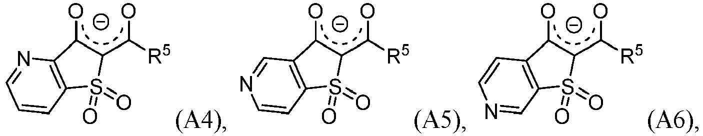

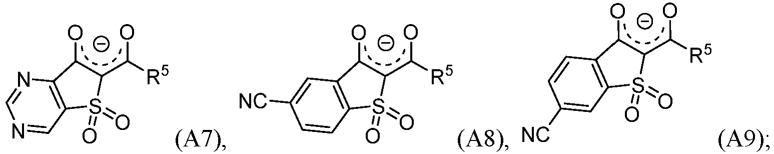

7. The organic electronic device according to any of the preceding claims 1 to 6, wherein in the compound of formula (I) M is a metal ion selected from Li(I), K(I), Rb(I), Cs(I), Ag(I), Cu(II), Zn(II), Pd(II), Ir(III), Al(III), Ga(III), Mn(II), Mn(III), Ru(III), In(III), Fe(II) or Fe(III); more preferred M is a metal ion selected from Cu(II), Mn(II), Fe(II) and Fe(III); especially preferred M is Cu(II) or Fe(III); wherein the number in brackets denotes the oxidation state.

8. The organic electronic device according to any of the preceding claims 1 to 7, whereby in the compound of formula (I) zero or one of R¹ to R⁴ are not H or D.

9. The organic electronic device according to any of the preceding claims 1 to 8, whereby in the compound of formula (I) R⁵ is selected from CF₃, C₂F₅, C₃F₇, iso-C₃F₇, C₄F₉, tert-C₄H₉, phenyl, pyrimidyl or formulae (B1) to (B51) 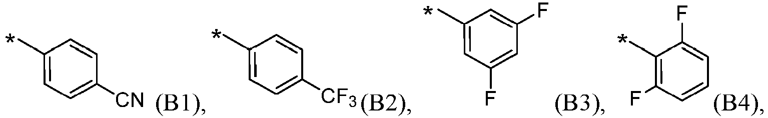 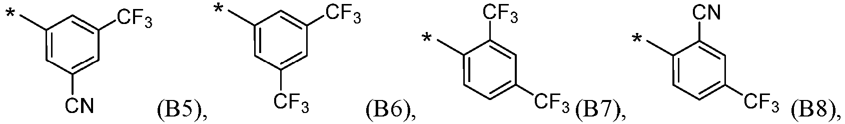 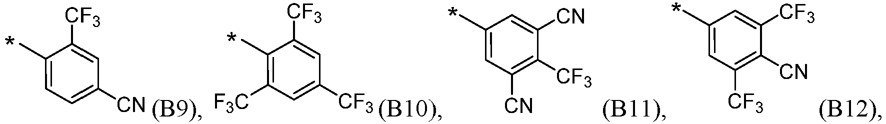 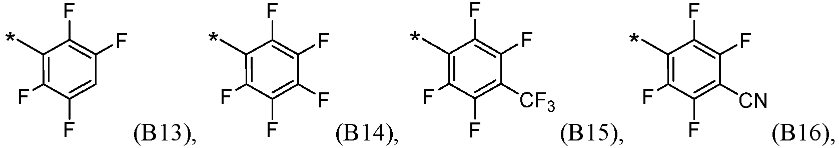 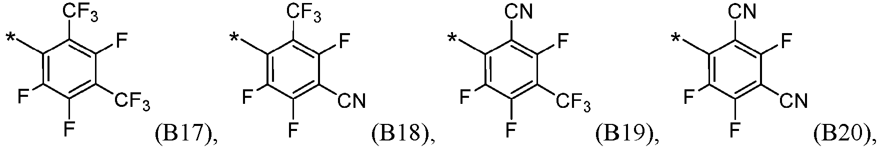 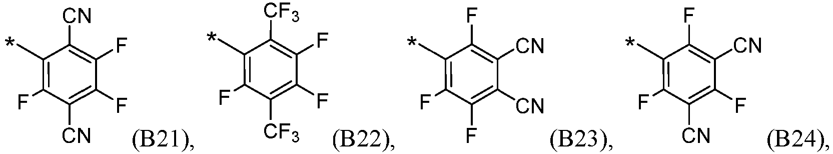 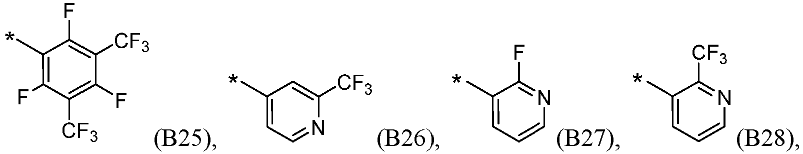 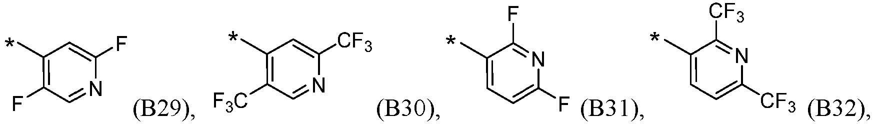 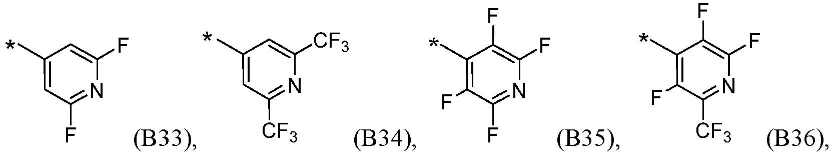 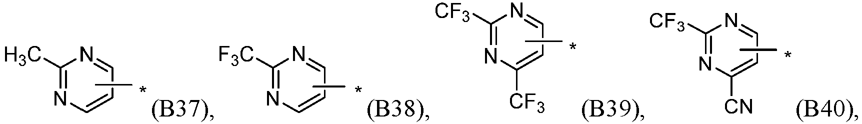 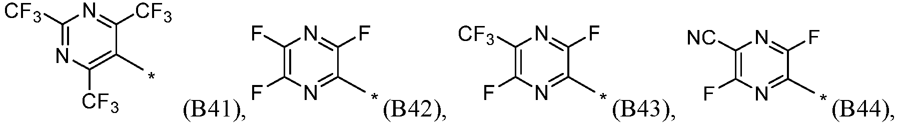 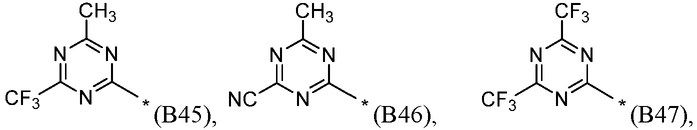 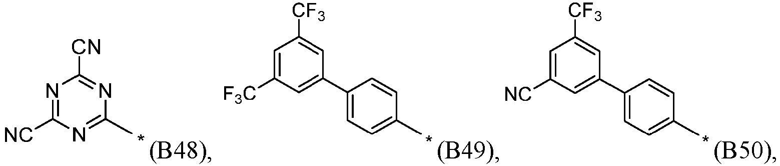 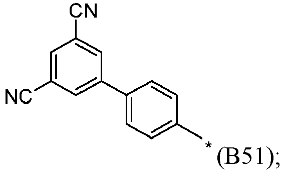 wherein the "*" denotes the binding position.

10. The organic electronic device according to any of the preceding claims 1 to 9, wherein the compound of formula (III) has a HOMO level smaller than the HOMO level of N2,N2,N2',N2',N7,N7,N7',N7'-octakis(4-methoxyphenyl)-9,9'-spirobi[fluorene]-2,2',7,7'-tetraamine, when determined by the same method.

11. The organic electronic device according to any of the preceding claims 1 to 10, wherein the compound of formula (III) is selected from one of the following formulae (K1) to (K19):

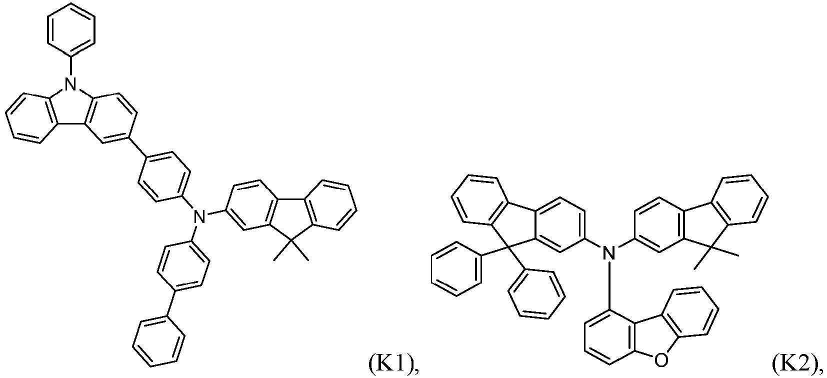

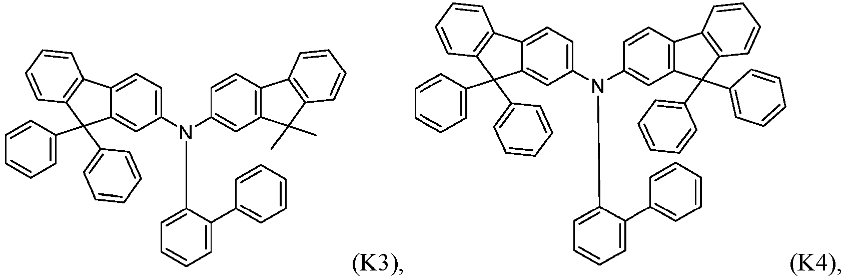

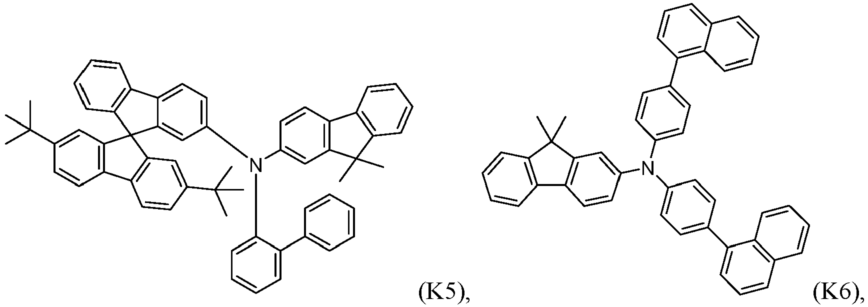

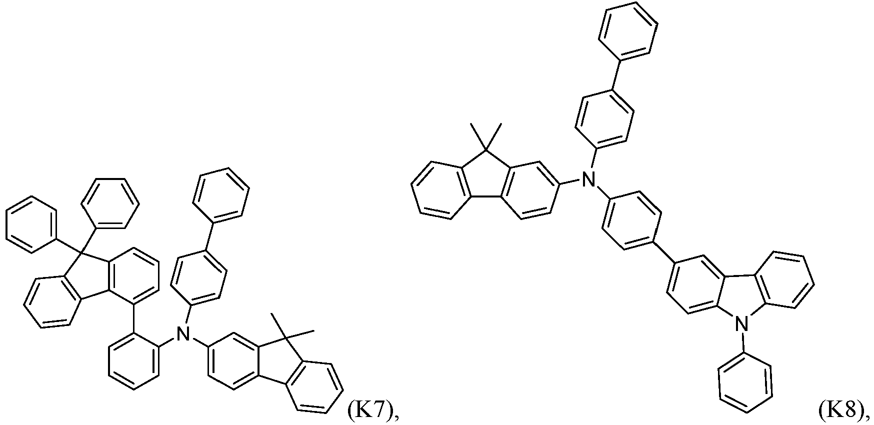

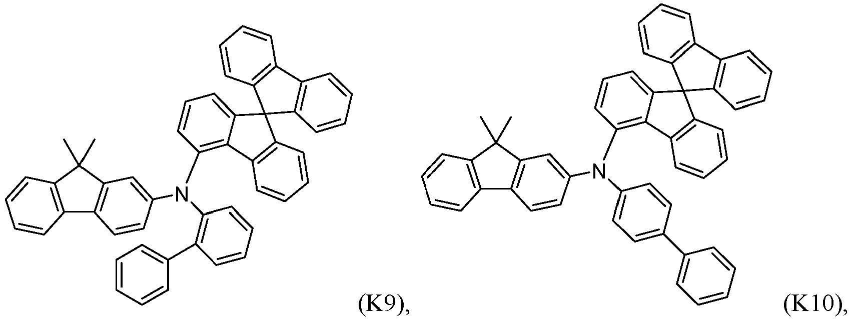

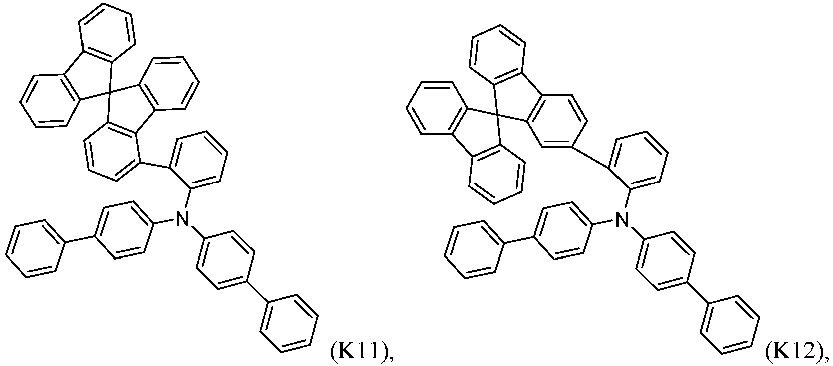

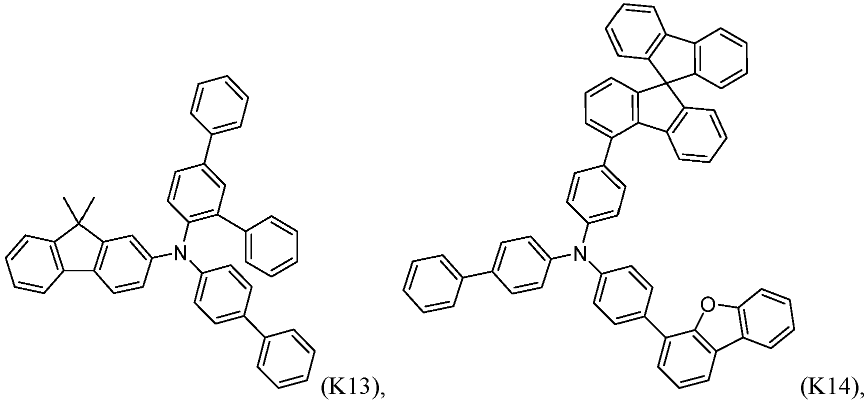

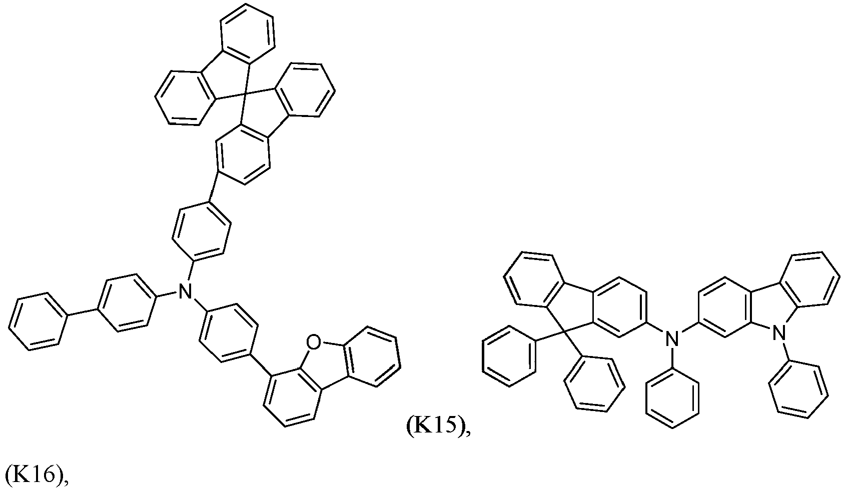

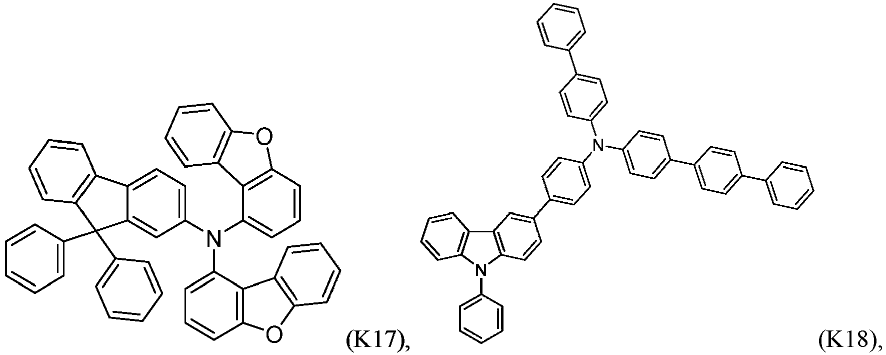

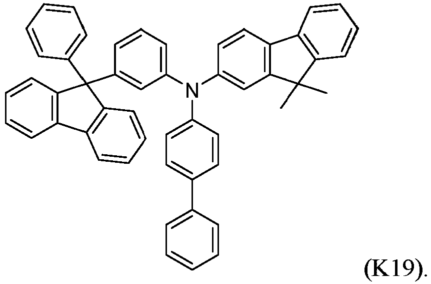

12. The organic electronic device according to any of preceding claims 1 to 11, wherein the organic electronic device further comprises a hole transport layer (140), wherein the hole transport layer is arranged between the hole injection layer (130) and the at least one first emission layer (150).

13. The organic electronic device according to claim 12, wherein the hole transport layer (140) comprises a compound of formula (III).

14. The organic electronic device according to any of the preceding claims 1 to 13, wherein the organic electronic device is a light emitting device or a display device.

15. A display device comprising an organic electronic device according to any of the claims 1 to 14.

## Patentansprüche

1. Organische elektronische Vorrichtung, umfassend ein Substrat (110), eine Anodenschicht (120), eine Kathodenschicht (190), mindestens eine erste Emissionsschicht (150) und eine Lochinjektionsschicht (130),
wobei
die Lochinjektionsschicht eine Verbindung der Formel (I) umfasst: 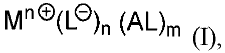
wobei:
M für ein Metallion steht;
n für die Wertigkeit von M steht und aus 1 bis 4 ausgewählt ist;
L für einen Liganden der Formel (II) 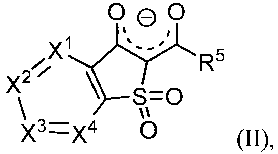
steht, wobei
X¹ aus CR¹ oder N ausgewählt ist;
X² aus CR² oder N ausgewählt ist;
X³ aus CR³ oder N ausgewählt ist;
X⁴ aus CR⁴ oder N ausgewählt ist;
wobei 0, 1 oder 2 der Gruppe bestehend aus X¹, X², X³, X⁴ aus N ausgewählt sind;
R¹ bis R⁴ unabhängig aus H, D, substituiertem oder unsubstituiertem C₁-bis C₁₂-Alkyl, substituiertem oder unsubstituiertem C₆- bis C₁₉-Aryl, substituiertem oder unsubstituiertem C₂- bis C₂₀-Heteroaryl, substituiertem oder unsubstituiertem 6-gliedrigem Heteroaryl, Halogen, F, Cl oder CN ausgewählt sind; und
wobei beliebige R^{k} bis R^{k+1} einen Ring bilden können;
R⁵ aus unsubstituiertem und substituiertem C₁- bis C₁₂-Alkyl, substituiertem oder unsubstituiertem C₆- bis C₁₉-Aryl, substituiertem oder unsubstituiertem C₂- bis C₂₀-Heteroaryl, substituiertem oder unsubstituiertem 6-gliedrigem Heteroaryl ausgewählt ist;
wobei die Substituenten in dem substituierten C₁- bis C₁₂-Alkyl, substituierten C₆- bis C₁₉-Aryl, substituierten C₂-bis C₂₀-Heteroaryl, substituierten 6-gliedrigen Heteroaryl aus Halogen, F, Cl, CN, teil- oder perfluoriertem C₁- bis C₆-Alkyl, teil- oder perfluoriertem C₁- bis C₆-Alkoxy, C₁- bis C₆-Alkyl, C₁-bis C₆-Alkoxy ausgewählt sind;
wobei
AL für einen Hilfsliganden steht, der an das Metall M koordiniert;
m für eine ganze Zahl von 0 bis 2 steht;
und die Lochinjektionsschicht eine Verbindung der Formel (III) umfasst: 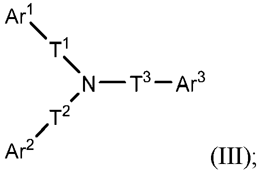
wobei
T¹, T², T³ unabhängig aus einer Einfachbindung, Phenylen, Biphenylen, Terphenylen oder Naphthenylen, vorzugsweise einer Einfachbindung oder Phenylen, ausgewählt sind; Ar¹, Ar², Ar³ unabhängig aus substituiertem oder unsubstituiertem C₆- bis C₂₀-Aryl oder substituiertem oder unsubstituiertem C₃- bis C₂₀-Heteroarylen, substituiertem oder unsubstituiertem Biphenylen, substituiertem oder unsubstituiertem Fluoren, substituiertem 9-Fluoren, substituiertem 9,9-Fluoren, substituiertem oder unsubstituiertem Naphthalin, substituiertem oder unsubstituiertem Anthracen, substituiertem oder unsubstituiertem Phenanthren, substituiertem oder unsubstituiertem Pyren, substituiertem oder unsubstituiertem Perylen, substituiertem oder unsubstituiertem Triphenylen, substituiertem oder unsubstituiertem Tetracen, substituiertem oder unsubstituiertem Tetraphen, substituiertem oder unsubstituiertem Dibenzofuran, substituiertem oder unsubstituiertem Dibenzothiophen, substituiertem oder unsubstituiertem Xanthen, substituiertem oder unsubstituiertem Carbazol, substituiertem **9-**Phenylcarbazol, substituiertem oder unsubstituiertem Azepin, substituiertem oder unsubstituiertem Dibenzo[b,f]azepin, substituiertem oder unsubstituiertem 9,9'-Spirobi[fluoren], substituiertem oder unsubstituiertem Spiro[fluoren-9,9'-xanthen] oder einem substituierten oder unsubstituierten aromatischen anellierten Ringsystem mit mindestens drei substituierten oder unsubstituierten aromatischen Ringen, die aus der Gruppe umfassend 5-gliedrige substituierte oder unsubstituierte Nichthetero- und substituierte oder unsubstituierte Heteroringe, substituierte oder unsubstituierte 6-gliedrige Ringe und/oder substituierte oder unsubstituierte 7-gliedrige Ringe ausgewählt sind, substituiertem oder unsubstituiertem Fluoren oder einem anellierten Ringsystem mit 2 bis 6 substituierten oder unsubstituierten **5-** bis 7-gliedrigen Ringen ausgewählt sind und die Ringe aus der Gruppe umfassend (i) einen ungesättigten 5- bis 7-gliedrigen Ring eines Heterocyclus, (ii) einen **5-** bis 6-gliedrigen Ring eines aromatischen Heterocyclus, (iii) einen ungesättigten **5-**bis 7-gliedrigen Ring eines Nichtheterocyclus, (iv) einen 6-gliedrigen Ring eines aromatischen Nichtheterocyclus ausgewählt sind;
wobei
die Substituenten von Ar¹, Ar², Ar³ gleich oder verschieden aus der Gruppe umfassend H, D, F, CN, Si(R²)₃, substituiertes oder unsubstituiertes geradkettiges Alkyl mit 1 bis 20 Kohlenstoffatomen, substituiertes oder unsubstituiertes verzweigtes Alkyl mit 1 bis 20 Kohlenstoffatomen, substituiertes oder unsubstituiertes cyclisches Alkyl mit 3 bis 20 Kohlenstoffatomen, substituierte oder unsubstituierte Alkenyl- oder Alkinylgruppen mit 2 bis 20 Kohlenstoffatomen, substituierte oder unsubstituierte aromatische Ringsysteme mit 6 bis 40 aromatischen Ringatomen und substituierte oder unsubstituierte heteroaromatische Ringsysteme mit 5 bis 40 aromatischen Ringatomen, unsubstituiertes C₆- bis C₁₈-Aryl, unsubstituiertes C₃-bis C₁₈-Heteroaryl, ein anelliertes Ringsystem mit 2 bis 6 unsubstituierten 5- bis 7-gliedrigen Ringen ausgewählt sind und die Ringe aus der Gruppe umfassend einen ungesättigten 5- bis 7-gliedrigen Ring eines Heterocyclus, einen 5- bis 6-gliedrigen Ring eines aromatischen Heterocyclus, einen ungesättigten 5- bis 7-gliedrigen Ring eines Nichtheterocyclus und einen 6-gliedrigen Ring eines aromatischen Nichtheterocyclus ausgewählt sind,
wobei R² aus H, D, geradkettigem Alkyl mit 1 bis 6 Kohlenstoffatomen, verzweigtem Alkyl mit 1 bis 6 Kohlenstoffatomen, cyclischem Alkyl mit 3 bis 6 Kohlenstoffatomen, Alkenyl- oder Alkinylgruppen mit 2 bis 6 Kohlenstoffatomen, C₆- bis C₁₈-Aryl oder C₃- bis C₁₈-Heteroaryl ausgewählt sein kann;
wobei die Lochinjektionsschicht zwischen der Anodenschicht und der mindestens einen ersten Emissionsschicht angeordnet ist.

2. Organische elektronische Vorrichtung nach Anspruch 1, wobei in der Verbindung der Formel (I) die Atommasse von M der Verbindung der Formel (I) im Bereich von ≥ 54 Da und ≤ 200 Da ausgewählt ist.

3. Organische elektronische Vorrichtung nach Anspruch 1 oder 2, wobei in der Verbindung der Formel (I) der Ligand L eine Molekülmasse von ≤ 600 Da aufweist.

4. Organische elektronische Vorrichtung nach einem der Ansprüche 1 bis 3, wobei in der Verbindung der Formel (I) R¹ bis R⁴ unabhängig aus H, D, F oder CN, vorzugsweise H oder D, ausgewählt sind; und R⁵ aus unsubstituiertem und substituiertem C₁- bis C₆-Alkyl, substituiertem oder unsubstituiertem C₆- bis C₁₂-Aryl, substituiertem oder unsubstituiertem C₂ bis C₁₂-Heteroaryl, substituiertem oder unsubstituiertem 6-gliedrigem Heteroaryl ausgewählt ist;
wobei die Substituenten in dem substituierten C₁- bis C₆-Alkyl, substituierten C₆- bis C₁₂-Aryl, substituierten C₂-bis C₁₂-Heteroaryl, substituierten 6-gliedrigen Heteroaryl aus Halogen, F, Cl, CN, teil- oder perfluoriertem C₁- bis C₄-Alkyl, teil- oder perfluoriertem C₁- bis C₄-Alkoxy, C₁- bis C₄-Alkyl, C₁-bis C₄-Alkoxy ausgewählt sind.

5. Organische elektronische Vorrichtung nach einem der vorhergehenden Ansprüche 1 bis 4, wobei in der Verbindung der Formel (I) der Ligand L mindestens zwei Fluoratome und/oder mindestens eine CN-Gruppe umfasst.

6. Organische elektronische Vorrichtung nach einem der vorhergehenden Ansprüche 1 bis 5, wobei in der Verbindung der Formel (I) der Ligand L aus einer der folgenden Formeln (A1) bis (A9) ausgewählt ist:

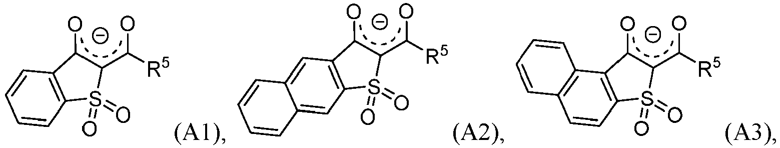

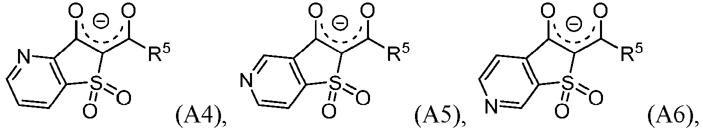

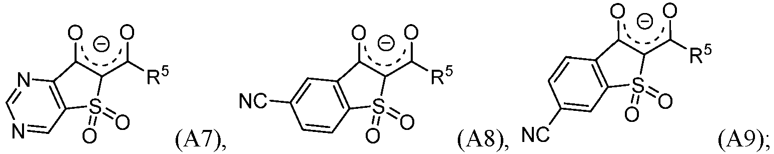

7. Organische elektronische Vorrichtung nach einem der vorhergehenden Ansprüche 1 bis 6, wobei in der Verbindung der Formel (I) M für ein Metallion steht, das aus Li(I), K(I), Rb(I), Cs(I), Ag(I), Cu(II), Zn(II), Pd(II), Ir(III), Al(III), Ga(III), Mn(II), Mn(III), Ru(III), In(III), Fe(II) oder Fe(III) ausgewählt ist; weiter bevorzugt M für ein Metallion steht, das aus Cu(II), Mn(II), Fe(II) und Fe(III) ausgewählt ist; besonders bevorzugt M für Cu(II) oder Fe(III) steht; wobei die Zahl in Klammern die Oxidationszahl bezeichnet.

8. Organische elektronische Vorrichtung nach einem der vorhergehenden Ansprüche 1 bis 7, wobei in der Verbindung der Formel (I) null oder eines von R¹ bis R⁴ nicht für H oder D stehen.

9. Organische elektronische Vorrichtung nach einem der vorhergehenden Ansprüche 1 bis 8, wobei in der Verbindung der Formel (I) R⁵ aus CF₃, C₂F₅, C₃F₇, iso-C₃F₇, C₄F₉, tert-C₄H₉, Phenyl, Pyrimidyl oder Formeln (B1) bis (B51) 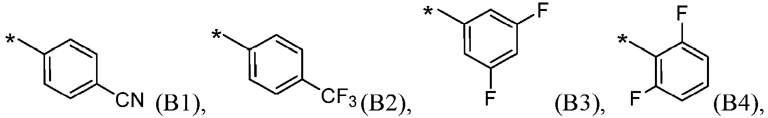 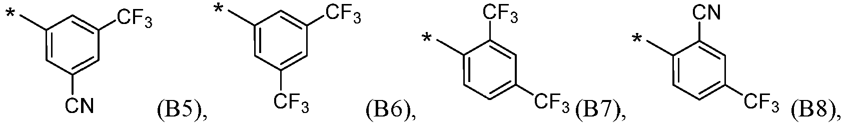 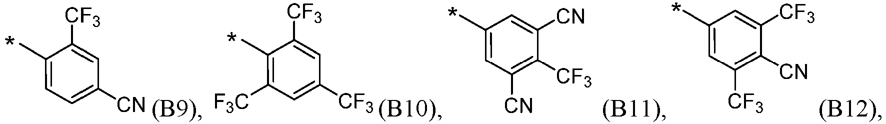 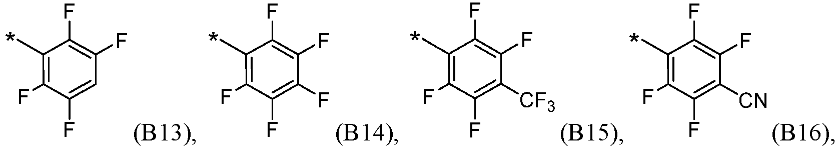 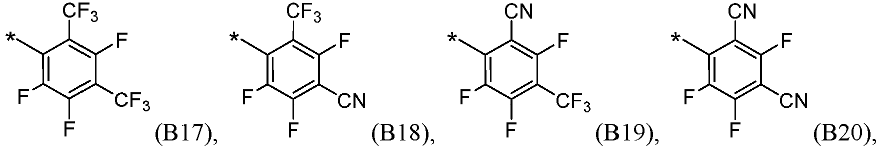 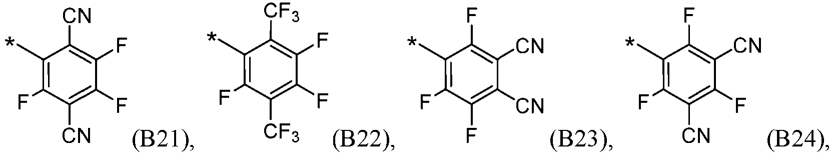 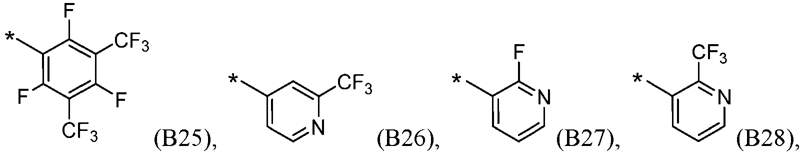 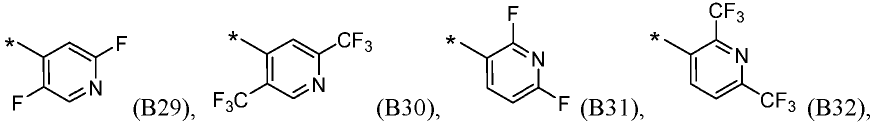 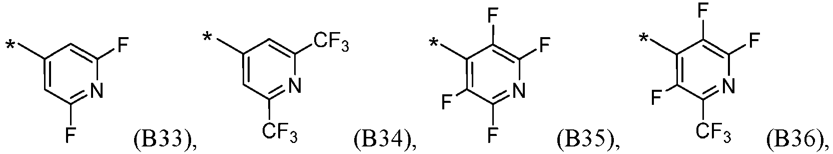 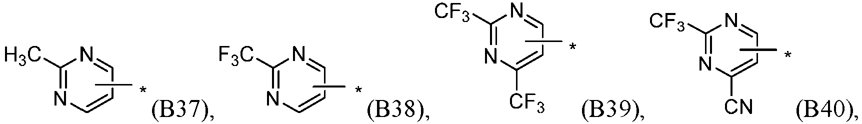 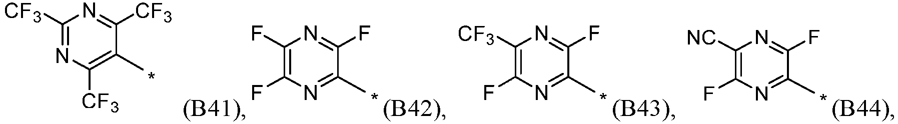 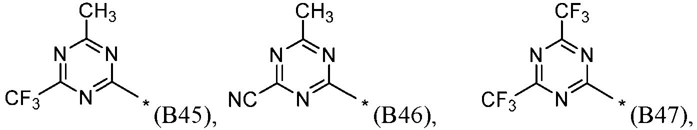 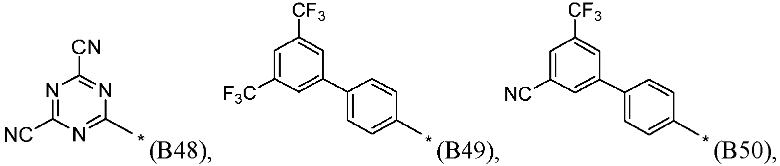 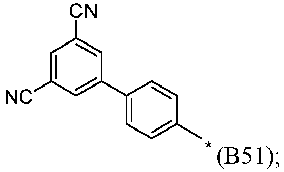 ausgewählt ist, wobei das "*" die Bindungsposition bezeichnet.

10. Organische elektronische Vorrichtung nach einem der vorhergehenden Ansprüche 1 bis 9, wobei die Verbindung der Formel (III) ein HOMO-Niveau aufweist, das kleiner ist als das HOMO-Niveau von N2,N2,N2',N2',N7,N7,N7',N7'-Octakis(4-methoxyphenyl)-9,9'-spirobi[fluoren]-2,2',7,7'-tetraamin, wenn nach der gleichen Methode bestimmt.

11. Organische elektronische Vorrichtung nach einem der vorhergehenden Ansprüche 1 bis 10, wobei die Verbindung der Formel (III) aus einer der folgenden Formeln (K1) bis (K19) ausgewählt ist:

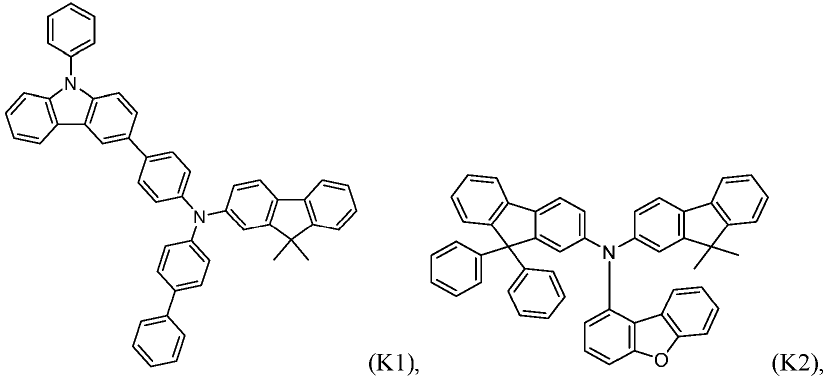

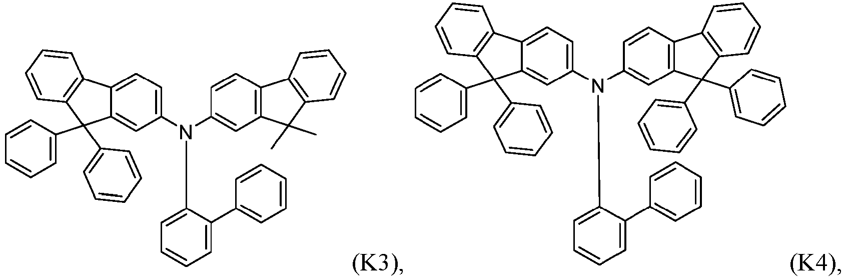

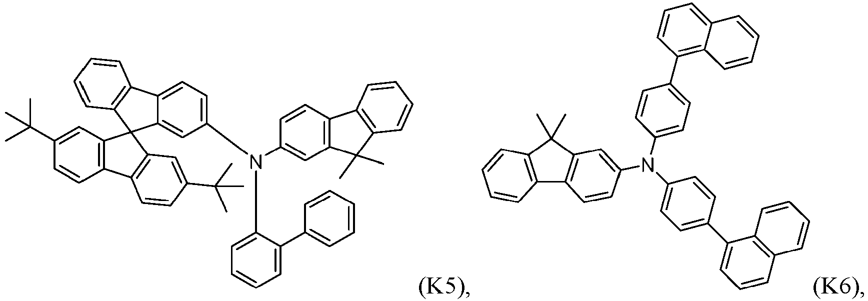

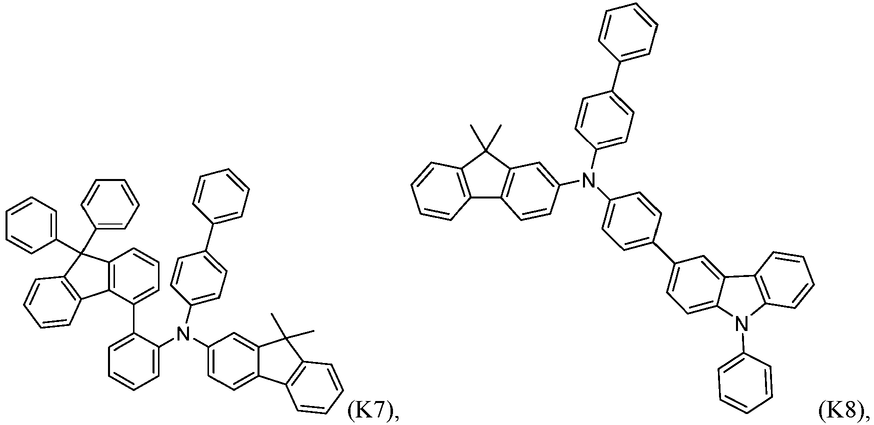

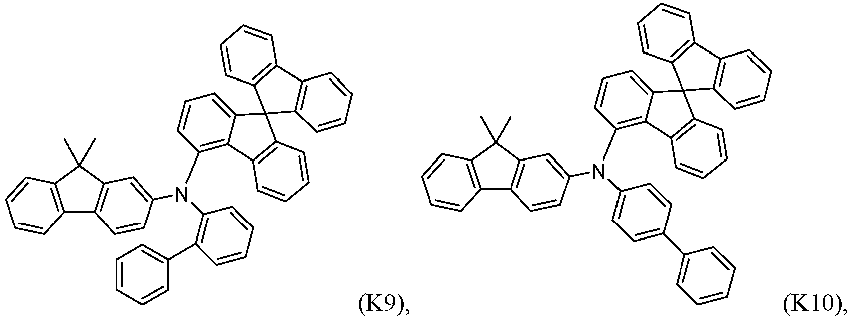

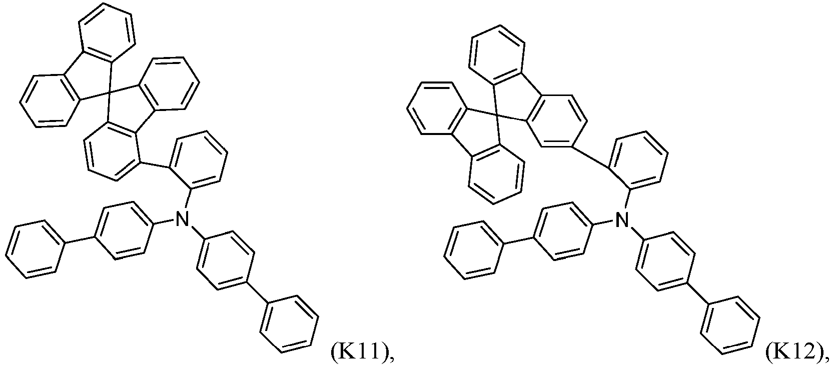

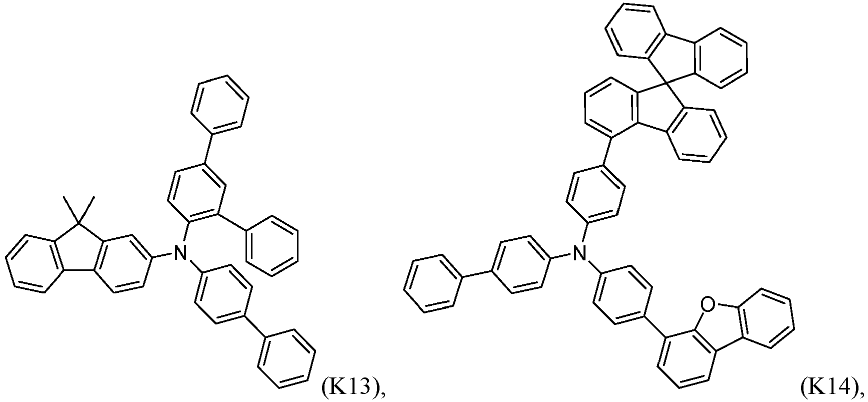

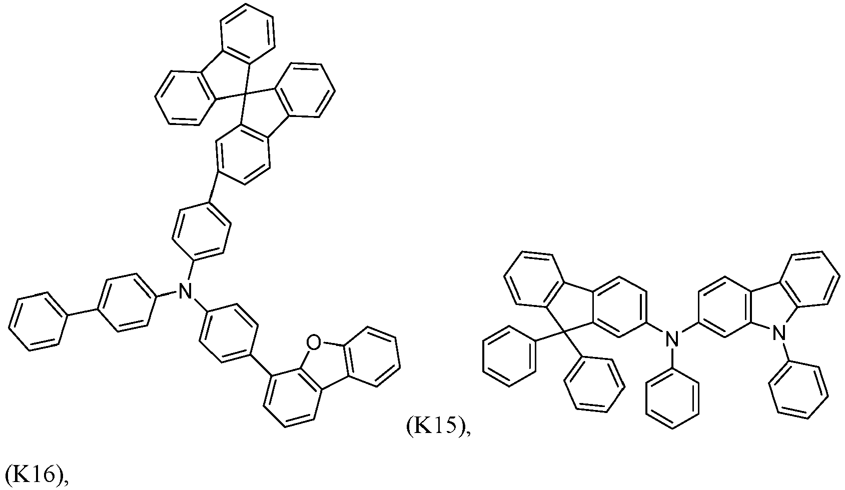

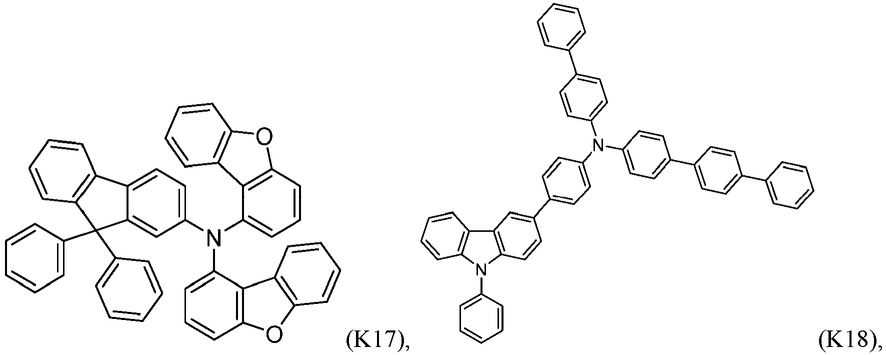

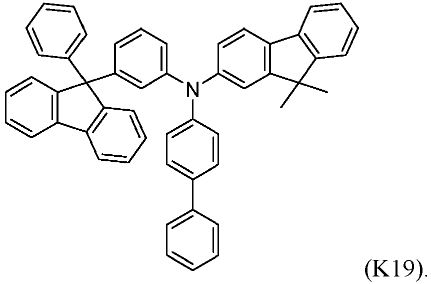

12. Organische elektronische Vorrichtung nach einem der vorhergehenden Ansprüche 1 bis 11, wobei die organische elektronische Vorrichtung ferner eine Lochtransportschicht (140) umfasst, wobei die Lochtransportschicht zwischen der Lochinjektionsschicht (130) und der mindestens einen ersten Emissionsschicht (150) angeordnet ist.

13. Organische elektronische Vorrichtung nach Anspruch 12, wobei die Lochtransportschicht (140) eine Verbindung der Formel (III) umfasst.

14. Organische elektronische Vorrichtung nach einem der vorhergehenden Ansprüche 1 bis 13, wobei es sich bei der organischen elektronischen Vorrichtung um eine lichtemittierende Vorrichtung oder eine Anzeigevorrichtung handelt.

15. Anzeigevorrichtung, umfassend eine organische elektronische Vorrichtung nach einem der Ansprüche 1 bis 14.

## Revendications

1. Dispositif électronique organique comprenant un substrat (110), une couche anodique (120), une couche cathodique (190), au moins une première couche d'émission (150) et une couche d'injection de trous (130),
la couche d'injection de trous comprenant un composé de formule (I) : 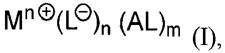
M étant un ion métallique ;
n étant la valence de M et étant choisi parmi 1 à 4 ;
L étant un ligand de formule (II) 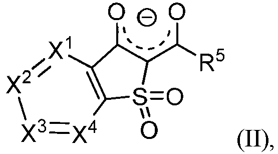
X¹ étant choisi entre CR¹ et N ;
X² étant choisi entre CR² et N ;
X³ étant choisi entre CR³ et N ;
X⁴ étant choisi entre CR⁴ et N ;
0, 1 ou 2 éléments du groupe constitué par X¹, X², X³, X⁴ étant N ;
R¹ à R⁴ étant indépendamment choisis parmi H, D, alkyle en C₁ à C₁₂ substitué ou non substitué, aryle en C₆ à C₁₉ substitué ou non substitué, hétéroaryle en C₂ à C₂₀ substitué ou non substitué, hétéroaryle à 6 chaînons substitué ou non substitué, halogène, F, Cl ou CN ; et de quelconques éléments parmi R^{k} à R^{k+1} pouvant former un cycle ;
R⁵ étant choisi parmi alkyle en C₁ à C₁₂ non substitué ou substitué, aryle en C₆ à C₁₉ substitué ou non substitué, hétéroaryle en C₂ à C₂₀ substitué ou non substitué, hétéroaryle à 6 chaînons substitué ou non substitué ; les substituants de l'alkyle en C₁ à C₁₂ substitué, l'aryle en C₆ à C₁₉ substitué, l'hétéroaryle en C₂ à C₂₀ substitué, l'hétéroaryle à 6 chaînons substitué étant choisis parmi halogène, F, Cl, CN, alkyle en C₁ à C₆ partiellement fluoré ou perfluoré, alcoxy en C₁ à C₆ partiellement fluoré ou perfluoré, alkyle en C₁ à C₆, alcoxy en C₁ à C₆ ;
AL étant un ligand auxiliaire qui forme une liaison de coordination avec le métal M ;
m étant un entier choisi parmi 0 à 2 ;
et la couche d'injection de trous comprenant un composé de formule (III) 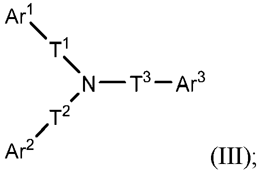
T¹, T², T³ étant choisis indépendamment parmi une simple liaison, phénylène, biphénylène, terphénylène ou naphténylène, de préférence une simple liaison ou phénylène ;
Ar¹, Ar², Ar³ étant indépendamment choisis parmi aryle en C₆ à C₂₀ substitué ou non substitué ou hétéroarylène en C₃ à C₂₀ substitué ou non substitué, biphénylène substitué ou non substitué, fluorène substitué ou non substitué, 9-fluorène substitué, 9,9-fluorène substitué, naphtalène substitué ou non substitué, anthracène substitué ou non substitué, phénanthrène substitué ou non substitué, pyrène substitué ou non substitué, pérylène substitué ou non substitué, triphénylène substitué ou non substitué, tétracène substitué ou non substitué, tétraphène substitué ou non substitué, dibenzofurane substitué ou non substitué, dibenzothiophène substitué ou non substitué, xanthène substitué ou non substitué, carbazole substitué ou non substitué, 9-phénylcarbazole substitué, azépine substituée ou non substituée, dibenzo[b,f]azépine substituée ou non substituée, 9,9'-spirobi[fluorène] substitué ou non substitué, spiro[fluorène-9,9'-xanthène] substitué ou non substitué ou un système cyclique condensé aromatique substitué ou non substitué comprenant au moins trois cycles aromatiques substitués ou non substitués choisis dans le groupe comprenant les cycles non hétérocycliques substitués ou non substitués, les cycles hétérocycliques à 5 chaînons substitués ou non substitués, les cycles à 6 chaînons substitués ou non substitués et/ou les cycles à 7 chaînons substitués ou non substitués, le fluorène substitué ou non substitué ou un système cyclique condensé comprenant 2 à 6 cycles à 5 à 7 chaînons substitués ou non substitués et les cycles étant choisis dans le groupe comprenant (i) un cycle à 5 à 7 chaînons insaturé d'un hétérocycle, (ii) un cycle à 5 à 6 chaînons d'un hétérocycle aromatique, (iii) un cycle à 5 à 7 chaînons insaturé d'un non-hétérocycle, (iv) un cycle à 6 chaînons d'un non-hétérocycle aromatique ;
les substituants de Ar¹, Ar², Ar³ étant choisis identiques ou différents dans le groupe comprenant H, D, F, CN, Si (R²)₃, alkyle à chaîne droite substitué ou non substitué ayant 1 à 20 atomes de carbone, alkyle ramifié substitué ou non substitué ayant 1 à 20 atomes de carbone, alkyle cyclique substitué ou non substitué ayant 3 à 20 atomes de carbone, les groupes alcényle ou alcynyle substitués ou non substitués ayant 2 à 20 atomes de carbone, les systèmes cycliques aromatiques substitués ou non substitués ayant 6 à 40 atomes de cycle aromatique et les systèmes cycliques hétéroaromatiques substitués ou non substitués ayant 5 à 40 atomes de cycle aromatique, aryle en C₆ à C₁₈ non substitué, hétéroaryle en C₃ à C₁₈ non substitué, un système cyclique condensé comprenant 2 à 6 cycles à 5 à 7 chaînons non substitués et les cycles étant choisis dans le groupe comprenant un cycle à 5 à 7 chaînons insaturé d'un hétérocycle, un cycle à 5 à 6 chaînons d'un hétérocycle aromatique, un cycle à 5 à 7 chaînons insaturé d'un non-hétérocycle et un cycle à 6 chaînons d'un non-hétérocycle aromatique,
R² pouvant être choisi parmi H, D, alkyle à chaîne droite ayant 1 à 6 atomes de carbone, alkyle ramifié ayant 1 à 6 atomes de carbone, alkyle cyclique ayant 3 à 6 atomes de carbone, les groupes alcényle ou alcynyle ayant 2 à 6 atomes de carbone, aryle en C₆ à C₁₈ ou hétéroaryle en C₃ à C₁₈ ;
la couche d'injection de trous étant disposée entre la couche anodique et l'au moins une première couche d'émission.

2. Dispositif électronique organique selon la revendication 1, dans le composé de formule (I), la masse atomique de M du composé de formule (I) étant choisie dans la plage de ≥ 54 Da et ≤ 200 Da.

3. Dispositif électronique organique selon les revendications 1 ou 2, le ligand L dans le composé de formule (I) ayant une masse moléculaire ≤ 600 Da.

4. Dispositif électronique organique selon l'une quelconque des revendications 1 à 3, dans le composé de formule (I), R¹ à R⁴ étant indépendamment choisis parmi H, D, F ou CN, préférablement H ou D ; et R⁵ étant choisi parmi alkyle en C₁ à C₆ non substitué et substitué, aryle en C₆ à C₁₂ substitué ou non substitué, hétéroaryle en C₂ à C₁₂ substitué ou non substitué, hétéroaryle à 6 chaînons substitué ou non substitué ;
les substituants de l'alkyle en C₁ à C₆ substitué, l'aryle en C₆ à C₁₂ substitué, l'hétéroaryle en C₂ à C₁₂ substitué, l'hétéroaryle à 6 chaînons substitué étant choisis parmi halogène, F, Cl, CN, alkyle en C₁ à C₄ partiellement fluoré ou perfluoré, alcoxy en C₁ à C₄ partiellement fluoré ou perfluoré, alkyle en C₁ à C₄, alcoxy en C₁ à C₄.

5. Dispositif électronique organique selon l'une quelconque des revendications 1 à 4 précédentes, le ligand L, dans le composé de formule (I), comprenant au moins deux atomes de fluor et/ou au moins un groupe CN.

6. Dispositif électronique organique selon l'une quelconque des revendications 1 à 5 précédentes, le ligand L, dans le composé de formule (I), étant choisi parmi l'une des formules (A1) à (A9) suivantes

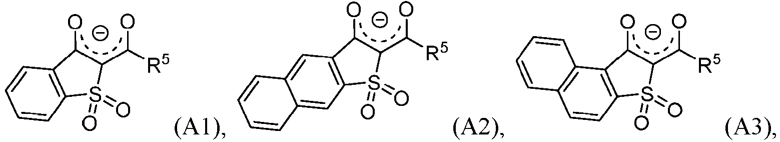

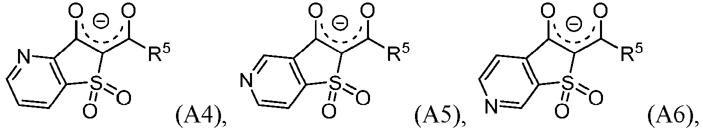

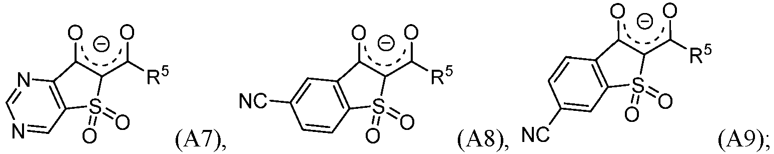

7. Dispositif électronique organique selon l'une quelconque des revendications 1 à 6 précédentes, M, dans le composé de formule (I), étant un ion métallique choisi parmi Li(I), K(I), Rb(I), Cs(I), Ag(I), Cu(II), Zn(II), Pd(II), Ir(III), Al(III), Ga(III), Mn(II), Mn(III), Ru(III), In(III), Fe(II) ou Fe(III) ; plus préférablement M étant un ion métallique choisi parmi Cu(II), Mn(II), Fe(II) ou Fe(III) ; particulièrement préférablement M étant Cu(II) et Fe(III) ; le nombre entre parenthèses indiquant l'état d'oxydation.

8. Dispositif électronique organique selon l'une quelconque des revendications 1 à 7 précédentes, aucun de R¹ à R⁴, dans le composé de formule (I), n'étant pas H ou D ou l'un de ceux-ci n'étant pas H ou D.

9. Dispositif électronique organique selon l'une quelconque des revendications 1 à 8 précédentes, R⁵, dans le composé de formule (I), étant choisi parmi CF₃, C₂F₅, C₃F₇, iso-C₃F₇, C₄F₉, tert-C₄H₉, phényle, pyrimidyle ou les formules (B1) à (B51) 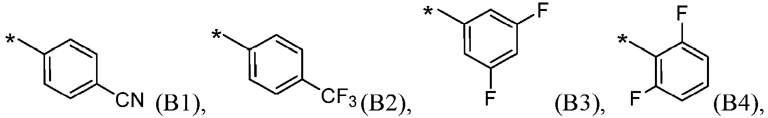 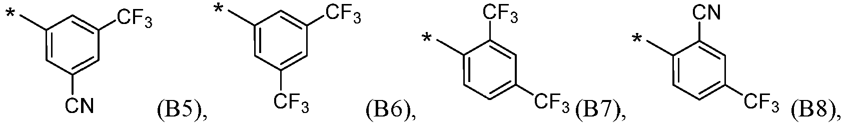 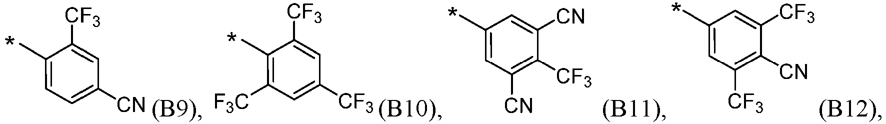 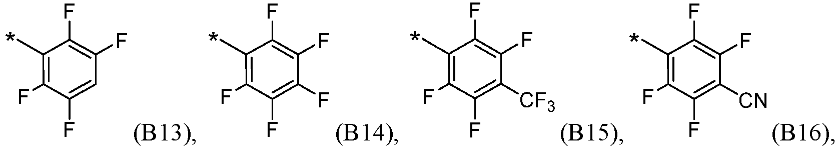 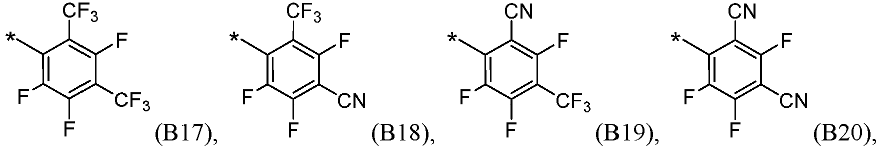 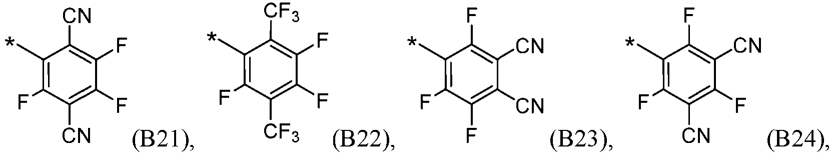 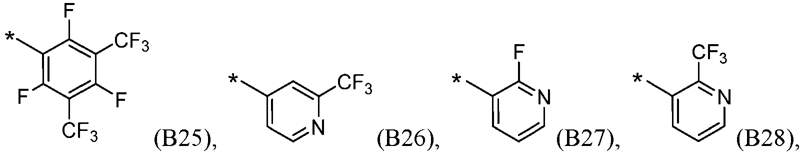 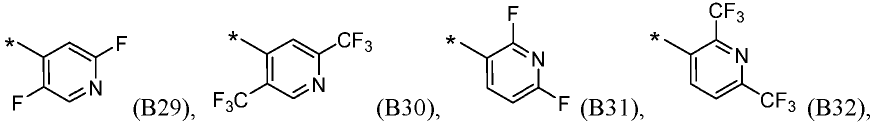 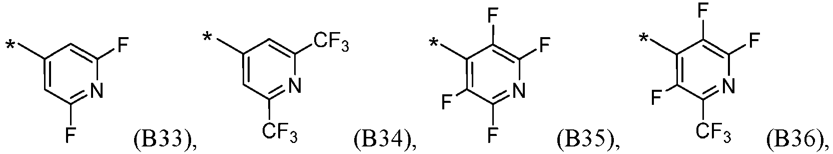 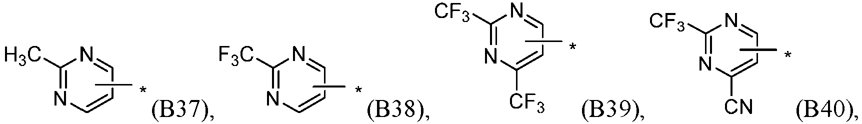 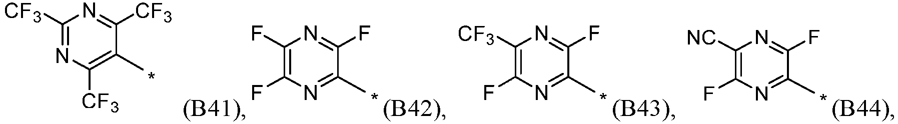 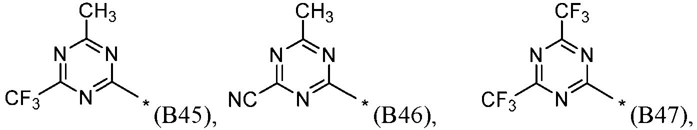 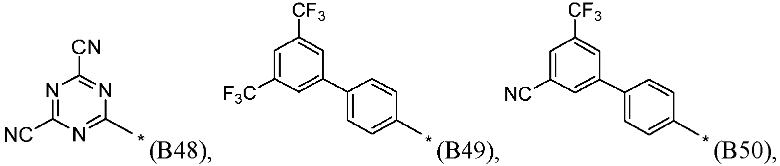 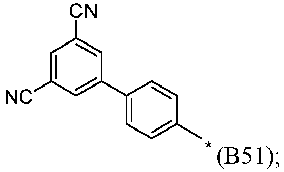 « * » indiquant la position de liaison.

10. Dispositif électronique organique selon l'une quelconque des revendications 1 à 9 précédentes, le composé de formule (III) ayant un niveau de HOMO inférieur au niveau de HOMO de la N2,N2,N2',N2',N7,N7,N7',N7'-octakis(4-méthoxyphényl)-9,9'-spirobi[fluorène]-2,2',7,7'-tétraamine, lorsqu'il est déterminé par la même méthode.

11. Dispositif électronique organique selon l'une quelconque des revendications 1 à 10 précédentes, le composé de formule (III) étant choisi parmi l'une des formules (K1) à (K19) suivantes :

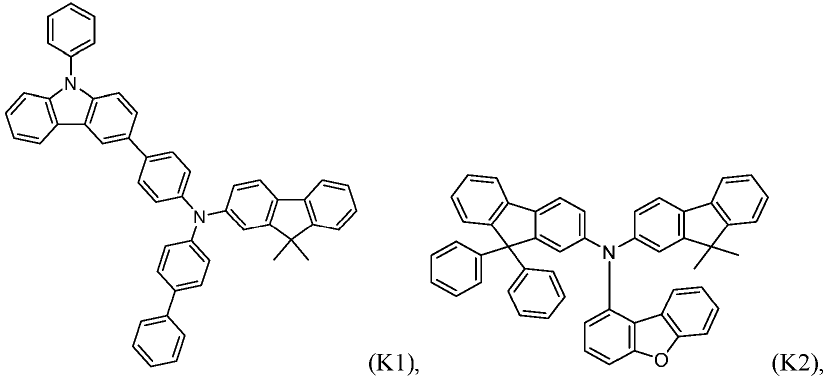

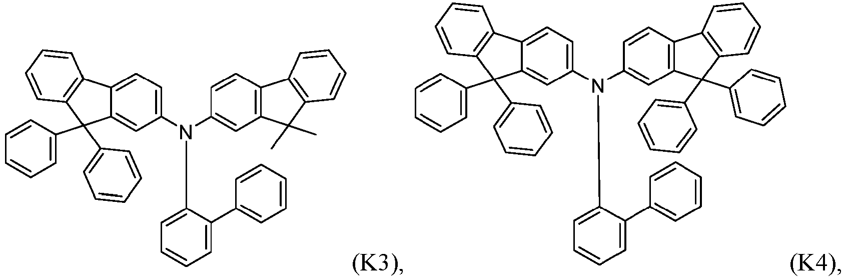

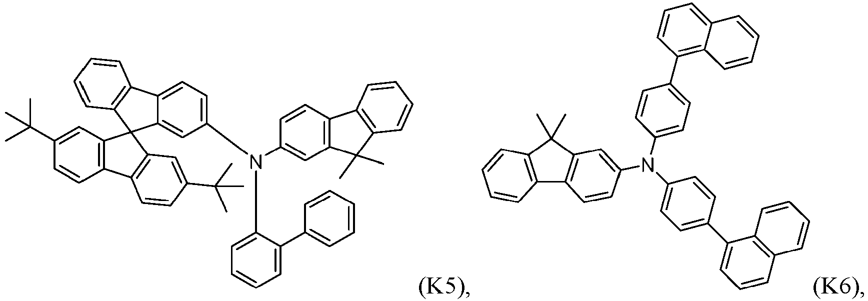

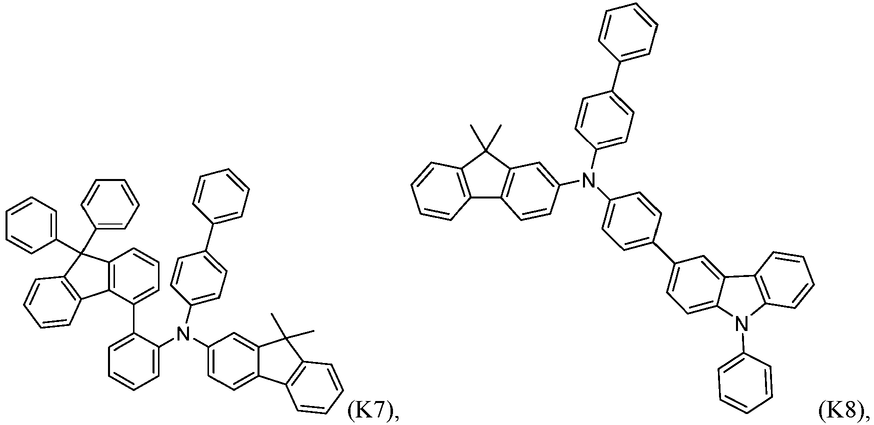

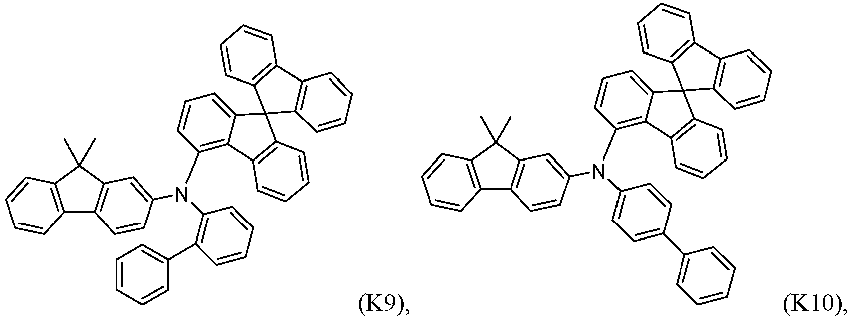

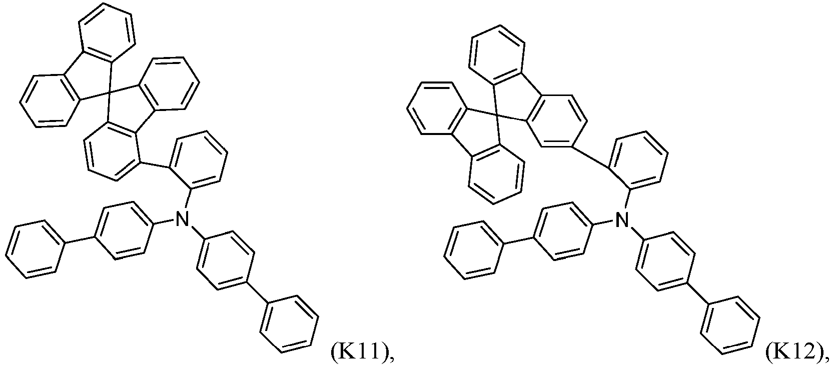

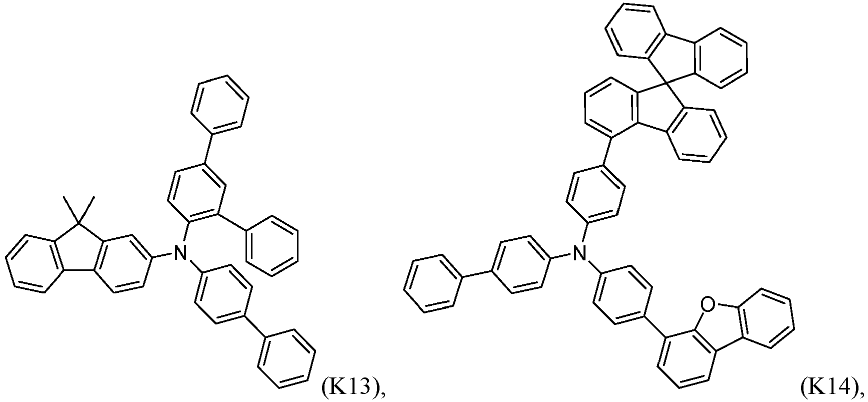

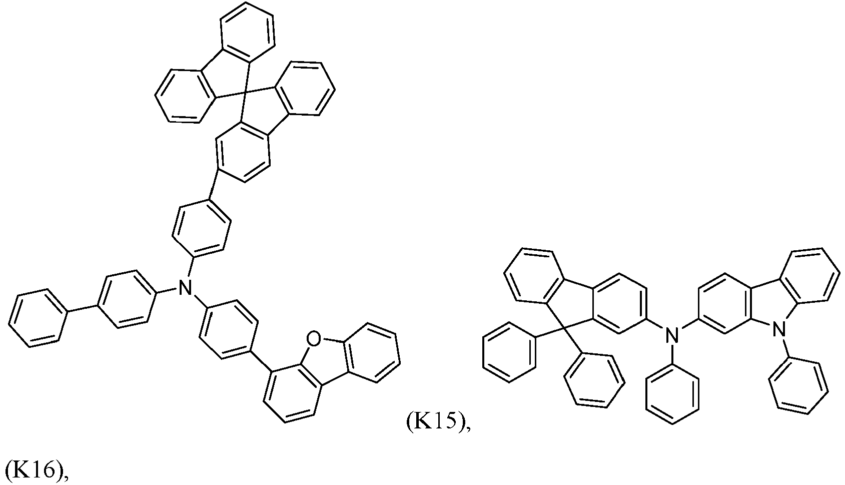

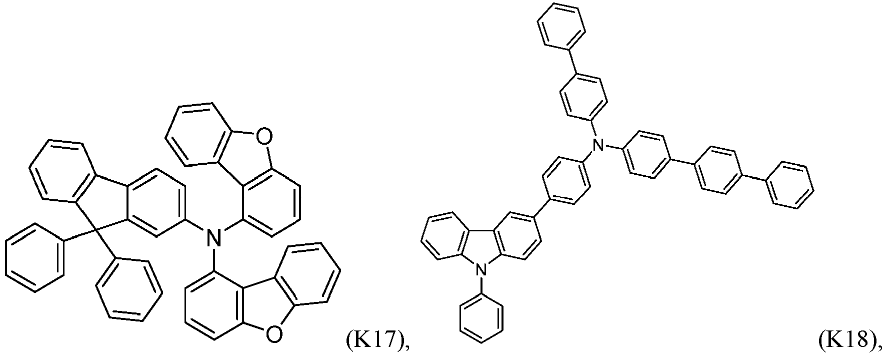

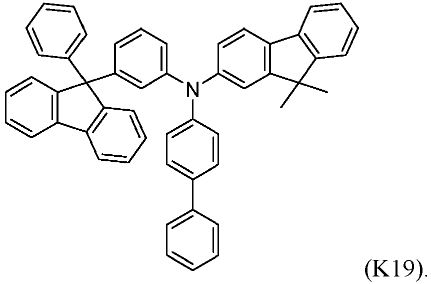

12. Dispositif électronique organique selon l'une quelconque des revendications 1 à 11 précédentes, le dispositif électronique organique comprenant en outre une couche de transport de trous (140), la couche de transport de trous étant disposée entre la couche d'injection de trous (130) et l'au moins une couche d'émission (150).

13. Dispositif électronique organique selon la revendication 12, la couche de transport de trous (140) comprenant un composé de formule (III).

14. Dispositif électronique organique selon l'une quelconque des revendications 1 à 13 précédentes, le dispositif électronique organique étant un dispositif émetteur de lumière ou un dispositif d'affichage.

15. Dispositif d'affichage comprenant un dispositif électronique organique selon l'une quelconque des revendications 1 à 14.
